# EUROPEAN PATENT SPECIFICATION

(11) **EP 4 102 571 B1**
(45) Date of publication and mention of the grant of the patent: **13.11.2024**
(21) Application number: 21178494.7
(22) Date of filing: 09.06.2021
(51) Int. Cl.: H10K 10/50, H10K 19/00

(54) **ELECTRONIC ELEMENT COMPRISING A PLURALITY OF CELLS ARRANGED IN A THREE DIMENSIONAL ARRAY OF CELLS AND METHOD FOR PRODUCING SUCH AN ELECTRONIC DEVICE**
ELEKTRONISCHES BAUELEMENT MIT EINER VIELZAHL VON ZELLEN IN EINER DREIDIMENSIONALEN ANORDNUNG UND HERSTELLUNGSMETHODE DAFÜR
ÉLÉMENT ÉLECTRONIQUE COMPRENANT UNE PLURALITÉ DE CELLULES DISPOSÉES DANS UN RÉSEAU TRIDIMENSIONNEL DE CELLULES ET PROCÉDÉ DE FABRICATION D'UN TEL DISPOSITIF ÉLECTRONIQUE

(43) Date of publication of application: 14.12.2022
(73) Proprietor: Merck Patent GmbH, 64293 Darmstadt (DE)
(72) Inventor: KIRSCH, Peer, 64293 Darmstadt (DE); RESCH, Sebastian, 64293 Darmstadt (DE); SEIM, Henning, 64293 Darmstadt (DE); TORNOW, Marc, 80333 München (DE)
(74) Representative: Merck Patent Association

(56) References cited:
- US-A1- 2010 051 909
- US-A1- 2019 312 216
- US-B1- 6 836 398

## Description

The invention relates to an electronic element comprising a plurality of cells arranged in a three dimensional array of cells, wherein the cells are located at crossings between two electrode lines. Further aspects of the invention relate to a method for producing such an electronic element and the use of such an electronic element.

In computer technology, storage media are required which allow rapid writing and reading access to information stored therein. Solid-state memories or semiconductor memories allow particularly fast and reliable storage media to be achieved, since absolutely no moving parts are necessary. At present, use is mainly made of dynamic random access memory (DRAM). DRAM allows rapid access to the stored information, but this information has to be refreshed regularly, meaning that the stored information is lost when the power supply is switched off.

The prior art also discloses non-volatile semiconductor memories, such as flash memory or magnetoresistive random access memory (MRAM), in which the information is retained even after the power supply has been switched off. A disadvantage of flash memory is that writing access takes place comparatively slowly and the memory cells of the flash memory cannot be erased ad infinitum. The lifetime of flash memory is typically limited to a maximum of one million read/write cycles. MRAM can be used in a similar way to DRAM and has a long lifetime, but this type of memory has not been able to establish itself owing to the difficult production process.

A further alternative is memory which works on the basis of memristors. The term memristor is a contraction of the words "memory" and "resistor" and denotes a component, whose electrical resistance can be changed reproducibly between a high and a low value. The respective state (high resistance or low resistance) is retained even without a supply voltage, meaning that non-volatile memories can be achieved with memristors.

An important alternative application of electrically switchable components arises for the area of neuromorphic or synaptic computing. In computer architectures pursued therein, the information is not intended to be processed sequentially in a classical manner. Instead, the aim is to build up the circuits in a highly three-dimensionally interlinked manner in order to be able to achieve information processing analogous to the brain. In artificial neuronal networks of this type, the biological connections between nerve cells (synapses) are then represented by the memristive switching elements. Under certain circumstances, additional intermediate states (between the digital states "1" and "0") may also be of particular benefit here.

DE 10 2017 005 884 A1 discloses an electronic switching element which comprises in this order a first electrode, a molecular layer bonded to a substrate and a second electrode. The molecular layer consists essentially of compounds in which a rigid polar cyclic or mesogenic radical is bound to the substrate via a spacer group by means of an anchor group. The resistance of the molecular layer may be switched between a high resistance state and a low resistance state by applying an electrical potential exceeding a certain positive or negative switching voltage.

WO 2020/225270 A1 discloses diamondoid compounds and a switching element for memristive devices comprising self-assembled monolayers (SAMs) comprising said diamondoid compounds. The switchable element comprises in this order a first electrode, the SAM and a second electrode. WO 2020/225398 A1 discloses similar switchable elements having a self-assembled monolayer based on aryl ethers.

US2019312216 A1 discloses an organic switching element comprising compounds having a mesogenic radical bonded to the substrate via a spacer group by means of an anchor group.

US 6,579,760 describes a memory device comprising a crossbar array of bit- and word-lines, wherein memory cells are arranged at intersections between the bit-lines and word-lines. The memory cells each comprise an isolation diode as selection device and a phase change layer. A memory cell is selected by biasing the word-line and the bit-line which intersect at the selected memory cell, so that the isolation diode of the selection device is conductive, while word-lines and bit-lines coupled to other memory cells are reverse biased so that the isolation diode of the selection device is nonconductive. The phase change layer and the isolation diode are formed as a self-aligned stack.

In order to further increase the density of the electronic devices, in particular of memory devices, three dimensional arrangements of memory cells using inorganic materials based on phase change materials and other memory materials such as conductive bridge random access memory (CB-RAM), ferroelectric transistor random access memory (FeTRAM), magnetoresistive random access memory (MRAM) are known in the art. Such configurations are known as 3D cross-point or 3D X-point memory devices.

US 2019/0043923 A1 discloses a 3D cross-point memory structure having bit-lines and word-lines, wherein memory cells are arranged at crossings between bit- and word-lines. In order to mitigate current spikes, resistive material is deposited in two or more regions of the array including at least one region of memory cells nearer to a contact of the conductive bit- and word-lines.

It would be desirable to produce such 3D cross-point structures of cells comprising memristive switching elements based on organic self-assembled monolayers. However, the thermal sensitivity of the organic components have not allowed the manufacturing of 3D cross-point structures using established processes in the fabrication of microelectronics.

It is thus an object of the invention to provide such an electronic element having a plurality of cells with a hybrid organic-inorganic structure arranged in a three dimensional array of cells which may be easily manufactured. Further, it is an object of the invention to provide a method for producing such an electronic element.

An electronic element comprising a plurality of cells is proposed. The plurality of cells is arranged in a three dimensional array of cells, wherein the cells are located at crossings between two crossed electrode lines. Each cell comprises in this order a first electrode, a part of a molecular layer and a second electrode, wherein the molecular layer is a self-assembled monolayer of organic molecules having an anchoring group connected to a dipolar unit by means of a conformationally flexible unit.

Each of the cells is a switchable unit, wherein a state of the self-assembled monolayer within the cell can be switched from a first state, in which the cell has a high electrical resistance, to a second state, in which the cell has a low electrical resistance. The electrical resistance of the cell in the high electrical resistance state is preferably 10 to 100 000 times higher than in the low electrical resistance state.

Such a structure for a switchable unit is known in the art, see for example, documents WO 2020/225270 A1, WO 2020/225398 A1 and DE 10 2017 005 884 A1.

The state of the cell, in particular the state of the part of the molecular layer of the cell, may be switched by application of a switching voltage. Further, the state of the cell may be read out by measuring the resistance by applying a readout voltage and then measuring the electric current flowing through the cell, wherein the readout voltage is lower than the switching voltage. The absolute value of the readout voltage is preferably at least 10 times lower than absolute value of the switching voltage. It is particularly preferred if the reading voltage is from 10 to 300 mV.

The cell preferably has a first (positive) switching voltage, wherein, when a positive voltage larger than the first switching voltage is applied, the state of the molecular layer switches from the low resistance state to the high resistance state. Further, the cell preferably has a second switching voltage, having a polarity opposite to the first switching voltage, wherein, when a negative voltage larger than the second switching voltage is applied, the state of the molecular layer switches from the high resistance state to the low resistance state.

By means of the resistance state, a single bit of information may be encoded. Accordingly, each of the cells may be used as a single bit storage cell in an electronic element configured as memory device.

The plurality of cells is arranged in a three dimensional array of cells. Accordingly, the array extends in two directions of a plane, which may be defined by a substrate onto which the electronic element is formed, and may also extends in a vertical direction perpendicular to this plane. A number of cells arranged in the each of the two directions or dimensions of the plane may be very high, ranging from at least two to several thousands, millions or even billions of cells. For example, in a configuration of 1024 cells in an x-direction and 1024 cells in a y-direction, a single two dimensional layer of cells comprises 1048576 cells. Such a two-dimensional arrangement of cells, wherein each of the cells is located at a crossing of two orthogonal electrode lines is known as crossbar array.

The number of levels or layers of cells arranged in the vertical direction or dimension is typically lower and ranges from 2 to at least 64, preferably up to at least 1024 or even higher. Preferably, the array comprises at least 16 levels of cells, more preferably at least 32 levels of cells and most preferred at least 64 levels of cells. Such a three-dimensional arrangement of cells is known as a 3D crossbar array or 3D cross point device.

In the array of cells, each of the individual cells is arranged at a crossing between two crossed electrode lines which serve as the first electrode and the second electrode of the respective cell or are connected to a first and a second electrode of the respective cell. Accordingly, each of the cells may be addressed by applying a voltage to the respective electrode lines. However, due to leakage currents some of the current caused by the applied voltage may flow through adjacent cells. The influence of such leakage currents may be avoided or at least reduced by the inclusion of a selector device in each of the cells.

The two crossed electrode lines may be arranged orthogonal to each other, so that the crossed electrode lines enclose an angle of 90°. However, an exact 90° angle is not required so that the angle between the crossed electrode lines may, for example, be selected from the range of from 45° to 135°.

Preferably, each cell further comprises a diode, a threshold switch or a transistor as selector device.

The selector device may be configured as inorganic diode, in particular as Zener diode or symmetric Schottky diode. The diode may in particular comprise two layers of semiconducting material such as silicon, wherein a first layer is p-doped and a second layer is n-doped. A back-to-back Schottky diode may comprise a metal-insulator-metal (MIM) layer structure, for example Ni/TiO₂/Ni.

Owing to the bipolar switching characteristics of the molecular layer of the cells, the use of selector devices having non-linear characteristics for both polarities is preferred. To this end, a diodes may be used, for example, in the form of Zener diodes, where both the p-doped layer and also the n-doped layer are highly doped.

Suitable threshold switches may be based on ovonic threshold switching or metal-insulator transitions.

Suitable switches based on ovonic threshold switching are such as chalcogenide-based devices.

Suitable structures for metal-insulator transition based threshold switches comprise Pt/VO₂/Pt.

Preferably, the selector device is configured as a further self-assembled monolayer of organic molecules or as an diode arranged between the molecular layer and the first electrode or the second electrode.

Preferably, the first electrodes and/or second electrodes of each cell are made from a metal, a conductive alloy, a conductive ceramic, a semiconductor, a conductive oxidic material, conductive or semi conductive organic molecules or a layered conductive 2D material. The first and/or second electrode may comprise combinations of more than one of said materials, for example in form of a multi-layer system. The material of the first and the second electrode may be chosen identically or differently.

Suitable metals include Ag, Al, Au, Co, Cr, Cu, Mo, Nb, Ni, Pt, Ru, W, Pd, Pt, wherein Al, Cr and Ti are preferred.

Suitable conductive ceramic materials include CrN, HfN, MoN, NbN, TiO₂, RuO2, VO2, NSTO (niobium-doped strontium titanate), TaN and TiN, WN, WCN, VN and ZrN, wherein TiN is preferred.

Suitable semiconductor materials include indium tin oxide (ITO), indium gallium oxide (IGO), InGa-α-ZnO (IGZO), aluminium-doped zinc oxide (AZO), tin-doped zinc oxide (TZO), fluorine-doped tin oxide (FTO) and antimony tin oxide.

Suitable element semiconductors include Si, Ge, C (diamond, graphite, graphene, fullerene), α-Sn, B, Se and Te. Suitable compound semiconductors include group III-V semiconductors, in particular GaAs, GaP, InP, InSb, InAs, GaSb, GaN, TaN, TiN, MoN, WN, AIN, InN, Alx Ga1-x As and Inx Ga1-x Ni, group II-VI semiconductors, in particular ZnO, ZnS, ZnSe, ZnTe, CdS, CdSe, CdTe, Hg(1-x) Cd(x) Te, BeSe, BeTex and HgS; and group III-VI semiconductors, in particular GaS, GaSe, GaTe, InS, InSex and InTe, group I-III-VI semiconductors, in particular CulnSe2, CulnGaSe2, CulnS2 and CulnGaS2, group IV-IV semiconductors, in particular SiC and SiGe, group IV-VI semiconductors, in particular SeTe.

Suitable highly doped semiconductor materials include p+Si, n+Si.

An example of a suitable layered conductive 2D material is graphene.

Suitable semi conductive organic molecules include polythiophene, tetracene, pentacene, phthalocyanines, PTCDA, MePTCDI, quinacridone, acridone, indanthrone, flaranthrone, perinone, AIQ3 , and mixed systems, in particular PEDOT:PSS and polyvinylcarbazole/TLNQ complexes.

In a preferred embodiment, the first and second electrodes, identically or differently, comprise a material selected from the group consisting of Ag, Al, Au, Co, Cr, Cu, Mo, Nb, Ni, Pt, Ru, Si, W, CrN, HfN, MoN, NbN, TiN, TaN, WN, WCN, VN and ZrN.

More preferably, the first and second electrodes, identically or differently, comprise, preferably consist of a metal nitride selected from CrN, HfN, MoN, NbN, TiN, TaN, WN, tungsten carbide nitride (WCN), VN and ZrN.

In particular, the first electrode consist of a metal nitride selected from CrN, HfN, MoN, NbN, TiN, TaN, WN, WCN, VN and ZrN, and the second electrode consists of TiN.

Very particularly, the first and the second electrode both consist of TiN.

The self-assembled monolayer is arranged between the first and second electrode and serves as electrical insulator between said two electrodes. Accordingly, the self-assembled monolayer is arranged such that within the switchable cell a closed layer is formed without any holes which allow a direct electrical connection between the first and second electrodes.

The switchable cell comprising the first electrode, the self-assembled monolayer and the second electrode form a tunnel junction, wherein the electrical properties of said tunnel junction may be influenced by switching the state of the self-assembled monolayer. Preferably, the self-assembled monolayer has ferroelectric properties so that a ferroelectric tunnel junction is formed. Ferroelectric tunnel junctions allow for high ratios between the electrical resistance of a low resistive state and a high resistive state of the switchable cell and are thus preferred.

The organic molecules of the self-assembled monolayer have an anchoring group and a dipolar unit, which are connected by means of a conformationally flexible unit.

An anchor group in the sense of the present invention is a functional group by means of which the organic molecule is adsorbed onto or bonded to a surface, in particular by means of physisorption, chemisorption or by chemical reaction. The surface is preferably one of the first and the second electrodes. If the first and/or the second electrodes are not suitable for bonding with the anchor group, an intermediate layer in the form of an anchoring layer may be included in the cell between one of the electrodes and the molecular layer. The anchoring layer is preferably arranged on a surface of the first and/or the second electrode.

A conformationally flexible unit in the sense of the present invention is a flexible chain between the dipolar unit and the anchor group which causes a separation between these sub-structures and, owing to its flexibility, at the same time improves the mobility of the dipolar unit after bonding to a substrate.

When the state of the molecular layer is changed by application of a switching voltage, the conformationally flexible unit allows for a change in the shape of the organic molecules. This change in the shape then influences the electrical properties of the molecular layer, in particular an electrical resistance of the molecular layer.

The organic molecules for the formation of the self-assembled monolayer according to the invention are selected from one or more compounds of the formula I

T-Z^{T}-(A¹-Z¹)ᵣ-B-(Z²A²)ₛ-(Z³A³)ₜ-(Z⁴A⁴)ᵤ-Sp-G (I)

in which
- T: isa three- to ten-membered saturated or partially unsaturated aliphatic ring, in which at least one -CH₂- group is replaced with -O-, -S-, -S(O)-, -SO₂-, -NR^{x}- or -N(O)R^{x}-, or in which at least one -CH= group is replaced with -N=,
- Z^{T}, Z¹, Z² and Z⁴,: on each occurrence identically or differently, denote a single bond, -CF₂O-, -OCF₂-, -CF₂S-, -SCF₂-, -CH₂O-, -OCH₂-, -C(O)O-, -OC(O)-, -C(O)S , -SC(O)-, -(CH₂)ₙ₁-, -(CF₂)ₙ₂-, -CF₂ CH₂-, -CH₂CF₂-, -CH=CH-, -CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- or-N=C-C=N-, wherein n1, n2, n3, n4, identically or differently, are 1, 2, 3, 4, 5, 6, 7, 8, 9 or 10,
- Z³: denotes -O-, -S-, -CH₂-, -C(O)-, -CF₂-, -CHF-, -C(R^{x})₂-, -S(O)- or -SO₂-,
- A¹, A² and A⁴,: on each occurrence, identically or differently, denote an aromatic, heteroaromatic, alicyclic or heteroaliphatic ring having 4 to 25 ring atoms, which may also contain condensed rings and which may be mono- or polysubstituted by Y,
- A³: denotes an aromatic or heteroaromatic ring having 5 to 25 ring atoms, which may also contain condensed rings and which may be mono- or polysubstituted by Y^{C},
- Y: on each occurrence, identically or differently, denotes F, Cl, CN, SCN, SF₅ or straight-chain or branched, in each case optionally fluorinated alkyl, alkoxy, alkylcarbonyl, alkoxycarbonyl, alkylcarbonyloxy or alkoxycarbonyloxy having 1 to 12 C atoms, preferably F or CI,
- Y^{C}: has one of the meanings of Y or denotes cycloalkyl or alkylcycloalkyl each having 3 to 12 C atoms, preferably methyl, ethyl, isopropyl, cyclopropyl, cyclobutyl, cyclopentyl, cyclohexyl, trifluoromethyl, methoxy or trifluoromethoxy,
- B: denotes 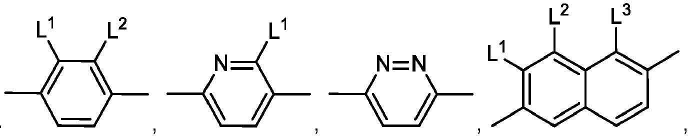 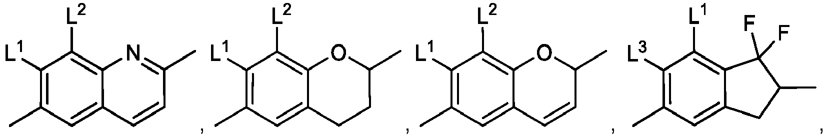 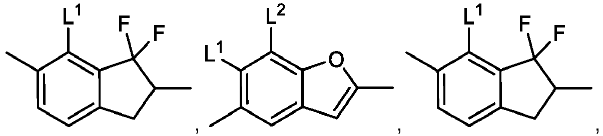 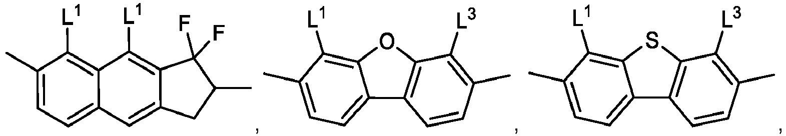 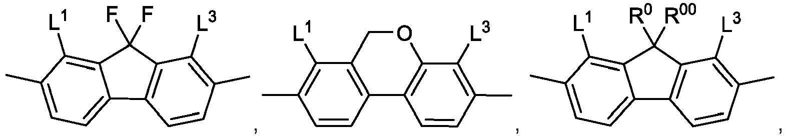 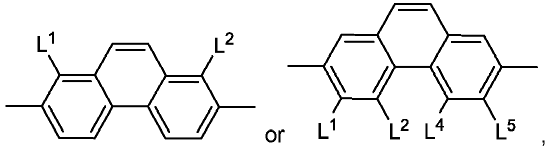 where the groups may be oriented in both directions,
- L¹ to L⁵,: independently of one another, denote F, C!, Br, I, CN, SF₅, CF₃ or OCF₃, preferably Cl or F, where L³ may alternatively also denote H,
- Sp: denotes a spacer group or a single bond,
- G: denotes -OH, -SH, -SO₂OH, -OP(O)(OH)₂, -PO(OH)₂, -C(OH)(PO(OH)₂)₂, -COOH, -Si(OR^{x})₃, -SiCl₃, -CH=CH₂, -POCl₂, -CO(NHOH), -CO(NR⁰OH), -Si(NMe₂)₃; -O-C(O)-OR^{V}, -O-C(O)-Si(OR^{V})₃, -PO(OR^{V})₂ or -SO₂OR^{V} or straight chain or branched alkyl having 1 to 12 C atoms in which one, two or three not geminal H atoms are substituted by OH, for example -CH(CH₂OH)₂ or -C(CH₂OH)₃;
- R°, R⁰⁰, R^{x}: denotes straight-chain or branched alkyl having 1 to 6 C atoms,
- R^{V}: denotes straight chain or branched alkyl having 1 to 12 C atoms, preferably secondary or tertiary alky, very preferably isopropyl or tert.-butyl, in particular tert.-butyl, and
- r, s, t, u,: identically or differently, are 0, 1 or 2.

Similar compounds are disclosed in WO 2016/110301, WO 2018/007337, WO 2019/238649, WO2020/225270, WO2020/225398 and WO2021/078699. Preferably, the organic molecules for the formation of the self-assembled monolayer are selected from one or more compounds of the formula IA and its sub-formulae set forth below.

A spacer group in the sense of the present invention is a flexible chain between dipolar moiety and anchor group which causes a separation between these sub-structures and, owing to its flexibility, at the same time improves the mobility of the dipolar moiety after bonding to a substrate.

The spacer group can be branched or straight chain. Chiral spacers are branched and optically active and non racemic.

Halogen is F, C!, Br or I, preferably F or CI.

Herein, alkyl is straight-chain or branched and has 1 to 15 C atoms, is preferably straight-chain and has, unless indicated otherwise, 1, 2, 3, 4, 5, 6 or 7 C atoms and is accordingly preferably methyl, ethyl, propyl, butyl, pentyl, hexyl or heptyl.

Herein, an alkoxy radical is straight-chain or branched and contains 1 to 15 C atoms. It is preferably straight-chain and has, unless indicated otherwise, 1, 2, 3, 4, 5, 6 or 7 C atoms and is accordingly preferably methoxy, ethoxy, propoxy, butoxy, pentoxy, hexoxy or heptoxy.

Herein, an alkenyl radical is preferably an alkenyl radical having 2 to 15 C atoms, which is straight-chain or branched and contains at least one C-C double bond. It is preferably straight-chain and has 2 to 7 C atoms. Accordingly, it is preferably vinyl, prop-1- or -2-enyl, but-1-, -2- or -3-enyl, pent-1-, -2-, -3- or -4-enyl, hex-1-, -2-, -3-, -4- or -5-enyl, hept-1-, -2-, -3-, -4-, -5- or -6-enyl. If the two C atoms of the C-C double bond are substituted, the alkenyl radical can be in the form of E and/or Z isomer (trans/cis). In general, the respective E isomers are preferred. Of the alkenyl radicals, prop-2-enyl, but-2- and -3-enyl, and pent-3- and -4-enyl are particularly preferred.

Herein alkynyl is taken to mean an alkynyl radical having 2 to 15 C atoms, which is straight-chain or branched and contains at least one C-C triple bond. 1- and 2-propynyl and 1-, 2- and 3-butynyl are preferred.

In formula I preferred aryl groups are derived, for example, from the parent structures benzene, naphthalene, tetrahydronaphthalene, 9,10-dihydrophenanthrene, fluorene, indene and indane.

In formula I, preferred heteroaryl groups are, for example, five-membered rings, such as, for example, furan, thiophene, selenophene, oxazole, isoxazole, 1,2-thiazole, 1,3-thiazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole and 1,3,4-thiadiazole, six-membered rings, such as, for example, pyridine, pyridazine, pyrimidine, pyrazine, 1,3,5-triazine, 1,2,4-triazine and 1,2,3-triazine, or condensed rings, such as, for example, indole, isoindole, indolizine, indazole, benzimidazole, benzotriazole, purine, naphthimidazole, benzoxazole, naphthoxazole, benzothiazole, benzofuran, isobenzofuran, dibenzofuran, thieno[2,3b]thiophene, thieno[3,2b]thiophene, dithienothiophene, isobenzothiophene, dibenzothiophene, benzothiadiazothiophene, 2H-chromen (2H-1-benzopyran), 4H-chromene (4H-1-benzopyran) and coumarin (2H-chromen-2-one), or combinations of these groups.

In formula I, preferred cycloaliphatic groups are cyclobutane, cyclopentane, cyclohexane, cyclohexene, cycloheptane, decahydronaphthalene, bicyclo[1.1.1]pentane, bicyclo[2.2.2]octane, spiro[3.3]heptane and octahydro-4,7-methanoindane.

In formula I, preferred heteroaliphatic groups are tetrahydrofuran, dioxolane, tetra-hydrothiofuran, pyran, dioxane, dithiane, silinane, piperidine and pyrrolidine.

A¹, A² and A⁴, on each occurrence, identically or differently, are particularly preferably selected from the following groups:
a) 1,4-phenylene, in which one or two CH groups may be replaced by N and in which one or more H atoms may be replaced by Y,
b) the group consisting of trans-1,4-cyclohexylene and 1,4-cyclohexenylene, in which, in addition, one or more non-adjacent CH₂ groups may be replaced by -O- and/or -Sand in which, in addition, one or more H atoms may be replaced by Y, and
c) the group consisting of 1,3-dioxolane-2,4-diyl, tetrahydrofuran-2,5-diyl, cyclobutane-1,3-diyl, 1,4-bicyclo[2.2.2]octanediyl, piperidine-1,5-diyl and thiophene-2,5-diyl, in which, in addition, one or more H atoms may be replaced by Y,
where Y has the meaning indicated above under formula I and preferably denotes F, Cl, CN or CF₃.

A³ is very preferably selected from the group consisting of 1,4-phenylene, naphthalene-1,4-diyl, naphthalene-1,5-diyl, naphthalene-2,6-diyl, anthracene-9,10-diyl, in which one or two CH groups may be replaced by N and in which one or more H atoms may be replaced by Y, where Y has the meaning indicated above under formula I, and wherein preferably the positions adjacent to the goup Z³ are not H.

In formula I the group G preferably denotes -SO₂OH, -OP(O)(OH)₂, -PO(OH)₂, -POCl₂, -COH(PO(OH)₂)₂, -Si(OR^{x})₃, -SiCl₃ or PO(OR^{V})₂, very preferably -OP(O)(OH)₂, - PO(OH)₂ or -COH(PO(OH)₂)₂, in particular -PO(OH)₂, where R^{V} has the meanings defined above, preferably Me, Et, n-Pr, i-Pr or t-Bu.

Preferred spacer groups Sp are selected from the formula Sp'-X', so that the radical G-Sp- of formula I corresponds to the formula G-Sp'-X'-,
where
- Sp': denotes straight-chain or branched alkylene having 1 to 20, preferably 1 to 12 C atoms, which is optionally mono- or polysubstituted by F, C!, Br, I or CN and in which, in addition, one or more non-adjacent CH₂ groups may each be replaced, independently of one another, by -O-, -S-, -NH-, -NR⁰-, -SiR⁰⁰R⁰⁰⁰-, -CO-, -COO-, -OCO-, -OCO-O-, -S-CO-, -CO-S-, -NR⁰-CO-O-, -O-CO-NR⁰-, -NR⁰-CO-NR⁰-, -CH=CH- or -C≡C- in such a way that O and/or S atoms are not linked directly to one another,
- X': denotes -O-, -S-, -CO-, -COO-, -OCO-, -O-COO-, -CO-NR⁰⁰-, -NR⁰⁰-CO-, -NR⁰⁰-CO-NR⁰⁰-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰⁰-, -CY^{x}=CY^{x'}-, -C≡C-, -CH=CH-COO-, -OCO-CH=CH- or a single bond,
- R⁰, R⁰⁰ and R⁰⁰⁰: each, independently of one another, denote H or alkyl having 1 to 12 C atoms, and
- Y^{x} and Y^{x'}: each, independently of one another, denote H, F, Cl or CN.
- X': is preferably -O-, -S-, -CO-, -COO-, -OCO-, -O-COO-, -CO-NR⁰-, -NR⁰-CO-, -NR⁰-CO-NR⁰- or a single bond.

Preferred groups Sp' are -(CH₂)ₚ₁-, -(CF₂)ₚ₁-, -(CH₂CH₂O)_{q1}-CH₂CH₂-, -(CF₂CF₂O)_{q1}-CF₂CF₂-, -CH₂CH₂-S-CH₂CH₂-, -CH₂CH₂-NH-CH₂CH₂- or-(SiR⁰⁰R⁰⁰⁰-O)ₚ₁₋, in which p1 is an integer from 1 to 12, q1 is an integer from 1 to 3, and R⁰⁰ and R⁰⁰⁰ have the meanings indicated above.

Particularly preferred groups -X'-Sp'- are -(CH₂)ₚ₁-, -O-(CH₂)ₚ₁-, -(CF₂)ₚ₁-, -O(CF₂)ₚ₁-, -OCO-(CH₂)ₚ₁- and -OC(O)O-(CH₂)ₚ₁-, in which p1 has the meaning indicated above.

Very particularly preferred groups Sp' are, for example, in each case straight-chain ethylene, propylene, butylene, pentylene, hexylene, heptylene, octylene, nonylene, decylene, undecylene, dodecylene, octadecylene, perfluoroethylene, perfluoropropylene, perfluorobutylene, perfluoropentylene, perfluorohexylene, perfluoroheptylene, perfluorooctylene, perfluorononylene, perfluorodecylene, perfluoroundecylene, perfluorododecylene, perfluorooctadecylene, ethyleneoxyethylene, methyleneeoxybutylene, ethylenethioethylene, ethylene-N-methyliminoethylene, 1-methylalkylene, ethenylene, propenylene and butenylene.

Particularly preferred groups X' are -O- or a single bond.

The organic molecules for the formation of the self-assembled monolayer are selected from compounds of the formula I in which the radical T denotes a three- to ten-membered saturated or partially unsaturated aliphatic ring, in which at least one -CH₂- group is replaced with -O-, -S-, -S(O)-, -SO₂-, -NR^{x}- or -N(O)R^{x}-, or in which at least one -CH= group is replaced with -N= as defined above and below.

An electronic element according to the invention comprising a self assembled monolayer that has been obtained from compounds of formula I in which the group T denotes a three- to ten-membered saturated or partially unsaturated aliphatic ring, in which at least one -CH₂- group is replaced with -O-, -S-, -NR^{x}-, -S(O)-, -SO₂-, -NR^{x}- or -N(O)R^{x}-, or in which at least one -CH= group is replaced with -N= as defined above and below, is distinguished by a particularly strong adhesion of the individual switching layers to the respective top electrodes, which contributes to an improved mechanical stability and structural reliability.

The present disclosure further relates to a compound of formula IA

T-Z^{T}-(A¹-Z¹)ᵣ-B-(Z²A²)ₛ-(Z³A³)ₜ-(Z⁴A⁴)ᵤ-Sp-G (IA)

in which
- T: denotes a three- to ten-membered saturated or partially unsaturated aliphatic ring, in which at least one -CH₂- group is replaced with -O-, -S-, -NR^{x}-, -S(O)-, -SO₂-, -NR^{x}- or -N(O)R^{x}-, or in which at least one -CH= group is replaced with -N=,
and the other groups and parameters have the meanings defined above.

Molecular layers obtained from these compounds are distinguished by significantly improved wettability by typical photoresist formulations and other process chemicals, improved deposition of materials by ALD on top of the SAM, higher quality of films deposited, e.g., by physical vapour deposition, and improved adhesion of the top electrode film.

In a preferred embodiment, the compounds of the formula IA are selected from the sub-formulae IA-1a to IA-1f,

T-Z^{T}-B-Sp-G IA-1a

T-Z^{T}-(A¹-Z¹)-B-Sp-G IA-1b

T-Z^{T}-(A¹-Z¹)₂-B-Sp-G IA-1c

T-Z^{T}-B-(Z²-A²)-Sp-G IA-1d

T-Z^{T}-B-(Z²-A²)₂-Sp-G IA-1e

T-Z^{T}-(A¹-Z¹)-B-(Z²-A²)- Sp-G IA-1f

in which T, Z^{T}, A¹, A², B, Z¹, Z², Sp and G have the meanings indicated above and preferably
T denotes 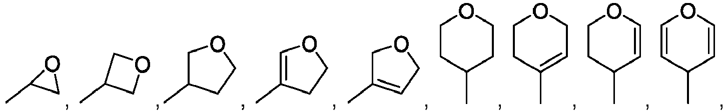 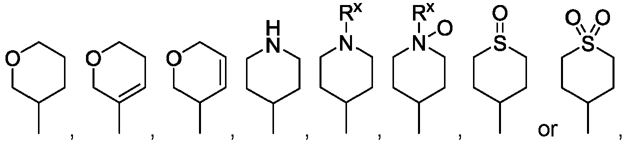
in which R^{x} denotes alkyl having 1 to 6 C atoms, preferably methyl.

In the compounds of formula I and its sub-formulae,
- A¹ and A²: identically or differently, denote 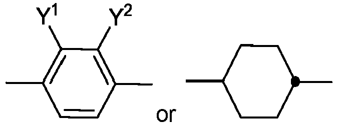
B denotes 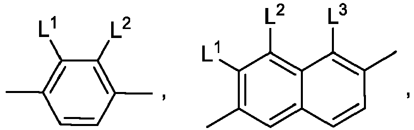 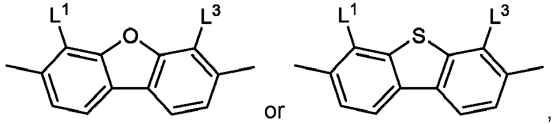
L¹ and L², independently of one another, denote CF₃, Cl or F, where preferably at least one of the radicals L¹ and L² denotes F,
L³ denotes H or F, preferably F
Y' and Y², independently of one another, denote H, Cl or F,
Z¹, Z²,Z^{T} independently of one another, denote a single bond, -CF₂O-, -OCF₂-, -CH₂O-, -OCH₂- or -CH₂CH₂-, preferably a single bond,
Sp denotes branched or unbranched, preferably unbranched, 1,ω-alkylene having 1 to 12 C atoms,
G denotes -OP(O)(OH)₂, -PO(OH)₂, or -COH(PO(OH)₂)₂.

Very particularly preferred sub-formulae of the formula IA-1 are the sub-formulae IA-1a-1 to IA-1d-18: 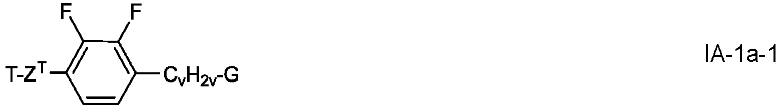 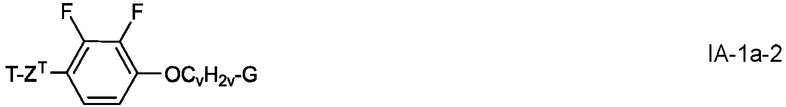 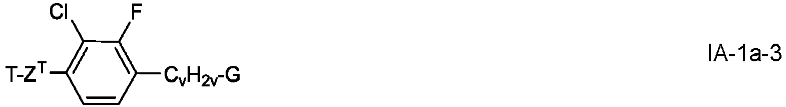 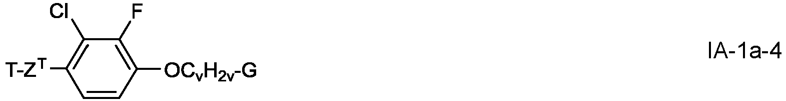 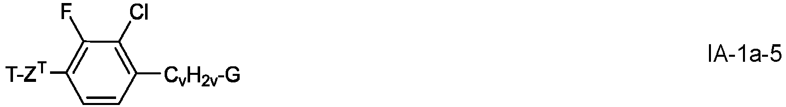 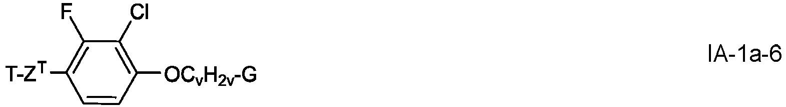 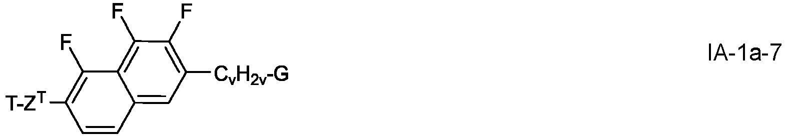 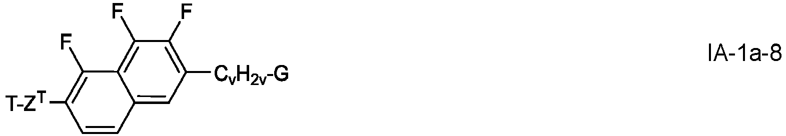 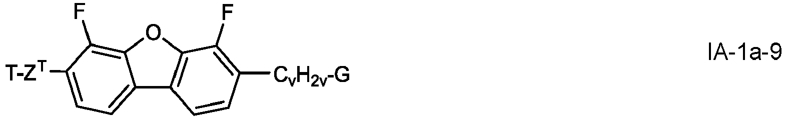 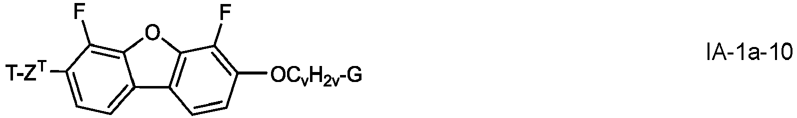 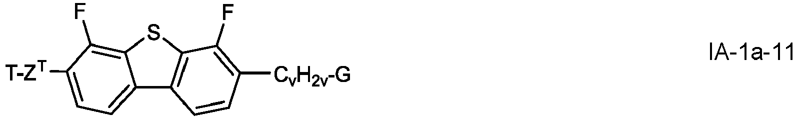 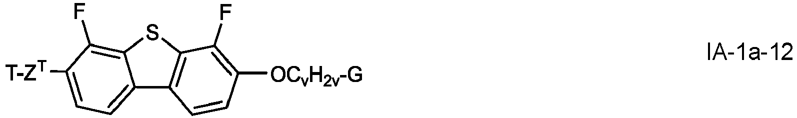 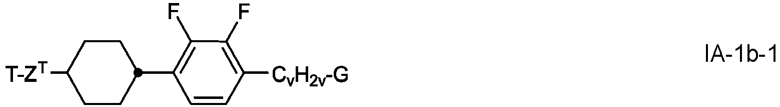 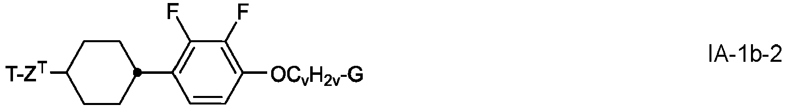 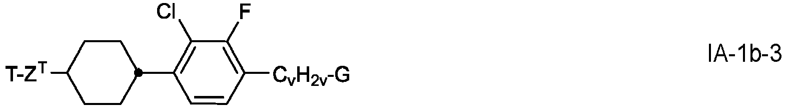 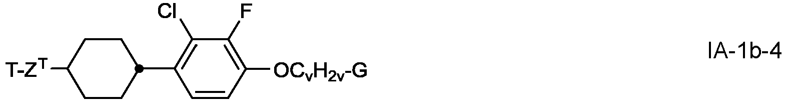 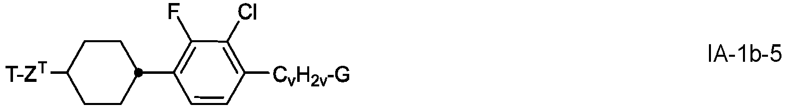 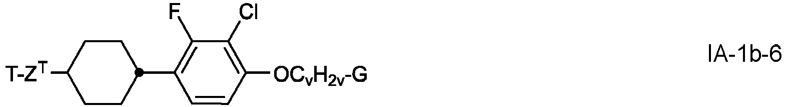 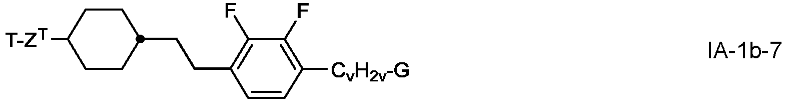 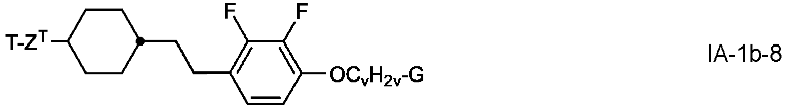 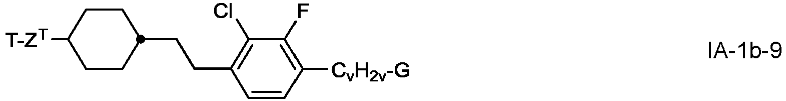 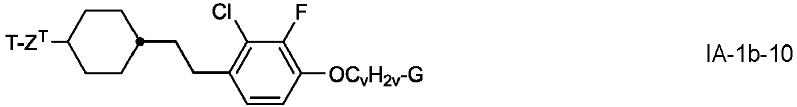 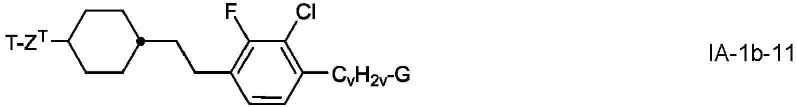 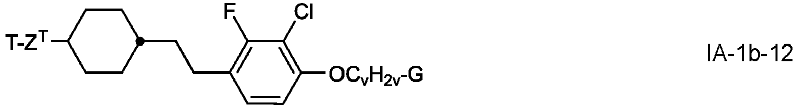 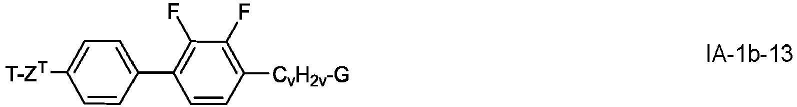 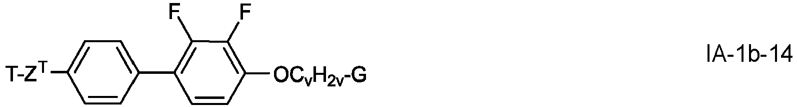 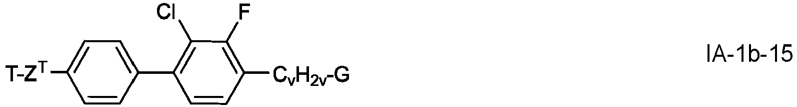 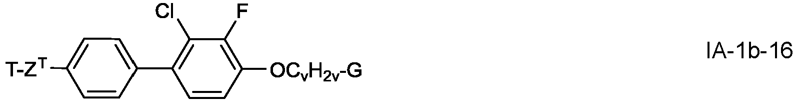 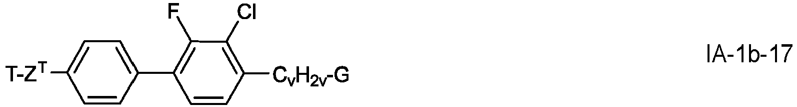 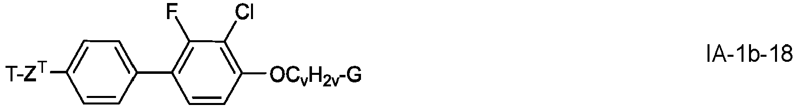 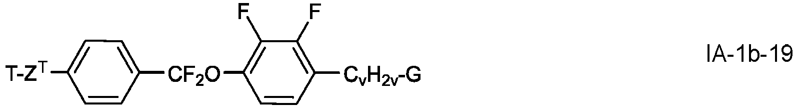 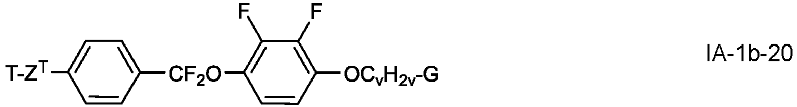 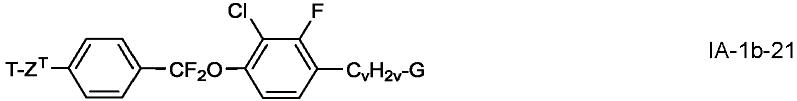 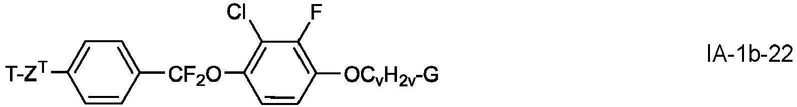 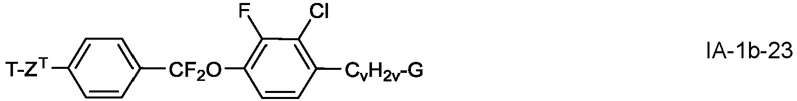 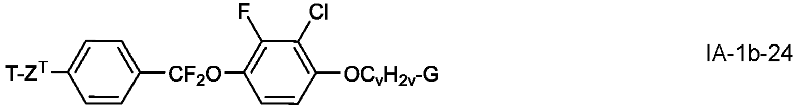 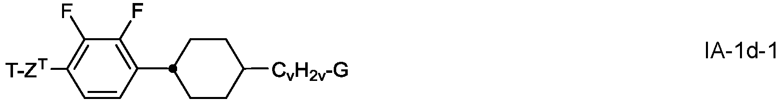 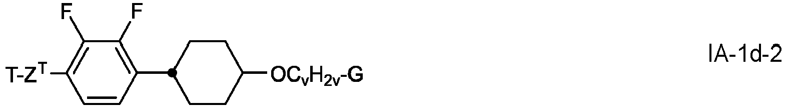 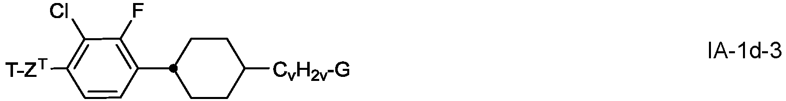 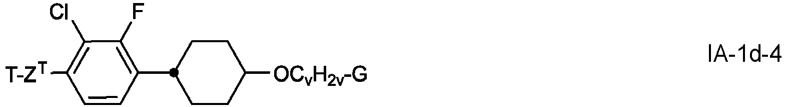 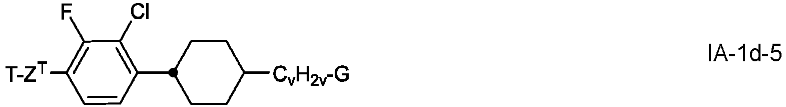 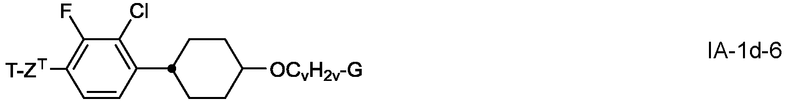 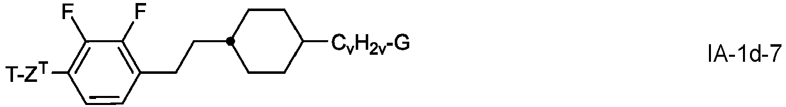 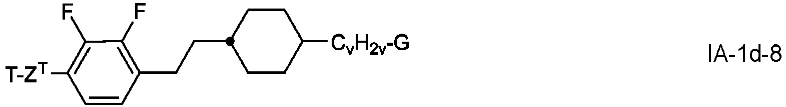 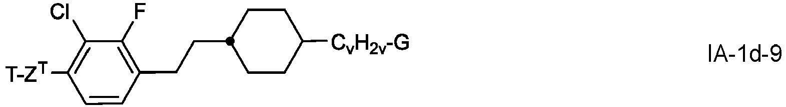 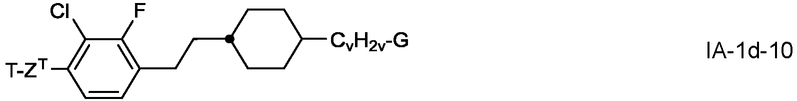 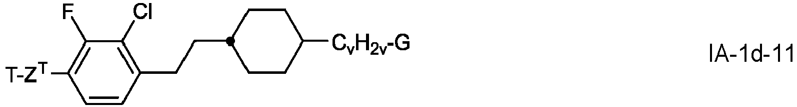 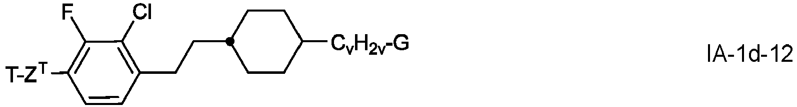 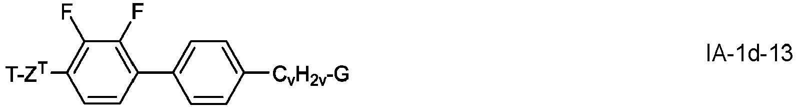 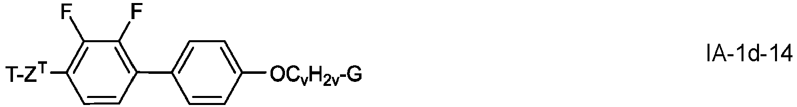 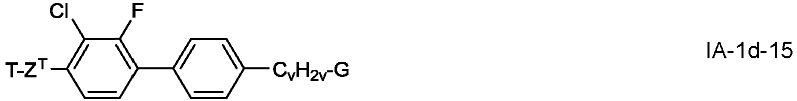 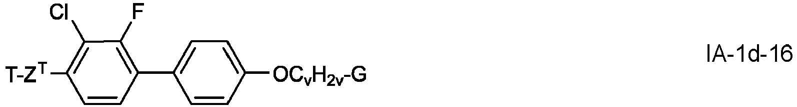 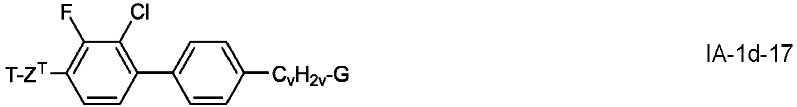 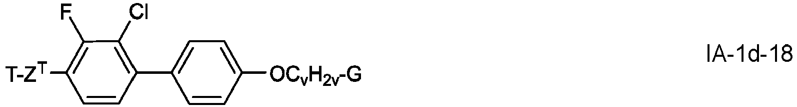 in which T, Z^{T}, and G have the meanings given above, v is an integer from 1 to 12, preferably from 2 to 7 and preferably
- T: denotes 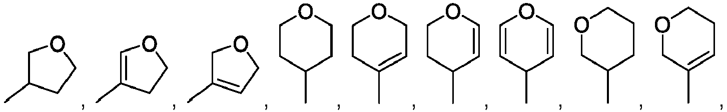 or 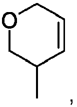 in particular 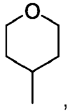
- Z^{T}: denotes -CH₂O-, -C≡C- or a single bond, very preferably a single bond,
- G: denotes -PO(OH)₂, or -COH(PO(OH)₂)₂, and
- v: is an integer from 2 to 7.

In a preferred ambodiment, the compounds of formula I are selected from the compounds of the formula IA-2

T-Z^{T}-(A¹-Z¹)ᵣ-B-Z³-A³-(Z⁴-A⁴)ᵤ-G IA-2

in which the occurring groups and parameters have the meanings given above for formula I and preferably
- T: denotes 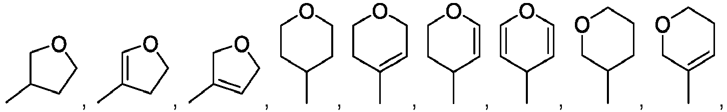 or 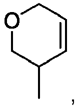 in particular

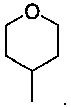

In the compounds of formula IA-2 and its sub-formulae, preferably
- A¹ and A⁴: identically or differently, denote 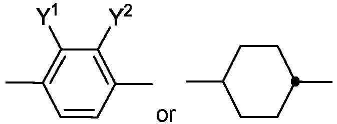
- A³-Z³: denotes 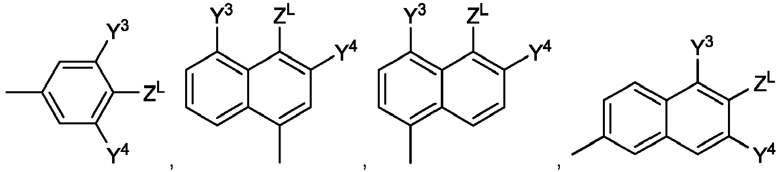 or 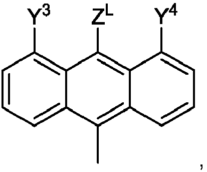
- B: denotes 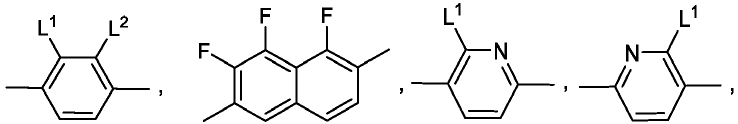 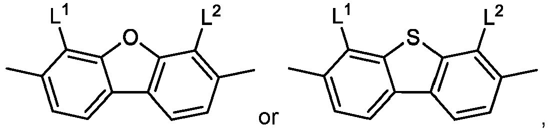
- Z^{T}: denote a single bond, -CH₂O-, -OCH₂- or -CH₂CH₂-,
- L¹ and L²: identically or differently, denote F, CF₃ or CI,
- Y¹ and Y²: identically or differently, have one of the meanings given above for Y and preferably denote H, F or CI,
- Y³ and Y⁴,: identically or differently, have one of the meanings given above for Y¹ and Y² and preferably denote methyl, ethyl, isopropyl, cyclopropyl, cyclobutyl, cyclopentyl, cyclopentenyl, cyclohexyl, cyclohexenyl, methoxy, trifluoromethyl, trifluoromethoxy, or trifluoromethylthio, very preferably methyl,
- Z³: denotes CH₂ or -O-, preferably O,
- Z¹, Z²,: independently of one another, denote a single bond, -C(O)O-, -OC(O)-, -CF₂O-, -OCF₂-, -CH₂O-, OCH₂- or -CH₂CH₂-, in particular a single bond, and
- G: denotes -PO(OH)₂, or -COH(PO(OH)₂)₂, preferably -PO(OH)₂,
- r and u,: independently are 0, 1 or 2, preferably 0 or 1.

Very preferred sub-formulae of the formula IA-2 are the sub-formulae IA-2-1 to IA-2-7: 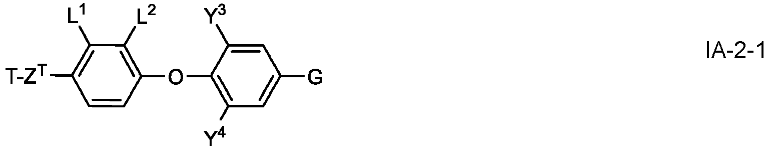 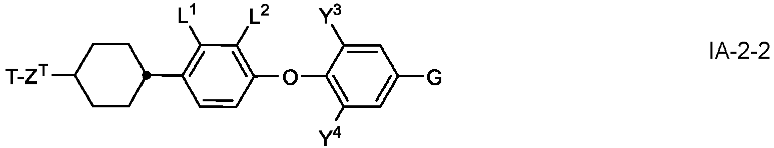 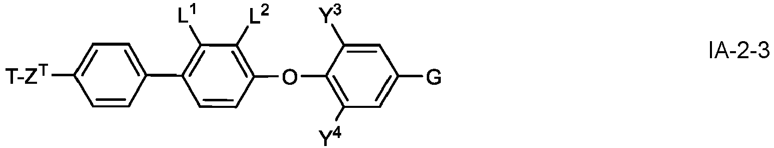 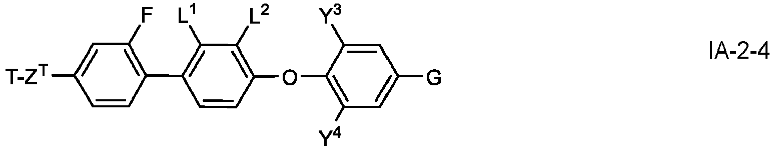 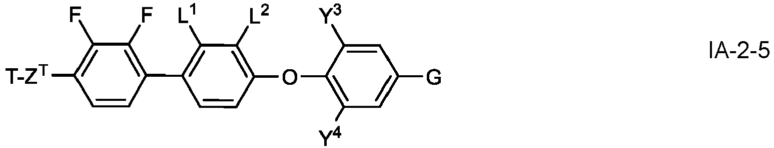 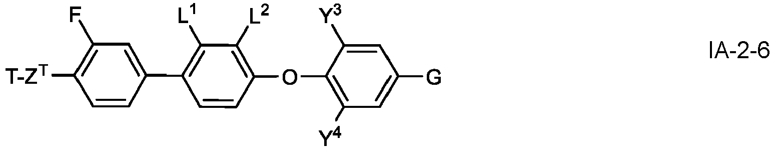 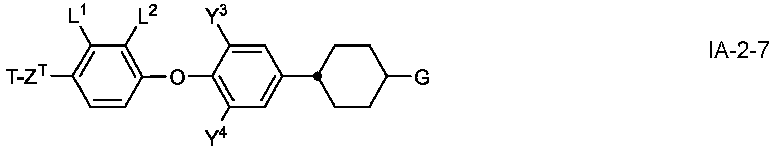 in which the occurring groups have the meanings given above for formula IA-2.

According to another aspect of the invention the molecular layer comprises one or more chiral non-racemic compounds selected from the compounds of the formula I.

The molecular layers obtained from chiral compounds of the formula I enable memristic devices with significantly reduced stochastic noise and faster switching, reducing the read and write error rate, which has a positive effect on energy-efficiency. In addition, increased tunnel currents are observed allowing for the integration to smaller junction sizes.

Preferably, the chiral compound has an enantiomeric excess (ee) of above 50%, preferably above 80%, 90%, or 95%, more preferably above 97%, in particular above 98%.

Chirality is achieved by a branched chiral group Sp of formula I above having one or more, preferably one or two, very preferably one, asymmetrically substituted carbon atom (or: asymmetric carbon atom, C*), hereinafter referred to as Sp*.

In Sp* the asymmetric carbon atom is preferably linked to two differently substituted carbon atoms, a hydrogen atom and a substituent selected from the group halogen (preferably F, CI, or Br), alkyl or alkoxy with 1 to 5 carbon atoms in each case, and CN.

The chiral organic radical Sp* preferably has the formula
in which
- X': has the meanings defined above for formula I and preferably denotes -CO-O-, -O-CO-, -O-CO-O-, -CO-, -O-, -S-, -CH=CH-, -CH=CH-COO- or a single bond, more preferably -CO-O-, -O-CO-, -O- or a single bond, very preferably -O- or a single bond,
- Q and Q': identically or differently, denote a single bond or optionally fluorinated alkylene having 1 to 10 carbon atoms, in which a CH₂ group not linked with X can also be replaced by -O-, -CO-, -O-CO-, -CO-O- or -CH=CH-, preferably alkylene having 1 to 5 carbon atoms or a single bond, particularly preferably -(CH₂)ₙ₅-, or a single bond,
- n5: is 1, 2, 3, 4, 5, or 6,
- Y: denotes optionally fluorinated alkyl having 1 to 15 carbon atoms, in which one or two non-adjacent CH₂ groups can also be replaced by -O-, -CO-,-O-CO-, -CO-O- and/or -CH=CH-, further CN or halogen, preferably optionally fluorinated alkyl or alkoxy having 1 to 7 C atoms, -CN or CI, particularly preferably -CH₃, -C₂H₅, -CF₃ or CI.

The compounds of the general formula IA according to the invention are prepared by methods known per se, as described in the literature (for example in the standard works, such as Houben-Weyl, Methoden der organischen Chemie [Methods of Organic Chemistry], Georg-Thieme-Verlag, Stuttgart), to be precise under reaction conditions which are known and are suitable for said reactions. Use can be made here of variants which are known per se, but are not mentioned here in greater detail.

Preferred synthetic pathways towards compounds of formula IA according to the invention are exemplified in the schemes below, and are further illustrated by means of the working examples. Suitable syntheses are also published for example in CN 103319444A or in P. Kirsch, M. Bremer, Angew. Chem. Int. Ed. 2000, 39, 4216-4235; M. Bremer, P. Kirsch, M. Klasen-Memmer, K. Tarumi, Angew. Chem. Int. Ed. 2013, 52, 8880-8896; and references cited therein, and can be adapted to the particular desired compounds of the general formula IA by choice of suitable starting materials.

The synthesis is illustrated by the following scheme 1.

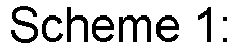

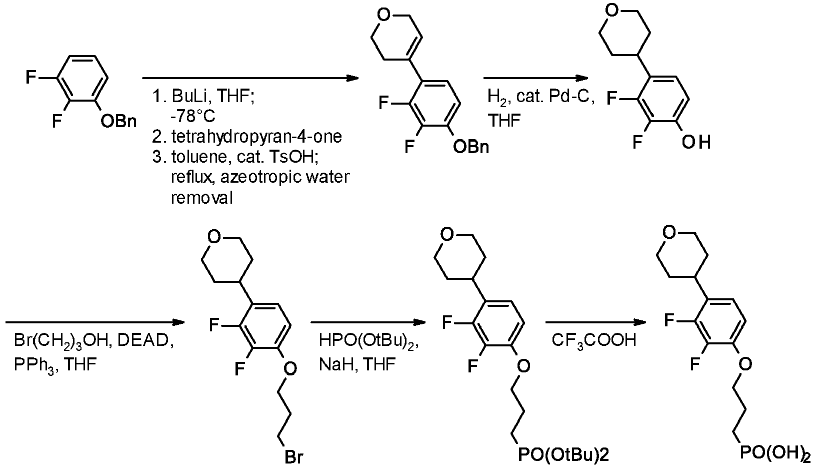

The syntheses of the *S*- and *N*-heterocyclic analogues work analogously, starting from the corresponding thianone and *N*-alkyl piperidone instead of tetrahydropyrane-4-one (Scheme 1). *S*-oxides and *N*-oxides are obtained from the corresponding tioethers or amines using known procedures such as by treatment with ozone (Scheme 2).

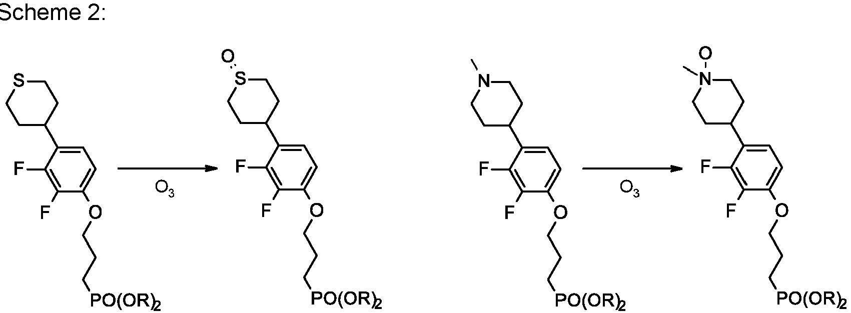

The electronic device is preferably arranged on a base substrate. Further, the electronic device preferably includes a dielectric material, which is arranged for electrical isolation of the electrode lines and/or the first/second electrodes.

Suitable materials for the base substrate as well as the dielectric are electrical insulators, wherein materials having good thermal conductivity are preferred. For example, large band-gap semiconductors such as GaN or SiC are suitable. Further particularly suitable materials include SiO₂, ZrO₂, diamond and Al₂O₃. The materials for the dielectric material and the base substrate may be chosen independently from each other so that it is possible to choose the same or different materials.

In case of the base substrate, the base substrate may be provided in the form of a further substrate coated with a layer forming the base substrate. For example, a wafer of highly doped p++ Si may be coated with a layer of SiO₂, wherein the SiO₂ layer forms the base substrate. Other suitable examples for suitable materials as further substrate includeSi, Ge, diamond, graphite, graphene, fullerene, α-Sn, B, Se, Te; GaAs, GaP, InP, InSb, InAs, GaSb, CrN, HfN, GaN, TaN, TiN, MoN, NbN, WCN, WN, AIN, InN, VN, ZrN,
AlxGa1-xAs and InxGa1-xNi, ZnO, ZnS, ZnSe, ZnTe, CdS, CdSe, CdTe, Hg(1-ₓ)Cd(ₓ)Te, BeSe, BeTeₓ and HgS; GaS, GaSe, GaTe, InS, InSeₓ and InTe, CuInSe₂, CuInGaSe₂, CuInS₂ and CuInGaS₂, SiC and SiGe, SeTe;
polythiophene, tetracene, pentacene, phthalocyanines, PTCDA, MePTCDI, quinacridone, acridone, indanthrone, flavanthrone, perinone, AlQ₃, PEDOT:PSS and polyvinylcarbazole/TLNQ complexes;
Ta, Ti, Co, Cr, Mo, Nb, Ni, Pt, Ru, Au, Ag, Cu, Al, Wand Mg; indium tin oxide, indium gallium oxide, InGa-α-ZnO, aluminium-doped zinc oxide, tin-doped zinc oxide, fluorine-doped tin oxide and antimony tin oxide.

Preferably, the anchoring layer, if present, comprises a material selected from the group consisting of Ag, Al, Au, Co, Cr, Cu, Mo, Nb, Ni, Pt, Ru, Si, W, CrN, HfN, MoN, NbN, TiN, TaN, WN, WCN, VN and ZrN, Al₂O₃, HfO₂, RuO₂, SiO₂, TiO₂, and ZrO₂.

A further aspect of the invention is providing of a method for producing the electronic element described herein.

The method for producing an electronic element comprising a plurality of cells as described herein comprises the steps of:
A) providing a base substrate,
B) formation of a first electrode layer comprising electrode lines separated by a dielectric material on the base substrate,
C) forming a molecular layer comprising a monolayer of organic molecules having an anchoring group connected to a dipolar unit by means of a conformationally flexible unit, and
D) deposition of a further electrode layer (22) comprising electrode lines (30) separated by a dielectric material (18).

The steps C) and D) are repeated until the desired number of layers of cells is formed, wherein the electrode lines of two adjacent electrode layers (are rotated with respect to each other so that the electrode lines of the two adjacent electrode layers cross each other. For example, two adjacent electrode layers may be rotated by 90° so that the electrode lines of two adjacent electrode layers are orthogonal to each other.

Preferably, the step A) of providing the base substrate includes a step of cleaning the substrate. The cleaning step may involve the use of one or more solvents and the use of an ultrasound bath.

Preferably, a selector device in the form of a diode layer structure or a threshold switch structure is deposited after formation of the first electrode layer according to step B) or a further electrode layer according to step D) and before forming of the molecular monolayer according to step C). A diode layer structure preferably comprises at least a p-doped semiconducting layer and an n-doped semiconducting layer.

Preferably, formation of the first electrode layer and/or the further electrode layers of electrode lines separated by a dielectric material comprises the steps of
- deposition of an electrode material,
- removing of the electrode material from non-electrode areas,
- deposition of a dielectric material, and
- planarization of the obtained layer structure down to the level of the electrode material,
   or, in case of formation of the first electrode layer, comprises the steps of
- deposition of a dielectric material,
- removing of the dielectric material from electrode areas,
- deposition of an electrode material, and
- planarization of the obtained layer structure down to the level of the dielectric material.

Planarization is preferably performed by means of chemical mechanical polishing. Preferably, removal of electrode material in the non-electrode areas or removal of dielectric material in the electrode areas is performed by a photolithographic method defining areas to be removed and etching.

Suitable etching methods include dry etching methods, wet etching, or combinations of these. Suitable dry etching methods include, for example, reactive ion etching and dry (plasma) etching techniques including high-pressure chemical etching, ion milling or reactive ion etching.

Preferably, deposition of the dielectric material and/or of the electrode material is performed by means of physical vapor deposition, chemical vapor deposition, chemical solution deposition, atomic layer deposition, microcontact- or transfer-printing or sol-gel method.

Physical vapor deposition methods include, in particular, evaporation, sputtering, epitaxy.

The coating with a molecular monolayer comprises the steps of
- pretreating of the substrate to be coated for cleaning and activation,
- dipping the substrate into a solution comprising organic molecules for forming a self-assembled monolayer of said molecules,
- rinsing with an organic solvent, and
- annealing of the formed molecular monolayer,
wherein the substrate to be coated is the first electrode layer, a further electrode layer or a surface of the selector device.

Alternatively to dip-coating, spin-coating may be used for forming the self-assembled monolayer.

The solution used for dipping is preferably a mixture of a phosphonic acid of the molecules for forming a self-assembled monolayer and a solvent. The concentration of the phosphonic acid of the molecules is preferably range of from 0.01 mM to 100 mM (millimolar, 10⁻³ mol/L), preferably in the range of from 0.1 mM to 10 mM.

Suitable solvents for preparing the solution as well as for rinsing include alcohols, ketones, nitriles, esters, ethers and dipolar aprotic solvents.

Preferred alcohols include ethanol, isopropanol. Suitable ketones include acetone, ethyl methyl ketone (EMK) and cyclohexanone. A suitable nitrile is, for example, acetonitrile. Suitable esters include propylene glycol methyl ether (PGME), propylene glycol methyl ether acetate (PGMEA), γ-butyrolactone (GBL). Suitable ethers include tetrahydrofuran (THF), dioxane, diglyme, anisole. Suitable dipolar aprotic solvents include N-Methyl-2-pyrrolidone (NMP), dimethylformamide (DMF), 1,3-Dimethyl-2-imidazolidinone (DMEU), N,N'-dimethylpropyleneurea (DMPU), dimethyl sulfoxide (DMSO).

In case of preparation of the solution for dipping, further suitable solvents include chlorobenzene, 1,2-dichlorobenzene, 1,2,4-trichlorobenzene, 1,2-difluorobenzene, chloroform and dichloromethane.

Preferably, the annealing is performed at a temperature in the range of from 50 °C to 250 °C for a time of from 1 min to 60 min.

Preferably, prior to dipping of the substrate into the solution, the pretreatment is performed by means of a UV-ozone treatment. The pretreatment is preferably performed using UV-light having a wavelength in the range of from 150 nm to 350 nm, wherein the substrate has a temperature in the range of from 50 °C to 300°C. The intensity of the UV-light is preferably in the range from 10 µW/cm² to 200 µW/cm². The ozone used in the pretreatment is obtained from oxygen present in the environment reacting with the UV light.

Preferably, after dipping and/or rinsing, the substrate is blown dry, for example by using a stream of nitrogen.

A further aspect of the invention is the use of one of the described electronic elements or of an electronic element obtained by means of one of the described methods as a memory device, wherein cells of the electronic element serve as memory cells, and/or as neural network device, wherein cells of the electronic element serve as synapses.

If the electronic element is used as a memory device, each of the cells serves as a memory cell. The cells may be individually addressed, in particular for reading and/or writing, by applying an appropriate signal to the two orthogonal electrode lines associated with the respective cell serving as bit lines and word lines.

Preferably, the cells have memristive properties, wherein a cell may have a high resistance state, in which the flow of electrical current is basically blocked, and a low resistance state, which allows the flow of electrical current. By making use of these properties, pathways for electrical signals through the electronic element may be configured by selectively adjusting the state of certain cells of the electronic element. This is particular useful for electronic elements configured as a neural network device. For example, signal/current pathways may evolve depending to excitation history, patterns and parameters such as bias voltage, pulse time / off-pulse time, compliance current, etc. in a percolation-like manner. In such a configuration, the electronic element is preferably contacted by few global external electrical probes only, in contrast to the conventional individual addressing of memory devices having word and bit lines.

Preferably, an electronic device is formed having one of the proposed electronic elements which is interfaced to common CMOS circuitry for processing input/weight/output information data.

Such an electronic device configured as neural network device is particularly useful for neuromorphic sensing, for example for processing image/video data.

The drawings show:
Figure 1 a schematic cross section of an electronic element having a three dimensional cross-bar arrangement of cells,
Figures 2a to 2l each show a top view and a cross section of the electronic element of figure 1 in different stages of production, and
Figure 3 a schematic view of a cell.

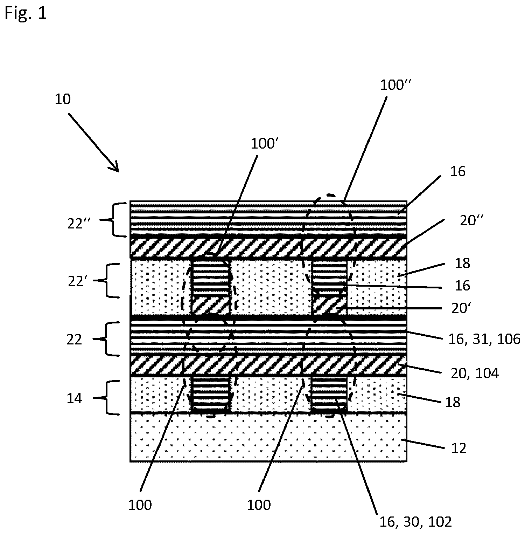

Figure 1 shows an example embodiment of an electronic element 10 having a plurality of cells 100 in a schematic cross section view. The schematic view of figure 1 shows only a part of the entire three-dimensional cross-bar arrangement of cells 100. The electronic element 10 may extend further in each of the three dimensions and may include much more than the six depicted cells 100.

The electronic element 10 of figure 1 comprises a layer structure having multiple levels, wherein a first level comprises in this order a base substrate 12, a first electrode layer 14, a molecular layer 20, and a further electrode layer 22. The base substrate 12 is preferably electrically insulating while having a good heat conductivity.

The first electrode layer 14 comprises electrode lines 30 separated by a dielectric material 18. The electrode lines 30 are made from an electrode material 16, which is electrically conductive. In figure 1, two electrode lines 30 are visible. However, the electronic component 10 may comprise a large number of electrode lines 30.

The molecular layer 20 is in the embodiment shown in figure 1 in direct contact with the first electrode layer 14 and in particular with the electrode lines 30. The molecular layer 20 is a self-assembled monolayer of organic molecules. The organic molecules have an anchoring group connected to a dipolar unit by means of a conformationally flexible unit. The anchoring group is in contact with the first electrode layer 14, in particular with the conductive material 16 forming the electrode lines 30 and thus anchors the molecules to a surface of the first electrode layer 14. In further embodiments, the electronic element 10 may include an anchoring layer located between the first electrode layer 14 and the molecular layer 20.

The further electrode layer 20 has a setup similar to the setup of the first electrode layer 14, but is rotated by 90°. Thus, rotated electrode lines 31 are formed in the further electrode layer 20 which are electrically insulated by dielectric material 18 and are orthogonal to the electrode lines 30. In other embodiments, the angle of rotation may be selected in the range of 45° to 135° to form crossed electrode lines 31, 30.

Cells 100 are located at crossings between two orthogonal electrode lines 30, 31, in particular at a crossing between an electrode line 30 and a rotated electrode line 31. Each cell 100 has a first electrode 102, a part 104 of the molecular layer 20 and a second electrode 106. In the embodiment of figure 1, a part of the electrode line 30 serves as first electrode 102 and a part of the rotated electrode line 31 serves as second electrode 106.

This structure may be extended by further levels, wherein a second level of the structure of figure 1 further comprises in this order another molecular layer 20' and another further electrode layer 22'. A third level of the structure comprises yet another molecular layer 20" and yet another further electrode layer 22". In figure 1, a cell 100' of the second level and a cell 100" of the third layer are marked.

With each addition of a molecular layer 20 and a further electrode layer 22, the structure is extended by a further level and thus a further layer of cells 100.

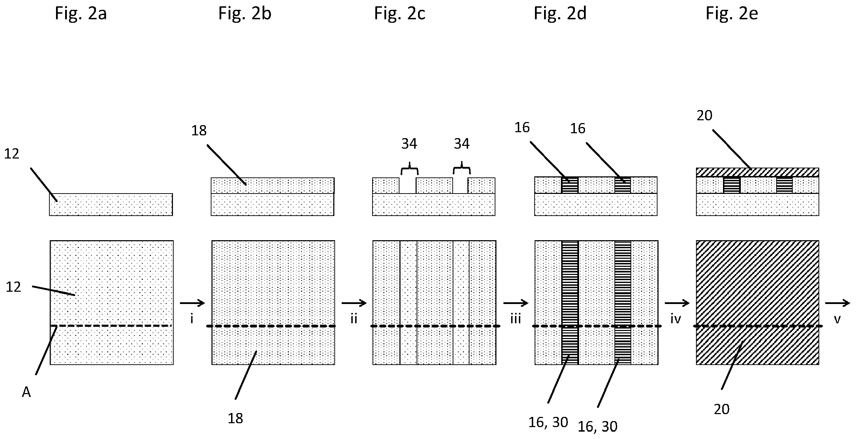

An example embodiment of the production of the electronic element is further described with respect to figures 2a to 2l. In each of the figures 2a to 2l, the lower part shows a top view and the upper part shows a cross section along the dashed line A viewed from the side.

Figure 2a shows a provided base substrate 12. In a first step i), an insulating layer in form of a dielectric material 18 is coated onto the substrate 12.

Figure 2b shows the base substrate 12 coated with the dielectric material 18.

In a subsequent step ii), trenches are formed in the layer of dielectric material 18. The trenches define electrode areas 34 as shown in figure 2c, in which an electrode will be formed in the following third step iii). The trenches depicted in figure 2c are aligned in a first direction and are parallel to each other.

Figure 2d shows that electrode lines 30 have been formed by deposition of electrode material 16 in the electrode areas 34 defined by the trenches prepared in step ii) and subsequent planarization down to the level of the dielectric material 18. The formed electrode lines 30 are aligned in a first direction and are parallel to each other.

In a further step iv), a molecular layer 20 comprising a monolayer of organic molecules is coated onto the surface of the dielectric material 18 and the electrode material 16. Prior to the coating, the surface is preferably cleaned and activated by an UV-ozone treatment. Coating may, for example, be performed by dipping the formed structure into a solution comprising the organic molecules. Figure 2e) shows the formed molecular layer 20 on the previously formed structure.

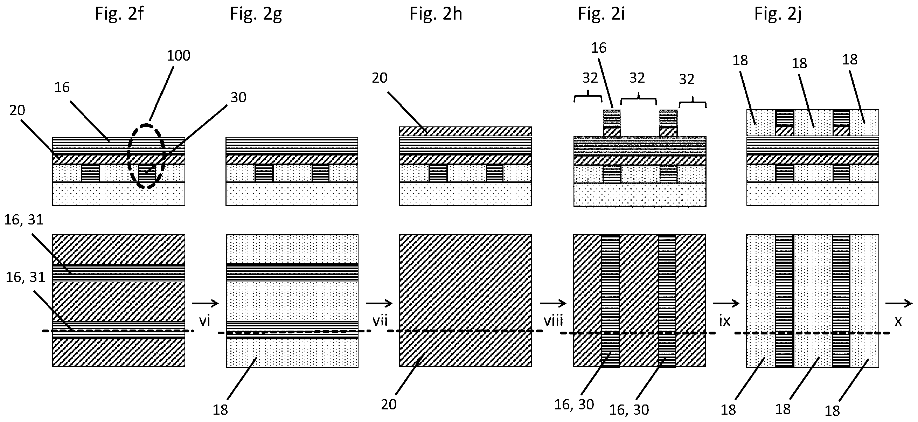

In a subsequent step v) a further layer of conductive material 16 is deposited onto the structure to form the basis for a further layer of conductive electrodes. After deposition, the conductive material 16 is selectively removed to form rotated electrode lines 31 depicted in figure 2f which are aligned in a second direction which is orthogonal to the first direction of the electrode lines 30.

The part of the molecular layer 20 located between a crossing of an electrode line 30 with a rotated electrode line 31 and the electrode lines 30, 31 serving as first and second electrode form a cell 100.

Figure 2g shows the structure after a further step vi). In step vi) a further layer of dielectric material 18 is deposited and subsequently planarized down to the level of the rotated electrode lines 31 formed in the previous step.

In step vii) a further molecular layer 20 is coated onto the structure as shown in figure 2h.

Figure 2i shows the structure after performing a subsequent step viii) in which a further layer of conductive material 16 is deposited and selectively removed in non-electrode areas 32. After removal of the conductive material 16 in the non-electrode areas 32, further electrode lines 30 arranged along the first direction are formed.

In a subsequent step ix) the trenches formed by removal of the conductive material 16 and of the molecular layer 20 in the non-electrode areas 32 are filled with dielectric material 18. After deposition of the dielectric material 18, planarization is performed down to the level of the conductive material 16 as shown in figure 2j.

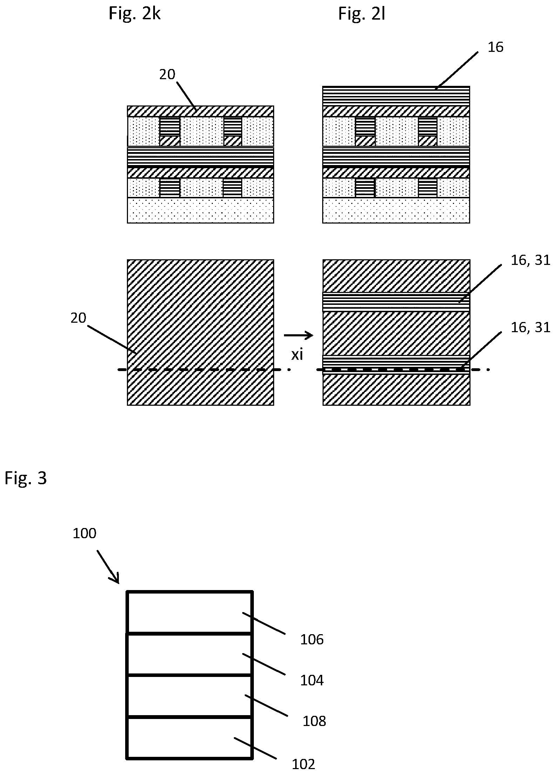

Figure 2k shows the structure after deposition of a further molecular layer 20 in a step x).

Figure 2l shows the structure after forming further rotated electrode lines 31 by deposition and selective removal of a further layer of conductive material 16 in a step xi).

By repeating the steps vi) to xi), further levels with further cells 100 located at crossings between an electrode line 30 and a rotated electrode line 31 can be obtained.

Figure 3 shows a layer structure of a cell 100 according to a second embodiment. While the cell 100 of the first embodiment, as shown in figure 1, comprises three layers, namely the first electrode 102, a part 104 of the molecular layer 20 and a second electrode 106, the cell 100 of the second embodiment as depicted in figure 3 comprises an additional selector device 108.

Accordingly, the cell 100 of the second embodiment comprises in this order the first electrode 102, the selector device 108, a part 104 of the molecular layer 20 and the second electrode 106. The selector device 108 itself may be configured as a layer structure comprising one or more layers. For example, the selector device 108 may be configured as a diode comprising an n-doped semiconducting layer and a p-doped semiconducting layer.

### Synthesis Examples

### Synthesis Example 1

### Step 1: 4-bromo-2,3-difluorophenylbenzylether

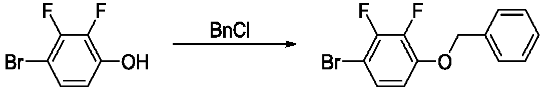

A mixture of 4-bromo-2,3-difluorophenol (78.6g, 0.376 mol), acetone (786 ml), benzyl chloride (50g, 0.395 mol) and potassium carbonate 325 mesh (207.9g, 1.50 mol) is heated at reflux for 16 h, The reaction is allowed to cool to room temp. and then filtered. The filtrates are evaporated to dryness in vacuo to leave an off-white solid (121.6g). The solid is dissolved in isopropanol (500 ml) at 65°C then allowed to cool and stir overnight to give a white suspension. The solid is collected by vacuum filtration, washed with isopropanol (2 x 50 ml) and dried, to give 4-bromo-2,3-difluorophenylbenzylether as a crystalline white solid, m.p. 70-73°C.

¹H NMR (400 MHz, CDCl₃) δ ppm 5.16 (2H, s), 6.71 (1H, ddd, J=9.2, 7.5, 2.1 Hz), 7.19 (1H, ddd, J=9.2, 7.0, 2.5 Hz), 7.31 - 7.48 (5H, m).

¹³C NMR (101 MHz, CDCl₃) δ ppm 71.68, 101.04 (d, J=18.3 Hz), 111.08 (d, J=2.9 Hz), 126.28 (d, J=4.4 Hz), 127.34, 128.34, 128.64, 135.60, 142.14 (dd, J=254.0, 14.8 Hz), 147.57 (dd, J=8.1, 2.9 Hz), 148.65 (dd, J=249.7, 11.8 Hz).

¹⁹F NMR (376 MHz, CDCl₃) δ ppm -128.7 (d, J=20.5 Hz), -135.8 (d, J=20.5 Hz).

### Step 2: 4-(4-benzyloxy-2,3-difluoro-phenyl)-3,6-dihydro-2H-pyran

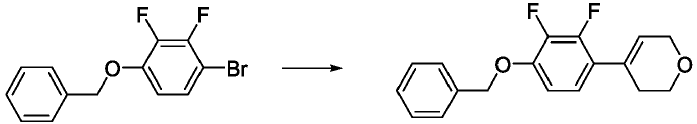

4-bromo-2,3-difluorophenylbenzylether (20.0g, 66.9 mmol) is dissolved in dry THF (200ml) under nitrogen and cooled to -85°C. n-BuLi (2.5M in hexanes, 17.0 ml, 73.6 mmol) is added dropwise over 30 min. After 1 h at -70°C, the reaction is cooled to - 85°C and 4-oxotetrahydropyran (8.0g, 80.2 mmol) is added dropwise over 10 min. The cooling bath is removed and the reaction allowed to warm to room temp. and stir overnight. The reaction is cooled to 10°C, then water (30 ml) is slowly added. After stirring for 30 min the mixture is partitioned between ethyl acetate (200 ml) and water (100 ml). The organic layer is collected and the aqueous layer extracted with ethyl acetate (2 x 100 ml). The combined organic phases are dried (MgSO₄) and concentrated to dryness in vacuo to leave a pale yellow solid. The solid is dissolved in dichloromethane and applied to a pad of silica (40-63µ, 70g) packed in dichloromethane. The pad is eluted with dichloromethane until all faster running 1-(benzyloxy)-2,3-difluorobenzene reduction product is removed. The pad is then eluted with ethyl acetate to remove the tertiary alcohol major reaction product. The ethyl acetate eluent is evaporated in vacuo to leave a pale yellow solid. The solid is dissolved in toluene (225 ml) at 40°C, then p-toluenesulfonic acid monohydrate (0.93g, 4.9 mmol) is added. The solution is heated to 70°C for 1 h, cooled to room temp. The reaction mixture is washed with water (3 x 30 ml) then dried (MgSO₄) and evaporated to an off-white solid, which is recrystallised from methanol (195 ml) to give 4-(4-benzyloxy-2,3-difluoro-phenyl)-3,6-dihydro-2H-pyran as colourless crystals, m.p. 103-107°C.

¹H NMR (400 MHz, CDCl₃) δ ppm 2.40 - 2.55 (2 H, m), 3.92 (2 H, t, J=5.4 Hz), 4.32 (2 H, m), 5.16 (2 H, s), 5.95 - 6.07 (1 H, m), 6.75 (1 H, ddd, J=9.0, 7.4, 1.9 Hz), 6.90 (1 H, td, J=8.4, 2.3 Hz), 7.30 - 7.53 (5 H, m).

¹³C NMR (100.6 MHz, CDCl₃) δ ppm 28.23 (d, J=2.2 Hz), 64.21, 65.53, 71.50, 109.87 (d, J=3.7 Hz), 121.45 (t, J=4.5 Hz), 123.37 (d, J=10.4 Hz), 126.23 (d, J=5.9 Hz), 127.30, 128.17, 128.58, 129.64 (t, J=2.2 Hz), 136.05, 141.79 (dd, J=249.7, 15.6 Hz), 146.89 (dd, J=8.5, 3.5 Hz), 149.10 (dd, J=250.6, 13.2 Hz).

¹⁹F NMR (376 MHz, CDCl₃) δ ppm -158.23 (d, J=19 Hz), -139.63 (d, J=19 Hz).

### Step 3: 2,3-difluoro-4-tetrahydropyran-4-yl-phenol

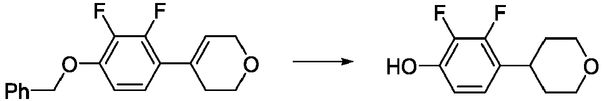

4-(4-benzyloxy-2,3-difluoro-phenyl)-3,6-dihydro-2H-pyran (10.5g, 34.7 mmol) is dissolved in a mixture of isopropanol (210 ml) and THF (31.5 ml) by sonication then hydrogenated over 5% Pd/C (0.53g, 50% wetted) at 5 bar pressure for 18 h, at which point, no further hydrogen is taken up. After release of excess hydrogen, degassing and back-filling with nitrogen, the solution is filtered through a GF/F 0.7µ filter to remove the catalyst and the filtrates concentrated in vacuo to give 2,3-difluoro-4-tetrahydropyran-4-yl-phenol as an off-white and used directly without further purification, m.p. 143-147°C

¹H NMR (400 MHz, DMSO-d6) δ ppm 1.53 - 1.77 (4 H, m), 2.85 - 3.03 (1 H, m), 3.43 (2 H, td, J=11.5, 2.6 Hz), 3.83 - 4.01 (2 H, m), 6.73 (1 H, td, J=8.4, 2.0 Hz), 6.90 (1 H, td, J=8.4, 2.2 Hz), 10.14 (1 H, br. s.).

¹³C NMR (100.6 MHz, DMSO-d6) δ ppm 32.46, 33.77, 67.37, 112.75 (m), 121.31 (dd, J=5.9, 4.5 Hz), 123.98 (dd, J=11.7, 1.5 Hz), 139.81 (d, J=242, 14.7 Hz), 144.76 (dd, J=8.8, 2.9 Hz), 148.90 (dd, J=243, 10.5 Hz).

¹⁹F NMR (376 MHz, DMSO-d6) δ ppm -161.89 (d, J=20.5 Hz), -144.54 (d, J=20.5 Hz).

### Step 4: 4-[4-(11-diethoxyphosphorylundecoxy)-2,3-difluoro-phenyl]tetrahydropyran

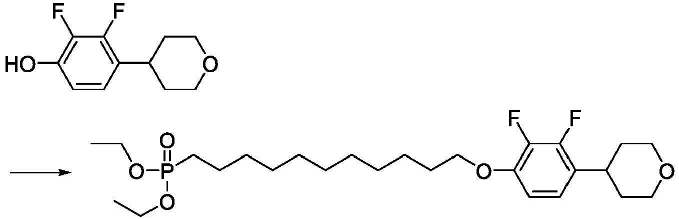

2,3-difluoro-4-tetrahydropyran-4-yl-phenol (5.0g, 23.3 mmol) is dissolved in butanone (65 ml) with stirring under nitrogen then diethyl (11-bromoundecyl)-phosphonate (11.3g, 30.3 mmol) and anhydrous potassium carbonate 325 mesh (12.9g, 93.4 mmol) are added. The mixture is heated under reflux for 18 hour. The reaction is allowed to cool to 30°C and filtered. The combined filtrates are evaporated in vacuo and the obtained orange oil (14.3g) applied to a silica column prepared with 40-63µ silica gel (140g) packed in dichloromethane. The column is eluted with an increasing gradient of ethyl acetate from 0-40% in dichloromethane and the product enriched fractions (10-30% ethyl acetate) are combined and evaporated to a colourless oil (9.6g),which is used directly without further purification.

¹H NMR (400 MHz, CDCl₃) δ ppm 1.21 - 1.52 (20 H, m), 1.52 - 1.66 (2 H, m), 1.66 - 1.89 (8 H, m), 2.94 - 3.14 (1 H, m), 3.55 (2 H, td, J=11.7, 2.3 Hz), 3.95 - 4.21 (8 H, m), 6.63 - 6.75 (1 H, m), 6.85 (1 H, td, J=8.2, 2.3 Hz).

¹³C NMR (101 MHz, CDCl₃) δ ppm 16.39, 16.45, 22.34 (d, J=5.1 Hz), 25.62 (d, J=140 Hz), 25.81, 29.02, 29.11, 29.24, 29.27, 29.42, 30.45, 30.62, 32.64, 34.12, 61.31 (d, J=5.9 Hz), 68.20, 69.78, 109.47 (d, J=2.9 Hz), 120.41 (t, J=5.1 Hz), 126.12 (d, J=11.7 Hz), 141.40 (dd, J=247, 14.7 Hz), 146.74 (dd, J=8.1, 2.9 Hz), 149.35 (dd, J=246, 10.3 Hz).

¹⁹F NMR (376 MHz, CDCl₃) δ ppm -159.28 (d, J=20.5 Hz), -143.542 (d, J=20.5 Hz). ³¹P NMR (162 MHz, CDCl₃) δ ppm 32.64.

### Step 5: 11-(2,3-difluoro-4-tetrahydropyran-4-yl-phenoxy)undecylphosphonic acid

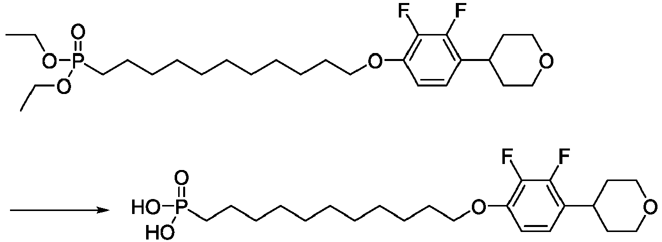

4-[4-(11-diethoxyphosphorylundecoxy)-2,3-difluoro-phenyl]tetrahydropyran (9.2g, 93.5% w/w, 17.0 mmol) is dissolved in dichloromethane (138 ml) with stirring and bromotrimethylsilane (28.1g, 182.3 mmol) is added over 10 min at ambient temperature, then stirred overnight. The mixture is evaporated in vacuo and the resultant oil is re-dissolved in dichloromethane (125 ml) and methanol (125 ml) then re-evaporated in vacuo to an oil. The oil is re-dissolved in dichloromethane (75ml) and methanol (75 ml) and then slowly concentrated in vacuo to ca. 40ml final volume to remove the dichloromethane. The solution is then cooled in an ice/acetone bath to - 15°C for 1 hour, which led to the formation of a white precipitate. The solid is filtered-off and dried overnight at 50°C under vacuum to give an off-white solid. The solid is dissolved in THF (50ml) and heptane (50ml) is added. The solution is concentrated in vacuo at 45°C, 400 mbar, slowly removing the THF, until a solid began to precipitate. The distillation is stopped and the mixture is allowed to stir at ambient temperature for 90 min before the solid is collected by vacuum filtration and washed with heptane (3 x 10ml). Drying overnight at 50°C under vacuum gives 11-(2,3-difluoro-4-tetrahydropyran-4-yl-phenoxy)undecylphosphonic acid as a cloourless solid, m.p. 94-98°C.

¹H NMR (400 MHz, THF-d8) δ ppm 1.27 - 1.43 (12 H, m), 1.43 - 1.52 (2 H, m), 1.53 - 1.69 (6 H, m), 1.69 - 1.83 (4 H, m), 3.02 (1 H, tt, J=11.9, 3.8 Hz), 3.46 (2 H, td, J=11.6, 2.1 Hz), 3.95 (2 H, dd, J=11.0, 3.9 Hz), 4.02 (2 H, t, J=6.5 Hz), 6.77 - 6.87 (1 H, m), 6.94 (1 H, td, J=8.3, 2.2 Hz).

¹³C NMR (101 MHz, THF-d8) δ ppm 23.76, 23.80, 26.92, 27.90 (d, J=142 Hz), 30.19, 30.28, 30.37, 30.50, 30.60 (br.), 31.60, 31.77, 33.84, 35.41, 68.77, 70.39, 110.46 (d, J=2.2 Hz), 121.71 (t, J=5.1 Hz), 127.23 (d, J=13.2 Hz), 142.21 (dd, J=247, 14.7 Hz), 147.93 (dd, J=8.1, 2.9 Hz), 150.31 (dd, J=244, 10.3 Hz).

¹⁹F NMR (376 MHz, THF-d8) δ ppm -162.90 (d, J=20.5 Hz), -147.28 (d, J=20.5 Hz). ³¹P NMR (162 MHz, THF-d8) δ ppm 30.71.

MS (ES negative): Found m/z [M-H]- 447.2108 (28%); C22H34F2O5P- requires m/z 447.21.

### Application Tests

Test chips are prepared from Compound A (Synthesis Example 1) according to the invention and for comparison from compounds B and C from prior art:

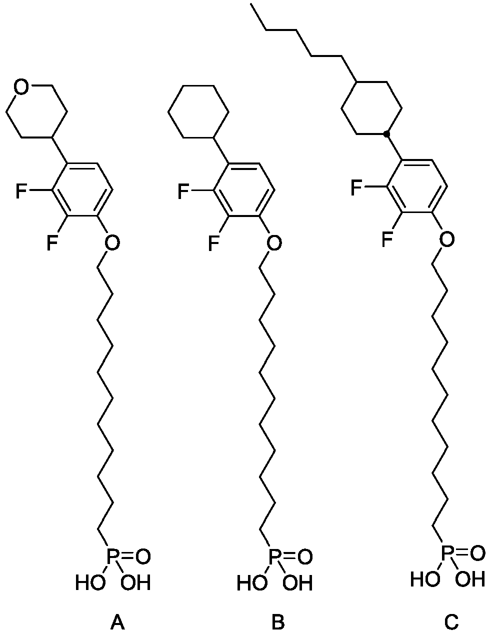

### Preparation of test chips:

A silicon chip (Siegert wafer substrate lot 19335; 8 × 8 × 0.5 mm; p-Si/SiO2 (~0.5 mm)/SiAIOx (1-2 nm)/Al2O3 (2 nm); conditioned by oxygen plasma treatment (<0.2 mbar O2, 1 min, 200 W) is immersed for 24 h into a 1 mM solution of the corresponding phosphonic acid (A, B or C) in THF. The chip is removed from the bath, blown dry under nitrogen, then heated on a hotplate at 120°C for 1 h under nitrogen. Afterwards the chip is washed with ethanol three times and dried on a hotplate at 120°C for 5 min under nitrogen.

### Measurement of Water Contact Angle (WCA)

The water contact angle of the test chips with A, B or C is determined by known methods. It is found that the tetrahydropyrane derivative A induces a much lower contact angle than B or C, indicating a strongly increased surface energy. Actually the WCA is similar to that of typical oxidic materials, making it well compatible with standard photoresist formulations. Just omitting the terminal alkyl chain results only in a very moderate reduction of the WCA, as the comparison of the compounds B and C shows.

| Test chip | compound | WCA |
|---|---|---|
| 1 | A | 64.0° |
| 2 | B | 99.5° |
| 3 | C | 107.6° |

### Adhesion Test

Onto the SAM-modified chips 1 and 2 first chromium (30 nm), then gold (200 nm) is sputtered.

Then, the samples are subjected to a "scotch tape adhesion test" according to DIN EN ISO 2409 (ASTM D 3002, ASTM D 3359), analogous to ASTM D 3359; available at https://www.astm.org/Standards/D4541.htm: The metal-sputtered sample is scratched with a lattice cutter (BYK-Gardner Multi-Cut tool; 1 mm cut distance). Then Permacel tape is applied and removed again. The test chip 1 treated with compound 7 remains >90% intact, whereas chip 2 is only 30% intact.

In analogy to Synthesis Example 1 the following compounds are obtained. Compounds of formula IA-1a

| No. | T | Z^{T} | B | Sp | G |
|---|---|---|---|---|---|
| 2 | 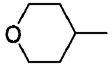 | - | 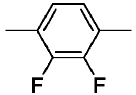 | OCH₂CH₂ | -PO(OH)₂ |
| 3 | 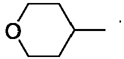 | - | 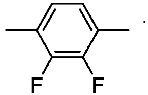 | O(CH₂)₃CH₂ | -PO(OH)₂ |
| 4 | 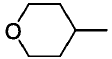 | - | 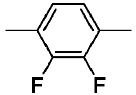 | O(CH₂)₄CH₂ | -PO(OH)₂ |
| 5 | 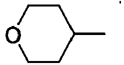 | - | 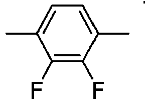 | O(CH₂)₅CH₂ | -PO(OH)₂ |
| 6 | 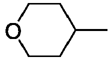 | - | 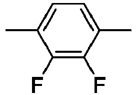 | O(CH₂)₆CH₂ | -PO(OH)₂ |
| 7 | 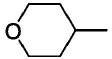 | - | 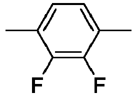 | O(CH₂)₈CH₂ | -PO(OH)₂ |
| 8 | 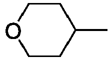 | - | 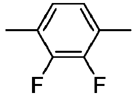 | 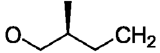 | -PO(OH)₂ |
| 9 | 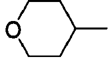 | CH₂CH₂ | 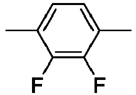 | O(CH₂)₁₀CH₂ | -PO(OH)₂ |

| No. | T | Z^{T} | B | Sp | G |
|---|---|---|---|---|---|
| 10 | 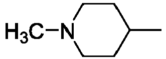 | - | 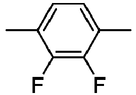 | OCH₂CH₂ | -PO(OH)₂ |
| 11 | 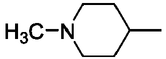 | - | 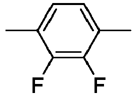 | O(CH₂)₃CH₂ | -PO(OH)₂ |
| 12 | 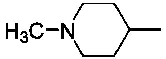 | - | 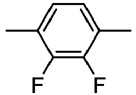 | O(CH₂)₄CH₂ | -PO(OH)₂ |
| 13 | 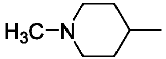 | - | 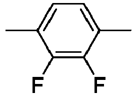 | O(CH₂)₅CH₂ | -PO(OH)₂ |
| 14 | 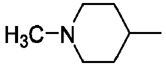 | - | 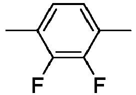 | O(CH₂)₆CH₂ | -PO(OH)₂ |
| 15 | 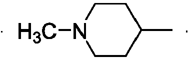 | - | 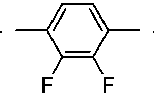 | O(CH₂)₈CH₂ | -PO(OH)₂ |
| 16 | 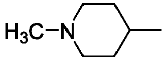 | - | 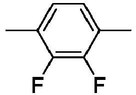 | O(CH₂)₁₀CH₂ | -PO(OH)₂ |
| 17 | 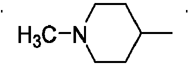 | - | 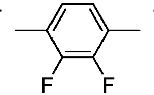 | 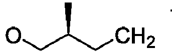 | -PO(OH)₂ |
| 18 | 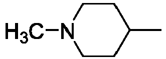 | CH₂CH₂ | 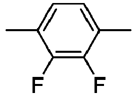 | O(CH₂)₁₀CH₂ | -PO(OH)₂ |

| No. | T | Z^{T} | B | Sp | G |
|---|---|---|---|---|---|
| 19 | 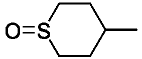 | - | 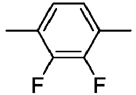 | OCH₂CH₂ | -PO(OH)₂ |
| 20 | 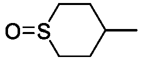 | - | 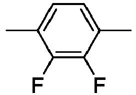 | O(CH₂)₃CH₂ | -PO(OH)₂ |
| 21 | 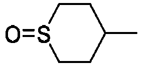 | - | 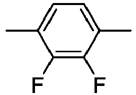 | O(CH₂)₄CH₂ | -PO(OH)₂ |
| 22 | 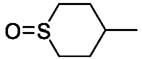 | - | 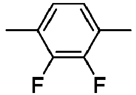 | O(CH₂)₅CH₂ | -PO(OH)₂ |
| 23 | 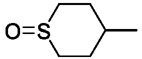 | - | 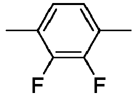 | O(CH₂)₅CH₂ | -OH |
| 24 | 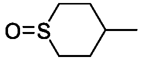 | - | 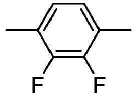 | O(CH₂)₆CH₂ | -PO(OH)₂ |
| 25 | 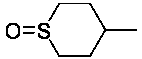 | - | 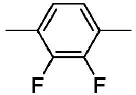 | O(CH₂)₈CH₂ | -PO(OH)₂ |
| 26 | 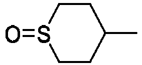 | - | 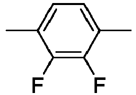 | O(CH₂)₁₀CH₂ | -PO(OH)₂ |
| 27 | 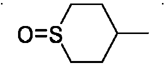 | - | 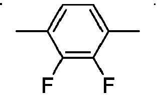 | 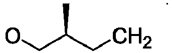 | -PO(OH)₂ |
| 28 | 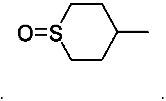 | CH₂CH₂ | 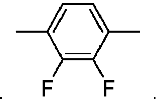 | O(CH₂)₁₀CH₂ | -PO(OH)₂ |

| No. | T | Z^{T} | B | Sp | G |
|---|---|---|---|---|---|
| 29 | 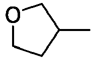 | - | 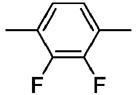 | OCH₂CH₂ | -PO(OH)₂ |
| 30 | 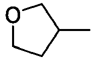 | - | 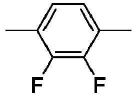 | O(CH₂)₃CH₂ | -PO(OH)₂ |
| 31 | 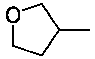 | - | 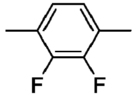 | O(CH₂)₄CH₂ | -PO(OH)₂ |
| 32 | 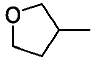 | - | 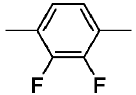 | O(CH₂)₅CH₂ | -PO(OH)₂ |
| 33 | 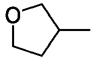 | - | 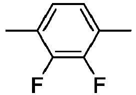 | O(CH₂)₆CH₂ | -PO(OH)₂ |
| 34 | 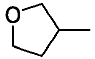 | - | 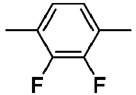 | O(CH₂)₈CH₂ | -PO(OH)₂ |
| 35 | 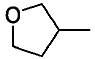 | - | 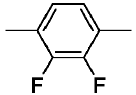 | O(CH₂)₁₀CH₂ | -PO(OH)₂ |
| 36 | 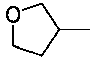 | - | 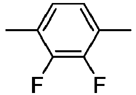 | 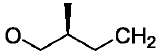 | -PO(OH)₂ |
| 37 | 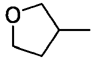 | CH₂CH₂ | 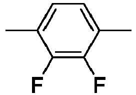 | O(CH₂)₁₀CH₂ | -PO(OH)₂ |

| No. | T | Z^{T} | B | Sp | G |
|---|---|---|---|---|---|
| 38 | 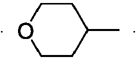 | - | 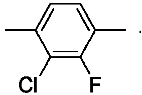 | OCH₂CH₂ | -PO(OH)₂ |
| 39 | 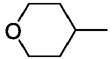 | - | 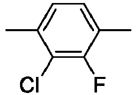 | O(CH₂)₃CH₂ | -PO(OH)₂ |
| 40 | 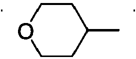 | - | 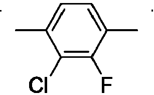 | O(CH₂)₄CH₂ | -PO(OH)₂ |
| 41 | 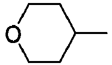 | - | 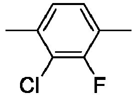 | O(CH₂)₅CH₂ | -PO(OH)₂ |
| 42 | 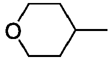 | - | 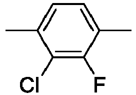 | O(CH₂)₆CH₂ | -PO(OH)₂ |
| 43 | 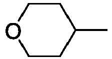 | - | 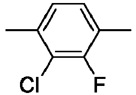 | O(CH₂)₈CH₂ | -PO(OH)₂ |
| 44 | 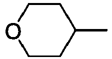 | - | 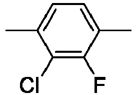 | O(CH₂)₁₀CH₂ | -PO(OH)₂ |
| 45 | 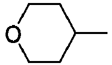 | - | 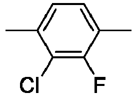 | 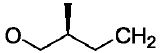 | -PO(OH)₂ |
| 46 | 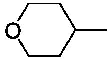 | CH₂CH₂ | 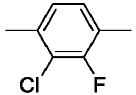 | O(CH₂)₁₀CH₂ | -PO(OH)₂ |

| No. | T | Z^{T} | B | Sp | G |
|---|---|---|---|---|---|
| 47 | 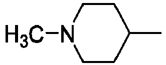 | - | 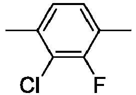 | OCH₂CH₂ | -PO(OH)₂ |
| 48 | 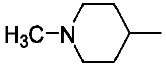 | - | 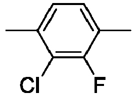 | O(CH₂)₃CH₂ | -PO(OH)₂ |
| 49 | 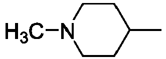 | - | 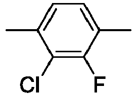 | O(CH₂)₄CH₂ | -PO(OH)₂ |
| 50 | 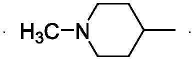 | - | 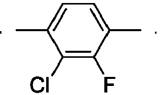 | O(CH₂)₅CH₂ | -PO(OH)₂ |
| 51 | 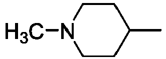 | - | 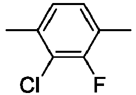 | O(CH₂)₆CH₂ | -PO(OH)₂ |
| 52 | 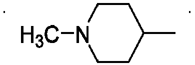 | - | 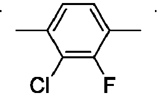 | O(CH₂)₈CH₂ | -PO(OH)₂ |
| 53 | 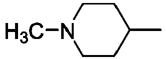 | - | 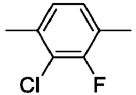 | O(CH₂)₁₀CH₂ | -PO(OH)₂ |
| 54 | 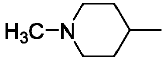 | - | 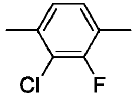 | 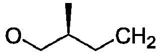 | -PO(OH)₂ |
| 55 | 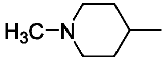 | CH₂CH₂ | 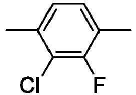 | O(CH₂)₁₀CH₂ | -PO(OH)₂ |
| 56 | 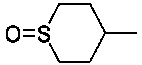 | - | 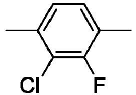 | OCH₂CH₂ | -PO(OH)₂ |
| 57 | 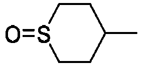 | - | 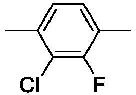 | O(CH₂)₃CH₂ | -PO(OH)₂ |
| 58 | 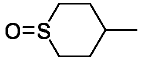 | - | 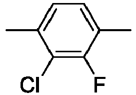 | O(CH₂)₄CH₂ | -PO(OH)₂ |
| 59 | 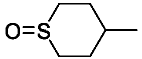 | - | 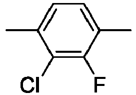 | O(CH₂)₅CH₂ | -PO(OH)₂ |
| 60 | 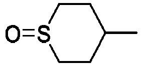 | - | 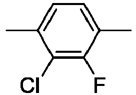 | O(CH₂)₆CH₂ | -PO(OH)₂ |
| 61 | 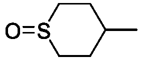 | - | 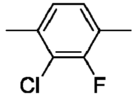 | O(CH₂)₈CH₂ | -PO(OH)₂ |
| 62 | 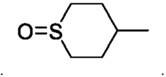 | - | 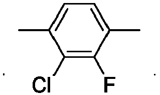 | O(CH₂)₁₀CH₂ | -PO(OH)₂ |
| 63 | 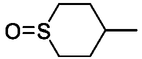 | - | 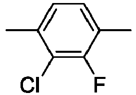 | 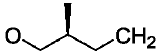 | -PO(OH)₂ |
| 64 | 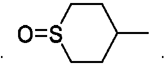 | CH₂CH₂ | 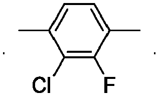 | O(CH₂)₁₀CH₂ | -PO(OH)₂ |

| No. | T | Z^{T} | B | Sp | G |
|---|---|---|---|---|---|
| 65 | 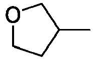 | - | 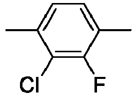 | OCH₂CH₂ | -PO(OH)₂ |
| 66 | 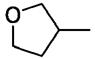 | - | 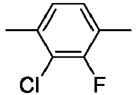 | O(CH₂)₃CH₂ | -PO(OH)₂ |
| 67 | 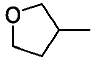 | - | 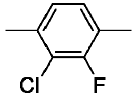 | O(CH₂)₄CH₂ | -PO(OH)₂ |
| 68 | 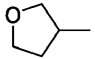 | - | 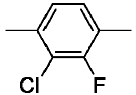 | O(CH₂)₅CH₂ | -PO(OH)₂ |
| 69 | 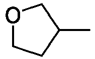 | - | 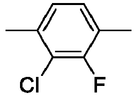 | O(CH₂)₆CH₂ | -PO(OH)₂ |
| 70 | 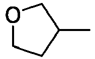 | - | 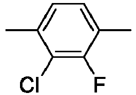 | O(CH₂)₈CH₂ | -PO(OH)₂ |
| 71 | 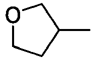 | - | 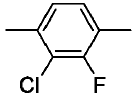 | O(CH₂)₁₀CH₂ | -PO(OH)₂ |
| 72 | 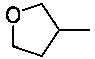 | - | 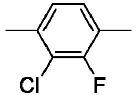 | 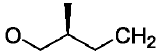 | -PO(OH)₂ |
| 73 | 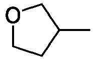 | CH₂CH₂ | 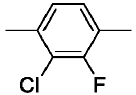 | O(CH₂)₁₀CH₂ | -PO(OH)₂ |

| No. | T | Z^{T} | B | Sp | G |
|---|---|---|---|---|---|
| 74 | 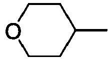 | - | 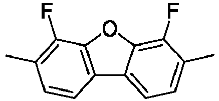 | OCH₂CH₂ | -PO(OH)₂ |
| 75 | 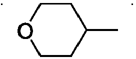 | - | 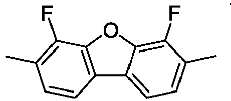 | O(CH₂)₃CH₂ | -PO(OH)₂ |
| 76 | 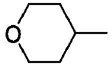 | - | 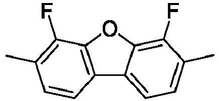 | O(CH₂)₄CH₂ | -PO(OH)₂ |
| 77 | 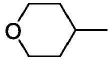 | - | 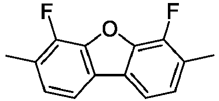 | O(CH₂)₅CH₂ | -PO(OH)₂ |
| 78 | 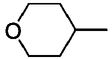 | - | 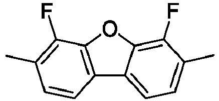 | O(CH₂)₆CH₂ | -PO(OH)₂ |
| 79 | 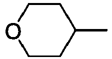 | - | 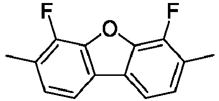 | O(CH₂)₈CH₂ | -PO(OH)₂ |
| 80 | 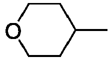 | - | 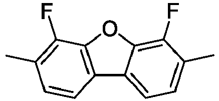 | O(CH₂)₁₀CH₂ | -PO(OH)₂ |
| 81 | 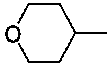 | - | 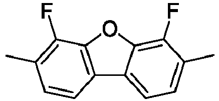 | | -PO(OH)₂ |
| 82 | 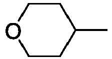 | CH₂CH₂ | 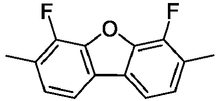 | O(CH₂)₁₀CH₂ | -PO(OH)₂ |

| No | T | Z^{T} | B | Sp | G |
|---|---|---|---|---|---|
| 83 | 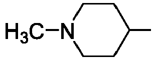 | - | 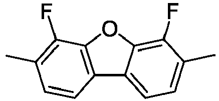 | OCH₂CH₂ | - PO(OH) ₂ |
| 84 | 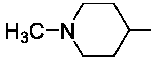 | - | 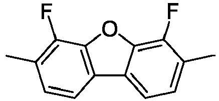 | O(CH₂)₃CH₂ | - PO(OH) ₂ |
| 85 | 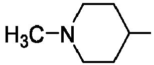 | - | 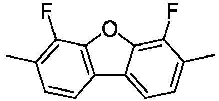 | O(CH₂)₄CH₂ | - PO(OH) ₂ |
| 86 | 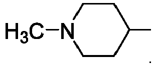 | - | 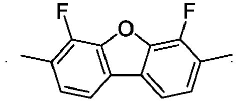 | O(CH₂)₅CH₂ | - PO(OH) ₂ |
| 87 | 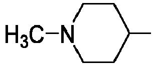 | - | 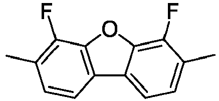 | O(CH₂)₆CH₂ | - PO(OH) ₂ |
| 88 | 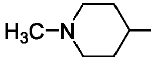 | - | 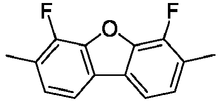 | O(CH₂)₈CH₂ | - PO(OH) ₂ |
| 89 | 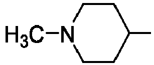 | - | 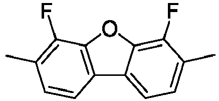 | O(CH₂)₁₀CH₂ | - PO(OH) ₂ |
| 90 | 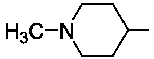 | - | 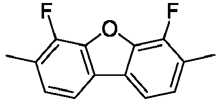 | 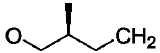 | - PO(OH) ₂ |
| 91 | 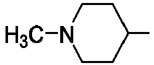 | CH₂CH₂ | 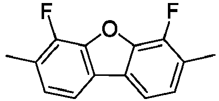 | O(CH₂)₁₀CH₂ | - PO(OH) ₂ |

| No. | T | Z^{T} | B | Sp | G |
|---|---|---|---|---|---|
| 92 | 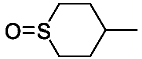 | - | 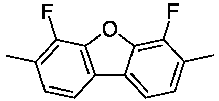 | OCH₂CH₂ | -PO(OH)₂ |
| 93 | 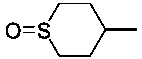 | - | 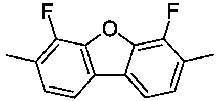 | O(CH₂)₃CH₂ | -PO(OH)₂ |
| 94 | 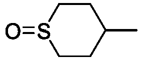 | - | 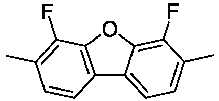 | O(CH₂)₄CH₂ | -PO(OH)₂ |
| 95 | 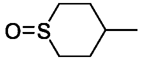 | - | 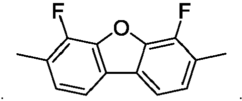 | O(CH₂)₅CH₂ | -PO(OH)₂ |
| 96 | 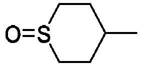 | - | 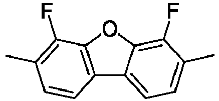 | O(CH₂)₆CH₂ | -PO(OH)₂ |
| 97 | 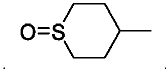 | - | 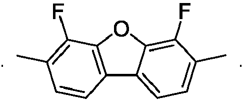 | O(CH₂)₈CH₂ | -PO(OH)₂ |
| 98 | 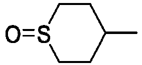 | - | 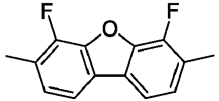 | O(CH₂)₁₀CH₂ | -PO(OH)₂ |
| 99 | 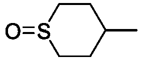 | - | 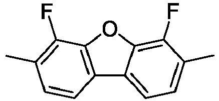 | 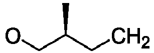 | -PO(OH)₂ |
| 100 | 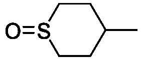 | CH₂CH₂ | 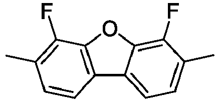 | O(CH₂)₁₀CH₂ | -PO(OH)₂ |
| 101 | 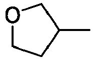 | - | 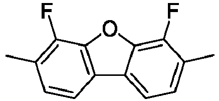 | OCH₂CH₂ | -PO(OH)₂ |
| 102 | 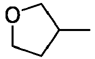 | - | 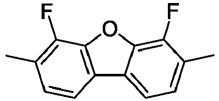 | O(CH₂)₃CH₂ | -PO(OH)₂ |
| 103 | 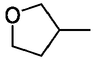 | - | 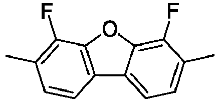 | O(CH₂)₄CH₂ | -PO(OH)₂ |
| 104 | 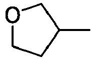 | - | 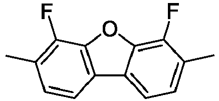 | O(CH₂)₅CH₂ | -PO(OH)₂ |
| 105 | 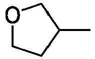 | - | 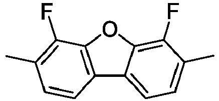 | O(CH₂)₆CH₂ | -PO(OH)₂ |
| 106 | 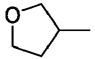 | - | 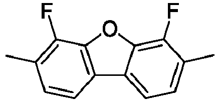 | O(CH₂)₈CH₂ | -PO(OH)₂ |
| 107 | 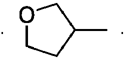 | - | 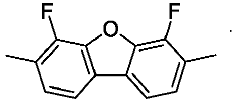 | O(CH₂)₁₀CH₂ | -PO(OH)₂ |
| 108 | 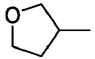 | - | 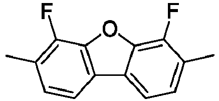 | 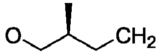 | -PO(OH)₂ |
| 109 | 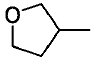 | CH₂CH₂ | 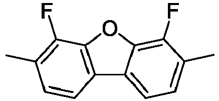 | O(CH₂)₁₀CH₂ | -PO(OH)₂ |

### Compounds of formula IA-1b

| No. | T | Z^{T} | A¹Z¹ | B | Sp | G |
|---|---|---|---|---|---|---|
| 110 | 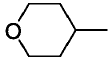 | - | 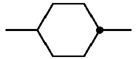 | 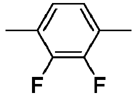 | OCH₂CH₂ | -PO(OH)₂ |
| 111 | 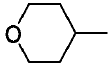 | - | 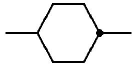 | 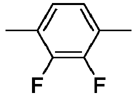 | O(CH₂)₃CH₂ | -PO(OH)₂ |
| 112 | 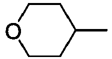 | - | 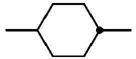 | 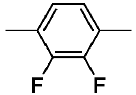 | O(CH₂)₄CH₂ | -PO(OH)₂ |
| 113 | 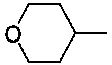 | - | 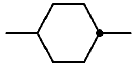 | 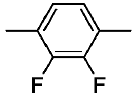 | O(CH₂)₅CH₂ | -PO(OH)₂ |
| 114 | 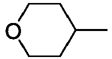 | - | 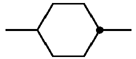 | 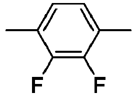 | O(CH₂)₆CH₂ | -PO(OH)₂ |
| 115 | 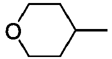 | - | 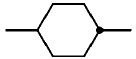 | 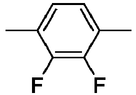 | O(CH₂)₈CH₂ | -PO(OH)₂ |
| 116 | 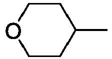 | - | 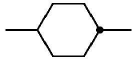 | 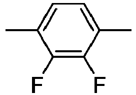 | O(CH₂)₁₀CH₂ | -PO(OH)₂ |
| 117 | 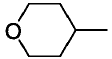 | - | 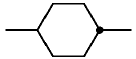 | 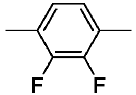 | 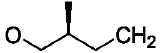 | -PO(OH)₂ |
| 118 | 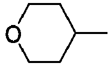 | - | 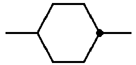 | 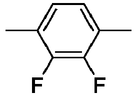 | O(CH₂)₁₀CH₂ | -PO(OH)₂ |

| No. | T | Z^{T} | A¹Z¹ | B | Sp | G |
|---|---|---|---|---|---|---|
| 119 | 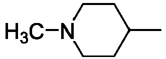 | - | 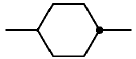 | 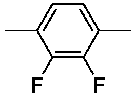 | OCH₂CH₂ | - PO(OH)₂ |
| 120 | 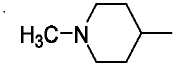 | - | 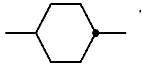 | 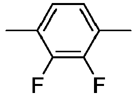 | O(CH₂)₃CH₂ | - PO(OH)₂ |
| 121 | 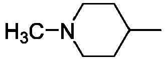 | - | 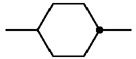 | 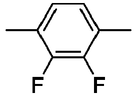 | O(CH₂)₄CH₂ | - PO(OH)₂ |
| 122 | 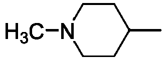 | - | 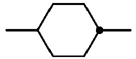 | 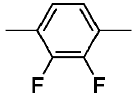 | O(CH₂)₅CH₂ | - PO(OH)₂ |
| 123 | 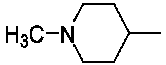 | - | 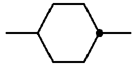 | 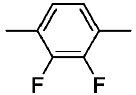 | O(CH₂)₆CH₂ | - PO(OH)₂ |
| 124 | 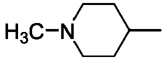 | - | 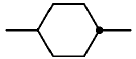 | 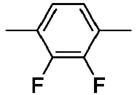 | O(CH₂)₈CH₂ | - PO(OH)₂ |
| 125 | 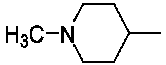 | - | 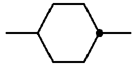 | 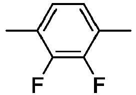 | O(CH₂)₁₀CH₂ | - PO(OH)₂ |
| 126 | 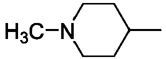 | - | 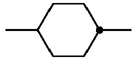 | 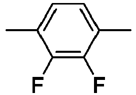 | 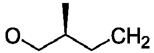 | - PO(OH)₂ |

| No. | T | Z^{T} | A¹Z¹ | B | Sp | G |
|---|---|---|---|---|---|---|
| 127 | 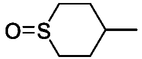 | - | 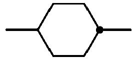 | 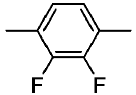 | OCH₂CH₂ | -PO(OH)₂ |
| 128 | 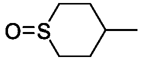 | - | 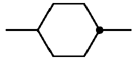 | 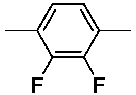 | O(CH₂)₃CH₂ | -PO(OH)₂ |
| 129 | 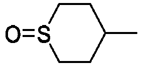 | - | 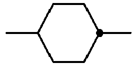 | 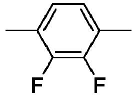 | O(CH₂)₄CH₂ | -PO(OH)₂ |
| 130 | 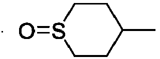 | - | 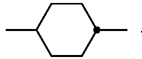 | 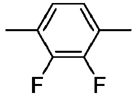 | O(CH₂)₅CH₂ | -PO(OH)₂ |
| 131 | 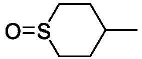 | - | 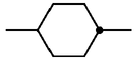 | 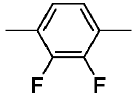 | O(CH₂)₆CH₂ | -PO(OH)₂ |
| 132 | 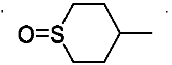 | - | 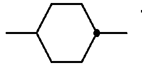 | 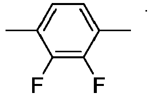 | O(CH₂)₈CH₂ | -PO(OH)₂ |
| 133 | 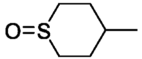 | - | 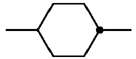 | 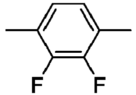 | O(CH₂)₁₀CH₂ | -PO(OH)₂ |
| 134 | 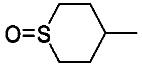 | - | 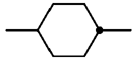 | 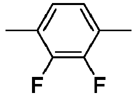 | 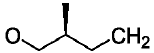 | -PO(OH)₂ |

| No. | T | Z^{T} | A¹Z¹ | B | Sp | G |
|---|---|---|---|---|---|---|
| 135 | 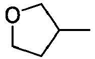 | - | 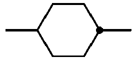 | 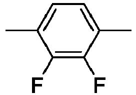 | OCH₂CH₂ | -PO(OH)₂ |
| 136 | 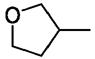 | - | 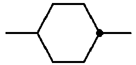 | 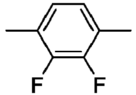 | O(CH₂)₃CH₂ | -PO(OH)₂ |
| 137 | 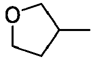 | - | 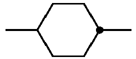 | 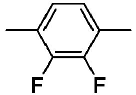 | O(CH₂)₄CH₂ | -PO(OH)₂ |
| 138 | 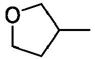 | - | 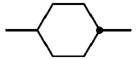 | 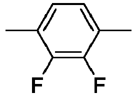 | O(CH₂)₅CH₂ | -PO(OH)₂ |
| 139 | 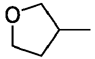 | - | 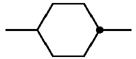 | 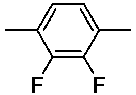 | O(CH₂)₆CH₂ | -PO(OH)₂ |
| 140 | 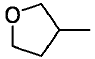 | - | 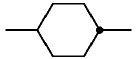 | 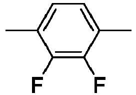 | O(CH₂)₈CH₂ | -PO(OH)₂ |
| 141 | 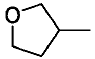 | - | 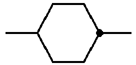 | 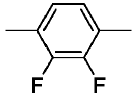 | O(CH₂)₁₀CH₂ | -PO(OH)₂ |
| 142 | 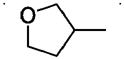 | - | 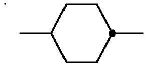 | 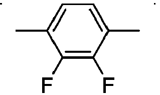 | 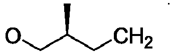 | -PO(OH)₂ |

| No. | T | Z^{T} | A¹Z¹ | B | Sp | G |
|---|---|---|---|---|---|---|
| 143 | 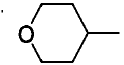 | - | 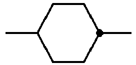 | 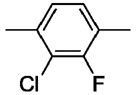 | OCH₂CH₂ | -PO(OH)₂ |
| 144 | 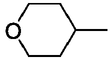 | - | 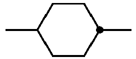 | 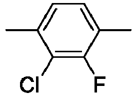 | O(CH₂)₃CH₂ | -PO(OH)₂ |
| 145 | 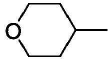 | - | 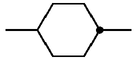 | 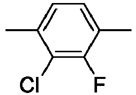 | O(CH₂)₄CH₂ | -PO(OH)₂ |
| 146 | 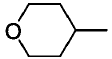 | - | 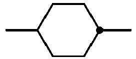 | 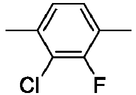 | O(CH₂)₅CH₂ | -PO(OH)₂ |
| 147 | 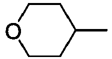 | - | 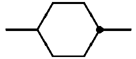 | 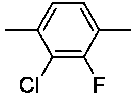 | O(CH₂)₆CH₂ | -PO(OH)₂ |
| 148 | 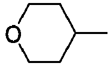 | - | 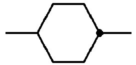 | 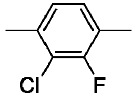 | O(CH₂)₈CH₂ | -PO(OH)₂ |
| 149 | 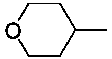 | - | 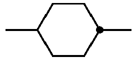 | 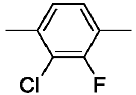 | O(CH₂)₁₀CH₂ | -PO(OH)₂ |
| 150 | 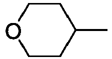 | - | 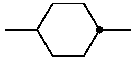 | 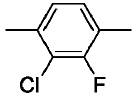 | 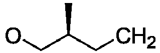 | -PO(OH)₂ |

| No. | T | Z^{T} | A¹Z¹ | B | Sp | G |
|---|---|---|---|---|---|---|
| 151 | 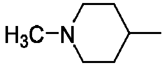 | - | 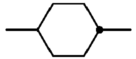 | 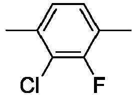 | OCH₂CH₂ | - PO(OH)₂ |
| 152 | 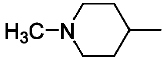 | - | 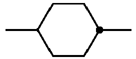 | 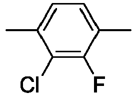 | O(CH₂)₃CH₂ | - PO(OH)₂ |
| 153 | 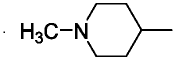 | - | 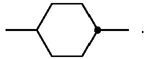 | 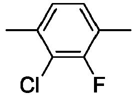 | O(CH₂)₄CH₂ | - PO(OH)₂ |
| 154 | 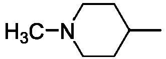 | - | 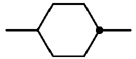 | 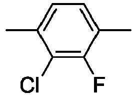 | O(CH₂)₅CH₂ | - PO(OH)₂ |
| 155 | 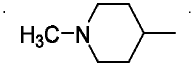 | - | 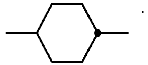 | 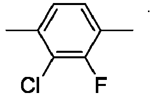 | O(CH₂)₆CH₂ | - PO(OH)₂ |
| 156 | 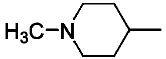 | - | 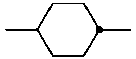 | 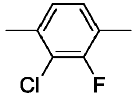 | O(CH₂)₈CH₂ | - PO(OH)₂ |
| 157 | 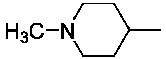 | - | 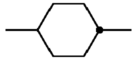 | 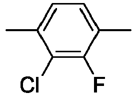 | O(CH₂)₁₀CH₂ | - PO(OH)₂ |
| 158 | 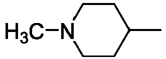 | - | 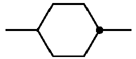 | 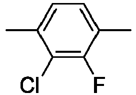 | 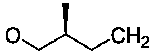 | - PO(OH)₂ |
| 15 9 | 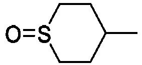 | - | 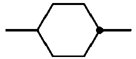 | 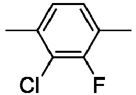 | OCH₂CH₂ | - PO(OH) ₂ |
| 16 0 | 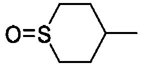 | - | 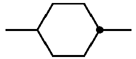 | 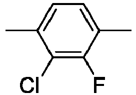 | O(CH₂)₃CH₂ | - PO(OH) ₂ |
| 16 1 | 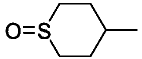 | - | 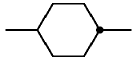 | 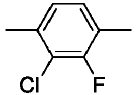 | O(CH₂)₄CH₂ | - PO(OH) ₂ |
| 16 2 | 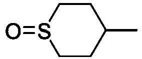 | - | 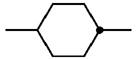 | 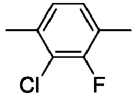 | O(CH₂)₅CH₂ | - PO(OH) ₂ |
| 16 3 | 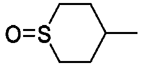 | - | 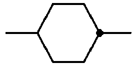 | 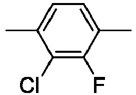 | O(CH₂)₆CH₂ | - PO(OH) ₂ |
| 16 4 | 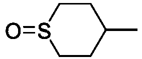 | - | 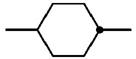 | 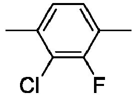 | O(CH₂)₈CH₂ | - PO(OH) ₂ |
| 16 5 | 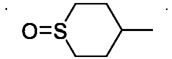 | - | 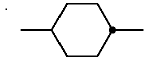 | 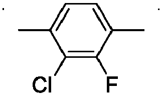 | O(CH₂)₁₀CH₂ | - PO(OH) ₂ |
| 16 6 | 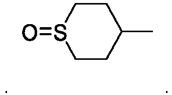 | - | 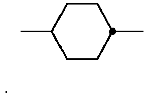 | 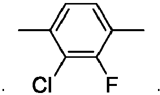 | 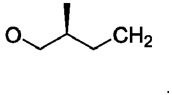 | - PO(OH) ₂ |
| 16 7 | 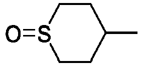 | CH₂CH ₂ | 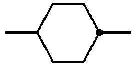 | 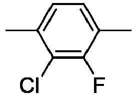 | O(CH₂)₁₀CH₂ | - PO(OH) ₂ |

| No. | T | Z^{T} | A¹Z¹ | B | Sp | G |
|---|---|---|---|---|---|---|
| 168 | 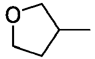 | - | 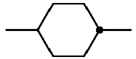 | 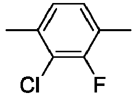 | OCH₂CH₂ | -PO(OH)₂ |
| 169 | 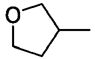 | - | 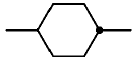 | 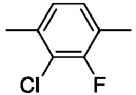 | O(CH₂)₃CH₂ | -PO(OH)₂ |
| 170 | 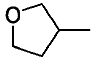 | - | 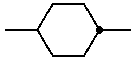 | 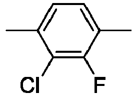 | O(CH₂)₄CH₂ | -PO(OH)₂ |
| 171 | 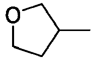 | - | 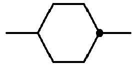 | 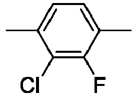 | O(CH₂)₅CH₂ | -PO(OH)₂ |
| 172 | 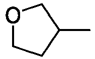 | - | 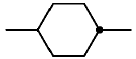 | 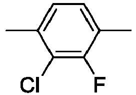 | O(CH₂)₆CH₂ | -PO(OH)₂ |
| 173 | 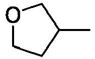 | - | 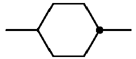 | 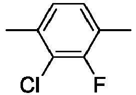 | O(CH₂)₈CH₂ | -PO(OH)₂ |
| 174 | 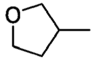 | - | 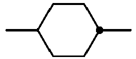 | 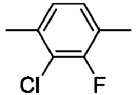 | O(CH₂)₁₀CH₂ | -PO(OH)₂ |
| 175 | 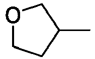 | - | 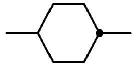 | 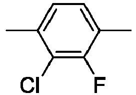 | 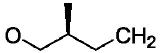 | -PO(OH)₂ |

| No1. | T | Z^{T} | A¹Z¹ | B | Sp | G |
|---|---|---|---|---|---|---|
| 176 | 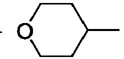 | - | 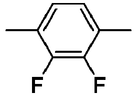 | 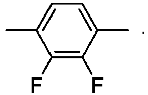 | OCH₂CH₂ | -PO(OH)₂ |
| 177 | 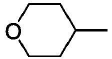 | - | 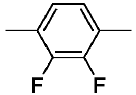 | 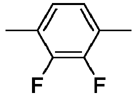 | O(CH₂)₃CH₂ | -PO(OH)₂ |
| 178 | 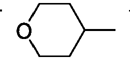 | - | 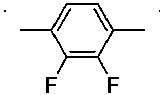 | 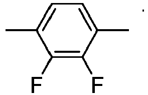 | O(CH₂)₄CH₂ | -PO(OH)₂ |
| 179 | 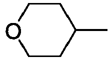 | - | 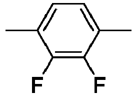 | 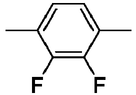 | O(CH₂)₅CH₂ | -PO(OH)₂ |
| 180 | 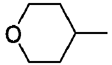 | - | 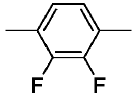 | 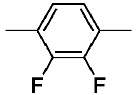 | O(CH₂)₆CH₂ | -PO(OH)₂ |
| 181 | 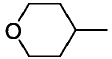 | - | 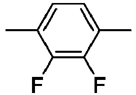 | 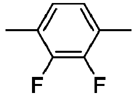 | O(CH₂)₈CH₂ | -PO(OH)₂ |
| 182 | 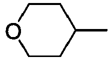 | - | 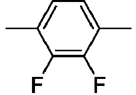 | 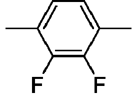 | O(CH₂)₁₀CH₂ | -PO(OH)₂ |
| 183 | 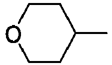 | - | 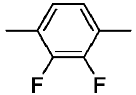 | 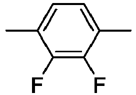 | 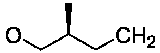 | -PO(OH)₂ |
| 184 | 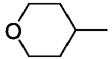 | - | 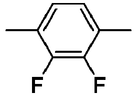 | 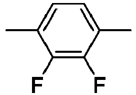 | O(CH₂)₁₀CH₂ | -PO(OH)₂ |

| No. | T | Z^{T} | A¹Z¹ | B | Sp | G |
|---|---|---|---|---|---|---|
| 185 | 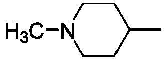 | - | 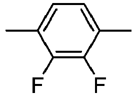 | 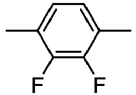 | OCH₂CH₂ | -PO(OH)₂ |
| 186 | 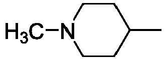 | - | 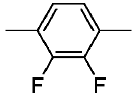 | 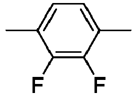 | O(CH₂)₃CH₂ | -PO(OH)₂ |
| 187 | 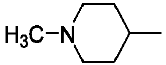 | - | 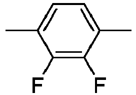 | 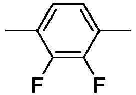 | O(CH₂)₄CH₂ | -PO(OH)₂ |
| 188 | 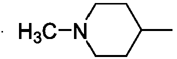 | - | 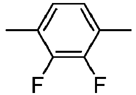 | 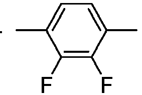 | O(CH₂)₅CH₂ | -PO(OH)₂ |
| 189 | 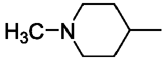 | - | 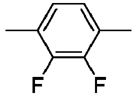 | 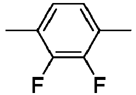 | O(CH₂)₆CH₂ | -PO(OH)₂ |
| 190 | 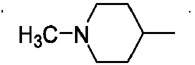 | - | 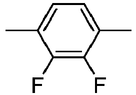 | 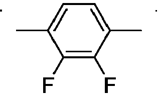 | O(CH₂)₈CH₂ | -PO(OH)₂ |
| 191 | 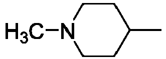 | - | 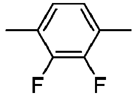 | 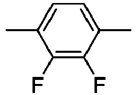 | O(CH₂)₁₀CH₂ | -PO(OH)₂ |
| 192 | 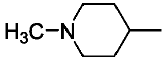 | - | 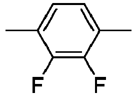 | 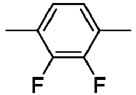 | 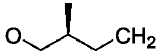 | -PO(OH)₂ |

| No. | T | Z^{T} | A¹Z¹ | B | Sp | G |
|---|---|---|---|---|---|---|
| 193 | 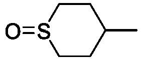 | - | 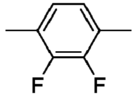 | 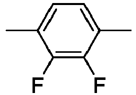 | OCH₂CH₂ | -PO(OH)₂ |
| 194 | 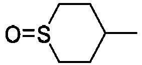 | - | 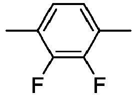 | 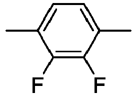 | O(CH₂)₃CH₂ | -PO(OH)₂ |
| 195 | 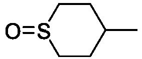 | - | 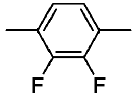 | 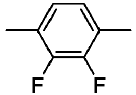 | O(CH₂)₄CH₂ | -PO(OH)₂ |
| 196 | 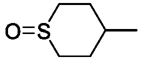 | - | 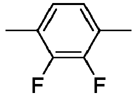 | 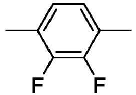 | O(CH₂)₅CH₂ | -PO(OH)₂ |
| 197 | 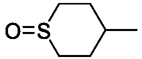 | - | 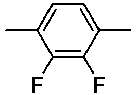 | 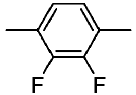 | O(CH₂)₆CH₂ | -PO(OH)₂ |
| 198 | 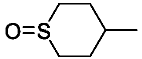 | - | 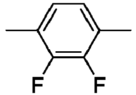 | 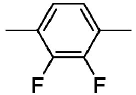 | O(CH₂)₈CH₂ | -PO(OH)₂ |
| 199 | 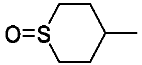 | - | 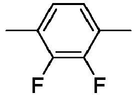 | 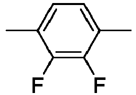 | O(CH₂)₁₀CH₂ | -PO(OH)₂ |
| 200 | 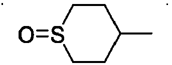 | - | 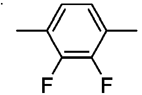 | 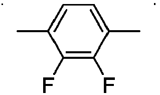 | 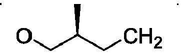 | -PO(OH)₂ |

| No. | T | Z^{T} | A¹Z¹ | B | Sp | G |
|---|---|---|---|---|---|---|
| 2010 | 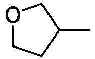 | - | 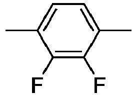 | 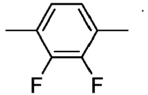 | OCH₂CH₂ | -PO(OH)₂ |
| 202 | 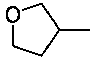 | - | 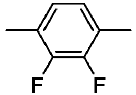 | 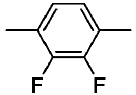 | O(CH₂)₃CH₂ | -PO(OH)₂ |
| 203 | 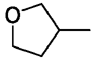 | - | 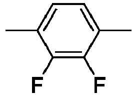 | 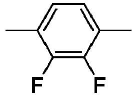 | O(CH₂)₄CH₂ | -PO(OH)₂ |
| 204 | 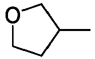 | - | 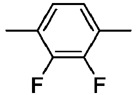 | 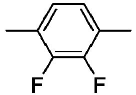 | O(CH₂)₅CH₂ | -PO(OH)₂ |
| 205 | 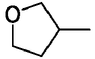 | - | 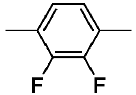 | 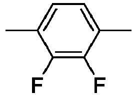 | O(CH₂)₆CH₂ | -PO(OH)₂ |
| 206 | 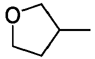 | - | 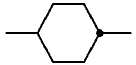 | 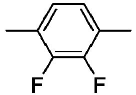 | O(CH₂)₈CH₂ | -PO(OH)₂ |
| 207 | 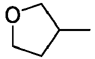 | - | 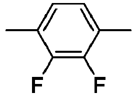 | 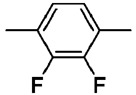 | O(CH₂)₁₀CH₂ | -PO(OH)₂ |
| 208 | 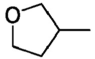 | - | 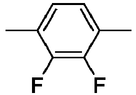 | 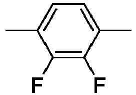 | 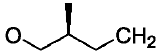 | -PO(OH)₂ |

| No. | T | Z^{T} | A¹Z¹ | B | Sp | G |
|---|---|---|---|---|---|---|
| 209 | 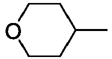 | - | 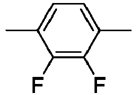 | 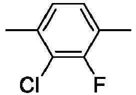 | OCH₂CH₂ | -PO(OH)₂ |
| 210 | 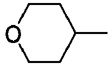 | - | 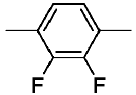 | 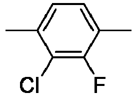 | O(CH₂)₃CH₂ | -PO(OH)₂ |
| 211 | 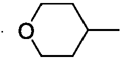 | - | 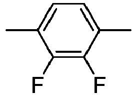 | 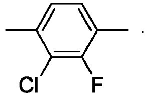 | O(CH₂)₄CH₂ | -PO(OH)₂ |
| 212 | 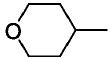 | - | 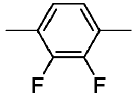 | 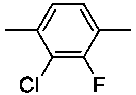 | O(CH₂)₅CH₂ | -PO(OH)₂ |
| 213 | 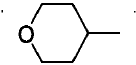 | - | 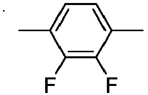 | 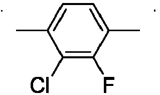 | O(CH₂)₆CH₂ | -PO(OH)₂ |
| 214 | 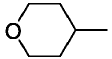 | - | 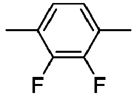 | 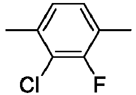 | O(CH₂)₈CH₂ | -PO(OH)₂ |
| 215 | 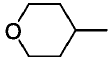 | - | 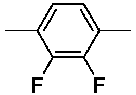 | 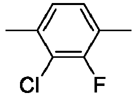 | O(CH₂)₁₀CH₂ | -PO(OH)₂ |
| 216 | 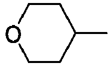 | - | 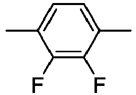 | 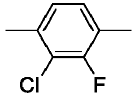 | 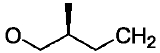 | -PO(OH)₂ |
| 217 | 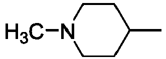 | - | 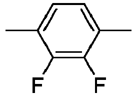 | 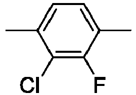 | OCH₂CH₂ | -PO(OH)₂ |
| 218 | 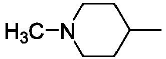 | - | 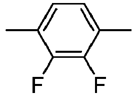 | 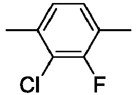 | O(CH₂)₃CH₂ | -PO(OH)₂ |
| 219 | 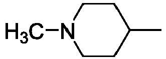 | - | 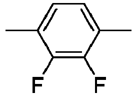 | 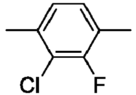 | O(CH₂)₄CH₂ | -PO(OH)₂ |
| 220 | 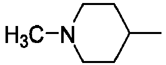 | - | 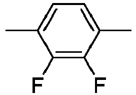 | 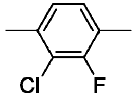 | O(CH₂)₅CH₂ | -PO(OH)₂ |
| 221 | 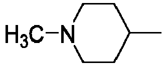 | - | 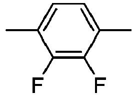 | 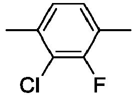 | O(CH₂)₆CH₂ | -PO(OH)₂ |
| 222 | 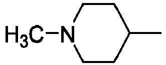 | - | 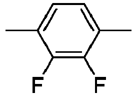 | 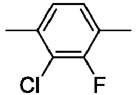 | O(CH₂)₈CH₂ | -PO(OH)₂ |
| 223 | 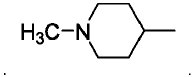 | - | 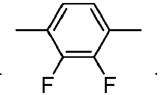 | 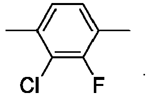 | O(CH₂)₁₀CH₂ | -PO(OH)₂ |
| 224 | 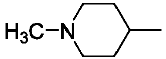 | - | 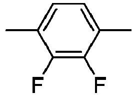 | 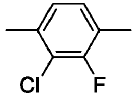 | 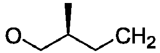 | -PO(OH)₂ |

| No. | T | Z^{T} | A¹Z¹ | B | Sp | G |
|---|---|---|---|---|---|---|
| 22 5 | 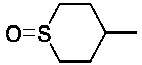 | - | 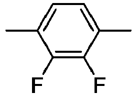 | 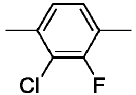 | OCH₂CH₂ | - PO(OH) ₂ |
| 22 6 | 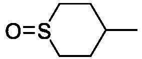 | - | 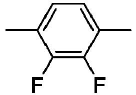 | 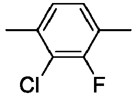 | O(CH₂)₃CH₂ | - PO(OH) ₂ |
| 22 7 | 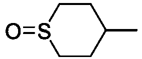 | - | 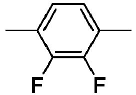 | 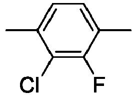 | O(CH₂)₄CH₂ | - PO(OH) ₂ |
| 22 8 | 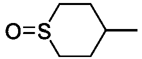 | - | 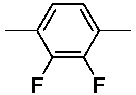 | 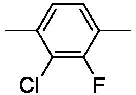 | O(CH₂)₅CH₂ | - PO(OH) ₂ |
| 22 9 | 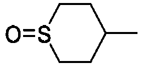 | - | 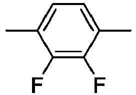 | 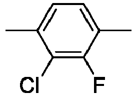 | O(CH₂)₆CH₂ | - PO(OH) ₂ |
| 23 0 | 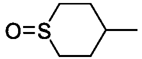 | - | 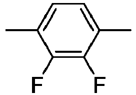 | 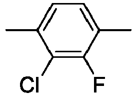 | O(CH₂)₈CH₂ | - PO(OH) ₂ |
| 23 1 | 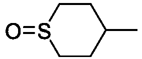 | - | 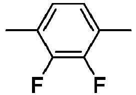 | 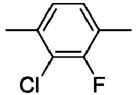 | O(CH₂)₁₀CH₂ | - PO(OH) ₂ |
| 23 2 | 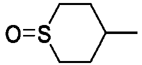 | - | 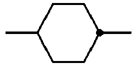 | 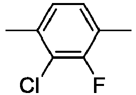 | 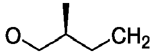 | - PO(OH) ₂ |
| 23 3 | 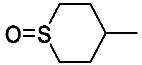 | CH₂CH ₂ | 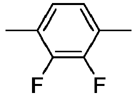 | 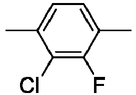 | O(CH₂)₁₀CH₂ | - PO(OH) ₂ |

| No. | T | Z^{T} | A¹Z¹ | B | Sp | G |
|---|---|---|---|---|---|---|
| 234 | 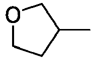 | - | 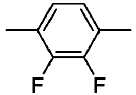 | 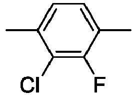 | OCH₂CH₂ | -PO(OH)₂ |
| 235 | 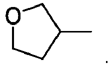 | - | 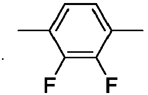 | 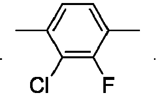 | O(CH₂)₃CH₂ | -PO(OH)₂ |
| 236 | 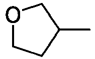 | - | 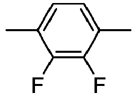 | 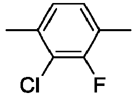 | O(CH₂)₄CH₂ | -PO(OH)₂ |
| 237 | 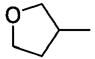 | - | 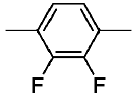 | 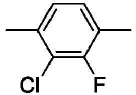 | O(CH₂)₅CH₂ | -PO(OH)₂ |
| 238 | 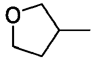 | - | 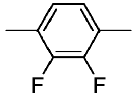 | 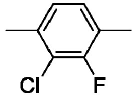 | O(CH₂)₆CH₂ | -PO(OH)₂ |
| 239 | 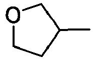 | - | 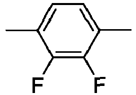 | 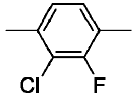 | O(CH₂)₈CH₂ | -PO(OH)₂ |
| 240 | 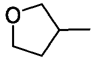 | - | 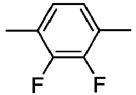 | 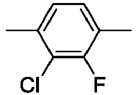 | O(CH₂)₁₀CH₂ | -PO(OH)₂ |
| 241 | 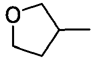 | - | 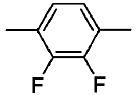 | 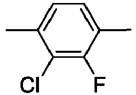 | 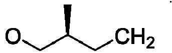 | -PO(OH)₂ |

### Compounds of formula IA-2-1 to IA-2-7

| No. | T | Z^{T} | L1 | L2 | Y³ | Y⁴ | G |
|---|---|---|---|---|---|---|---|
| 242 | 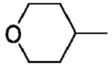 | - | F | F | CH₃ | CH₃ | -PO(OH)₂ |
| 243 | 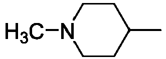 | - | F | F | CH₃ | CH₃ | -PO(OH)₂ |
| 244 | 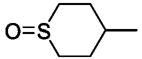 | - | F | F | CH₃ | CH₃ | -PO(OH)₂ |
| 245 | 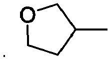 | - | F | F | CH₃ | CH₃ | -PO(OH)₂ |
| 246 | 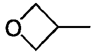 | - | F | F | CH₃ | CH₃ | -PO(OH)₂ |
| 247 | 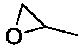 | CH₂ | F | F | CH₃ | CH₃ | -PO(OH)₂ |
| 248 | 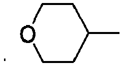 | -CH₂CH₂ | F | F | CH₃ | CH₃ | -PO(OH)₂ |
| 249 | 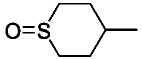 | CH₂CH₂ | F | F | CH₃ | CH₃ | -PO(OH)₂ |
| 250 | 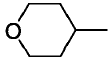 | - | Cl | F | CH₃ | CH₃ | -PO(OH)₂ |
| 251 | 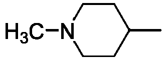 | - | Cl | F | CH₃ | CH₃ | -PO(OH)₂ |
| 252 | 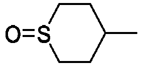 | - | Cl | F | CH₃ | CH₃ | -PO(OH)₂ |
| 253 | 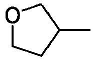 | - | Cl | F | CH₃ | CH₃ | -PO(OH)₂ |
| 254 | 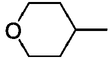 | -CH₂CH₂ | Cl | F | CH₃ | CH₃ | -PO(OH)₂ |
| 255 | 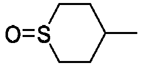 | CH₂CH₂ | Cl | F | CH₃ | CH₃ | -PO(OH)₂ |

Compounds with alternative anchoring groups are obtained analogusly by procedures known from prior art, as for example the following:

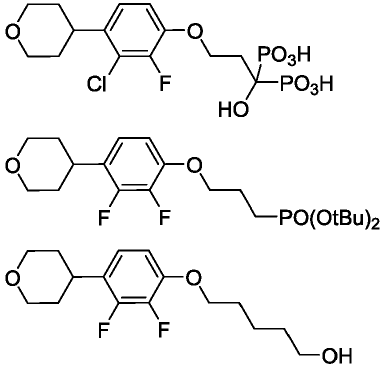

### List of reference numerals

- 10: electronic element
- 12: base substrate
- 14: first electrode layer
- 16: electrode material
- 18: dielectric material
- 20: molecular layer
- 22: further electrode layer

- 30: electrode line
- 31: rotated electrode line
- 32: non-electrode area
- 34: electrode area

- 100: cell
- 102: first electrode
- 104: part (of molecular layer)
- 106: second electrode
- 108: selector device

## Claims

1. Electronic element (10) comprising a plurality of cells (100) arranged in a three dimensional array of cells (100), wherein the cells (100) are located at crossings between two crossed electrode lines (30, 31), wherein each cell (100) comprises in this order a first electrode (102), a part (104) of a molecular layer (20) and a second electrode (106), wherein the molecular layer (20) is a self-assembled monolayer of organic molecules having an anchoring group connected to a dipolar unit by means of a conformationally flexible unit,
wherein the organic molecules for the formation of the self-assembled monolayer are selected from one or more compounds of the formula I
T-Z^{T}-(A¹-Z¹)ᵣ-B-(Z²A²)ₛ-(Z³A³)ₜ-(Z⁴A⁴)ᵤ-Sp-G (I)
in which
T is a three- to ten-membered saturated or partially unsaturated aliphatic ring, in which at least one -CH₂- group is replaced with -O-, -S-, -S(O)-, -SO₂-, -NR^{x}- or -N(O)R^{x}-, or in which at least one -CH= group is replaced with -N=,
Z^{T}, Z¹, Z² and Z⁴, on each occurrence, identically or differently, denote a single bond, -CF₂O-, -OCF₂-, -CF₂S-, -SCF₂-, -CH₂O-, -OCH₂-, -C(O)O-, -OC(O)-, -C(O)S , -SC(O)-, -(CH₂)ₙ₁-, -(CF₂)ₙ₂-, -CF₂ CH₂-, -CH₂CF₂-, -CH=CH-,-CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- or-N=C-C=N-, wherein n1, n2, n3, n4, identically or differently, are 1, 2, 3, 4, 5, 6, 7, 8, 9 or 10,
Z³ denotes -O-, -S-, -CH₂-, -C(O)-, -CF₂-, -CHF-, -C(R^{x})₂-, -S(O)- or -SO₂-,
A¹, A² and A⁴, on each occurrence, identically or differently, denote an aromatic, heteroaromatic, alicyclic or heteroaliphatic ring having 4 to 25 ring atoms, which may also contain condensed rings and which may be mono- or polysubstituted by Y,
A³ denotes an aromatic or heteroaromatic ring having 5 to 25 ring atoms, which may also contain condensed rings and which may be mono- or polysubstituted by Y^{C},
Y on each occurrence, identically or differently, denotes F, Cl, CN, SCN, SF₅ or straight-chain or branched, in each case optionally fluorinated alkyl, alkoxy, alkylcarbonyl, alkoxycarbonyl, alkylcarbonyloxy or alkoxycarbonyloxy having 1 to 12 C atoms, preferably F or Cl,
Y^{C} has one of the meanings of Y or denotes cycloalkyl or alkylcycloalkyl each having 3 to 12 C atoms, preferably methyl, ethyl, isopropyl, cyclopropyl, cyclobutyl, cyclopentyl, cyclohexyl, trifluoromethyl, methoxy or trifluoromethoxy,
B denotes 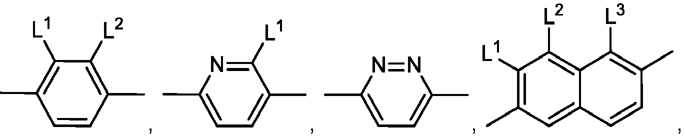 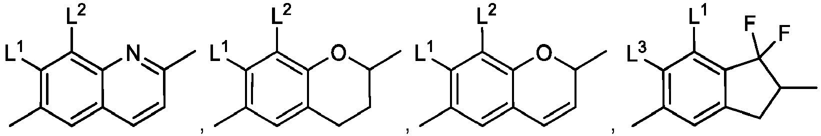 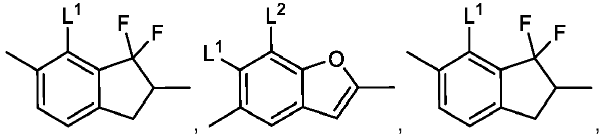 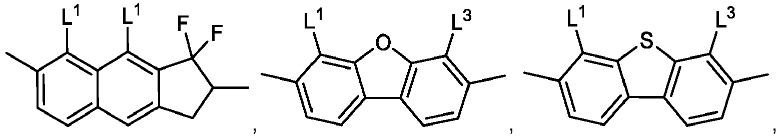 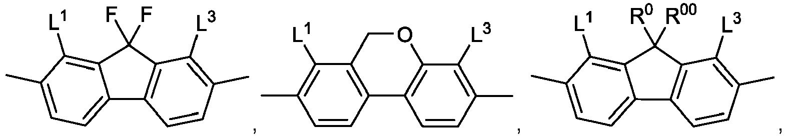 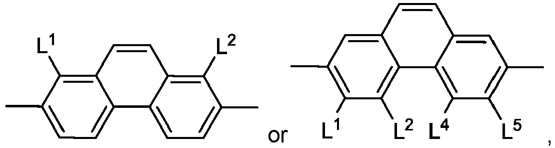 where the groups may be oriented in both directions,
L¹ to L⁵, independently of one another, denote F, Cl, Br, I, CN, SF₅, CF₃ or OCF₃, preferably Cl or F, where L³ may alternatively also denote H,
Sp denotes a spacer group or a single bond,
G denotes -OH, -SH, -SO₂OH, -OP(O)(OH)₂, -PO(OH)₂, -C(OH)(PO(OH)₂)₂, -COOH, -Si(OR^{x})₃, -SiCl₃, -CH=CH₂, -POCl₂, -CO(NHOH), -CO(NR⁰OH), -Si(NMe₂)₃; -O-C(O)-OR^{V}, -O-C(O)-Si(OR^{V})₃, -PO(OR^{V})₂ or -SO₂OR^{V} or straight chain or branched alkyl having 1 to 12 C atoms in which one, two or three not geminal H atoms are substituted by OH;
R⁰, R⁰⁰, R" identically or differently, denote straight-chain or branched alkyl having 1 to 6 C atoms,
R^{V} denotes straight chain or branched alkyl having 1 to 12 C atoms, and
r, s, t and u, identically or differently, are 0, 1 or 2.

2. Electronic element (10) according to claim 1, **characterized in that** each cell (100) further comprises a diode, a threshold switch or a transistor as selector device (108).

3. Electronic element (10) according to claim 2, wherein the selector device (108) is configured as a further self-assembled monolayer of organic molecules or as an inorganic diode arranged between the molecular layer and the first electrode or the second electrode.

4. Electronic element (10) according to any one of claims 1 to 3, **characterized in that** the first electrode (102) and/or second electrode (106) of each cell (100) are made from a metal, a conductive alloy, a conductive ceramic, a semiconductor, a conductive oxidic material, conductive or semiconductive organic molecules or a layered conductive 2D material.

5. Electronic element (10) according to claim 1, wherein the organic molecules for the formation of the self-assembled monolayer are selected from the group consisting of the formulae IA-1a to IA-1f
T-Z^{T}-B-Sp-G IA-1a
T-Z^{T}-(A¹-Z¹)-B-Sp-G IA-1b
T-Z^{T}-(A¹-Z¹)₂-B-Sp-G IA-1c
T-Z^{T}-B-(Z²-A²)-Sp-G IA-1d
T-Z^{T}-B-(Z²-A²)₂-Sp-G IA-1e
T-Z^{T}-(A¹-Z¹)-B-(Z²-A²)- Sp-G IA-1f
in which T, Z^{T}, A¹, A², B, Z¹, Z², Sp and G have the meanings given in claim 1.

6. The electronic element (10) according to claim 1 or 5, wherein
T denotes 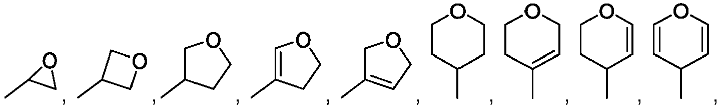 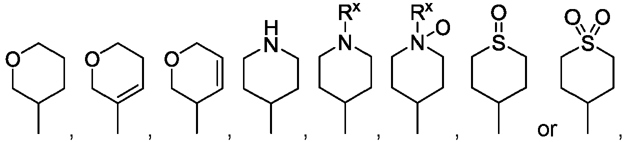
in which R^{x} denotes alkyl having 1 to 6 C atoms,
A¹ and A², identically or differently, denote 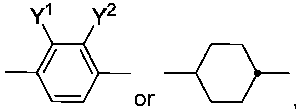
B denotes 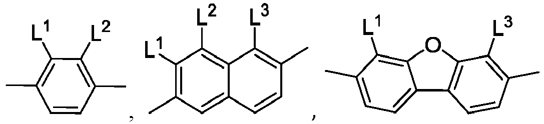 or 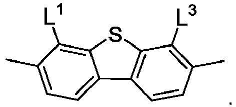
L¹ and L², independently of one another, denote CF₃, Cl or F,
L³ denotes H or F,
Y¹ and Y², independently of one another, denote H, Cl or F,
Z¹, Z²,Z^{T} independently of one another, denote a single bond, -CF₂O-, -OCF₂-, -CH₂O-, -OCH₂- or -CH₂CH₂-,
Sp denotes branched or unbranched 1,ω-alkylene having 1 to 12 C atoms, and
G denotes -OP(O)(OH)₂, -PO(OH)₂, or -COH(PO(OH)₂)₂.

7. The electronic element (10) according to claim 1, wherein the organic molecules for the formation of the self-assembled monolayer are selected from the compounds of the formula IA-2
T-Z^{T}-(A¹-Z¹)ᵣ-B-Z³-A³-(Z⁴-A⁴)ᵤ-G IA-2
in which the occurring groups and parameters have the meanings given in claim 1.

8. The electronic element (10) according to claim 7, wherein
T denotes 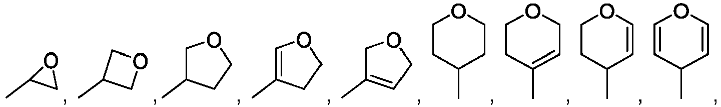 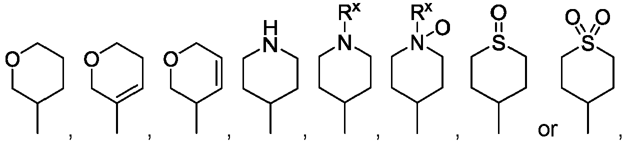 in which R^{x} denotes alkyl having 1 to 6 C atoms,
A¹ and A⁴, identically or differently, denote 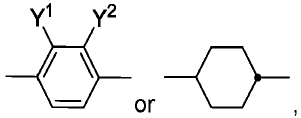
A³-Z³ denotes 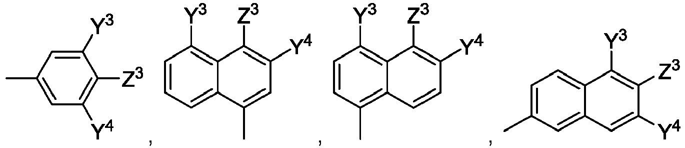 or 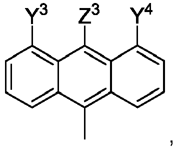
B denotes 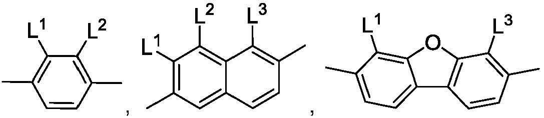 or 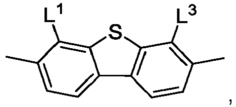
Z^{T} denote a single bond, -CH₂O-, -OCH₂- or -CH₂CH₂-,
L¹ and L² identically or differently, denote F, CF₃ or Cl,
Y¹ and Y² identically or differently, have one of the meanings given above for Y and preferably denote H, F or Cl,
Y³ and Y⁴, identically or differently, have one of the meanings given above for Y¹ and Y² and preferably denote methyl, ethyl, isopropyl, cyclopropyl, cyclobutyl, cyclopentyl, cyclopentenyl, cyclohexyl, cyclohexenyl, methoxy, trifluoromethyl, trifluoromethoxy, or trifluoromethylthio,
Z³ denotes CH₂ or O,
Z¹, Z², independently of one another, denote a single bond, -C(O)O-, -OC(O)-, -CF₂O-, -OCF₂-, -CH₂O-, OCH₂- or -CH₂CH₂-,
G denotes -PO(OH)₂, or -COH(PO(OH)₂)₂, and
r and u independently are 0, 1 or 2.

9. Method for producing of an electronic element (10) comprising a plurality of cells (100) according to any one of claims 1 to 8, **characterized in that** the method comprises:
A) providing a base substrate (12),
B) formation of a first electrode layer (14) comprising electrode lines (30, 31) separated by a dielectric material (18),
C) forming a molecular layer (20) comprising a monolayer of organic molecules having an anchoring group connected to a dipolar unit by means of a conformationally flexible unit, and
D) deposition of a further electrode layer (22) comprising electrode lines (30, 31) separated by a dielectric material (18),
wherein steps C) and D) are repeated until the desired number of layers of cells (100) is formed and wherein the electrode lines (30, 31) of two adjacent electrode layers (14, 22) are rotated with respect to each other so that the electrode lines (30, 31) of the two adjacent electrode layers (14, 22) cross each other,
wherein the coating with a molecular monolayer (20) comprises the steps of
- pretreating of the substrate to be coated for cleaning and activation,
- dipping the substrate into a solution comprising organic molecules for forming a self-assembled monolayer of said molecules,
- rinsing with an organic solvent and
- annealing of the formed molecular monolayer (20), wherein
the substrate to be coated is the first electrode layer (14), or a further electrode layer (22) and
wherein the organic molecules for forming the self-assembled monolayer are selected from one or more compounds of the formula I as defined in claim 1.

10. Method according to claim 9, **characterized in that** a selector device (108) in the form of a diode layer structure or a threshold switch structure is deposited after formation of the first electrode layer (14) according to step B) or a further electrode layer (22) according to step D) and before forming of the molecular monolayer (20) according to step C).

11. Method according to claim 9 or 10, **characterized in that** formation of the first electrode layer (14) and/or the further electrode layers (22) of electrode lines (30, 31) separated by a dielectric material (18) comprises the steps of
- deposition of an electrode material (16),
- removing of the electrode material (16) from non-electrode areas (32),
- deposition of a dielectric material (18),
- planarization of the obtained layer structure down to the level of the electrode material (16),
or, in case of formation of the first electrode layer (14) comprises the steps of
- deposition of a dielectric material (18),
- removing of the dielectric material (18) from electrode areas (34),
- deposition of an electrode material (16),
- planarization of the obtained layer structure down to the level of the dielectric material (18).

12. Method according to claim 11, **characterized in that** removal of electrode material (16) in the non-electrode (32) areas or removal of dielectric material (18) in the electrode areas (34) is performed by a photolithographic method defining areas to be removed and etching.

13. Method according to any one of claims 9 to 12, **characterized in that** the dielectric material (18) and/or the material of the base substrate (12) is selected from SiO₂, ZrO₂, diamond, Al₂O₃ or GaN.

14. Method according to claim 11 or 12, **characterized in that** deposition of dielectric material (18) and/or of the electrode material (16) is performed by means of physical vapor deposition, chemical vapor deposition, chemical solution deposition, atomic layer deposition, microcontact- or transfer-printing or sol-gel method.

15. Method according to claim 9, **characterized in that** pretreatment is performed by means of a UV-ozone treatment.

16. Method according to claim 9, **characterized in that** the solution is a mixture of a phosphonic acid of the molecules for forming a self-assembled monolayer and a solvent.

17. Method according to anyone of claims 9 to 16, **characterized in that** annealing is performed at a temperature in the range of from 50 °C to 250 °C for a time of from 1 minutes to 60 minutes.

18. Use of an electronic element (10) according to any one of claims 1 to 4 or an electronic element (10) obtained by means of a method according to any one of claims 9 to 15 as a memory device, wherein cells (100) of the electronic element (10) serve as memory cells, and/or as neural network device, wherein cells (100) of the electronic element (10) serve as synapses.

## Patentansprüche

1. Elektronisches Element (10) enthaltend eine Vielzahl von Zellen (100), die in einer dreidimensionalen Anordnung von Zellen (100) angeordnet sind, wobei sich die Zellen (100) an Kreuzungen zwischen zwei sich kreuzenden Elektrodenleitungen (30, 31) befinden, wobei
jede Zelle (100) in dieser Reihenfolge eine erste Elektrode (102), einen Teil (104) einer molekularen Schicht (20) und eine zweite Elektrode (106) umfasst, wobei die molekulare Schicht (20) eine selbstorganisierte Monoschicht aus organischen Molekülen ist, die eine Ankergruppe aufweisen, die über eine konformationell flexible Einheit mit einer dipolaren Einheit verbunden ist,
wobei die organischen Moleküle zur Bildung der selbstorganisierten Monoschicht ausgewählt sind aus einer oder mehreren Verbindungen der Formel I
T-Z^{T}-(A¹-Z¹)ᵣ-B-(Z²A²)ₛ-(Z³A³)ₜ-(Z⁴A⁴)ᵤ-Sp-G (I)
worin
T ein drei- bis zehngliedriger gesättigter oder teilweise ungesättigter aliphatischer Ring ist, worin mindestens eine -CH₂-Gruppe durch -O-, -S-, -S(O)-, -SO₂-, -NR^{x}- oder -N(O)R^{x}- ersetzt ist oder worin mindestens eine -CH=-Gruppe durch -N= ersetzt ist,
Z^{T}, Z¹, Z² und Z⁴ bei jedem Auftreten gleich oder verschieden eine Einfachbindung, -CF₂O-, -OCF₂-, -CF₂S-, -SCF₂-, -CH₂O-, -OCH₂-, -C(O)O-, -OC(O)-, -C(O)S, -SC(O)-, -(CH₂)ₙ₁-, -(CF₂)ₙ₂-, -CF₂CH₂-, -CH₂CF₂-, -CH=CH-, -CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- oder-N=C-C=N- bedeuten, wobei n1, n2, n3, n4 gleich oder verschieden 1, 2, 3, 4, 5, 6, 7, 8, 9 oder 10 sind,
Z³ -O-, -S-, -CH₂-, -C(O)-, -CF₂-, -CHF-, -C(R^{x})₂-, -S(O)- oder -SO₂- bedeutet,
A¹, A² und A⁴ bei jedem Auftreten gleich oder verschieden einen aromatischen, heteroaromatischen, alicyclischen oder heteroaliphatischen Ring mit 4 bis 25 Ringatomen bedeuten, der auch kondensierte Ringe enthalten kann und der ein- oder mehrfach durch Y substituiert sein kann,
A³ einen aromatischen oder heteroaromatischen Ring mit 5 bis 25 Ringatomen bedeutet, der auch kondensierte Ringe enthalten kann und der ein- oder mehrfach durch Y^{C} substituiert sein kann,
Y bei jedem Auftreten gleich oder verschieden F, Cl, CN, SCN, SF₅ oder geradkettiges oder verzweigtes, jeweils gegebenenfalls fluoriertes Alkyl, Alkoxy, Alkylcarbonyl, Alkoxycarbonyl, Alkylcarbonyloxy oder Alkoxycarbonyloxy mit 1 bis 12 C-Atomen, vorzugsweise F oder CI bedeutet,
Y^{C} eine der Bedeutungen von Y besitzt oder Cycloalkyl oder Alkylcycloalkyl mit jeweils 3 bis 12 C-Atomen, vorzugsweise Methyl, Ethyl, Isopropyl, Cyclopropyl, Cyclobutyl, Cyclopentyl, Cyclohexyl, Trifluormethyl, Methoxy oder Trifluormethoxy bedeutet,
B 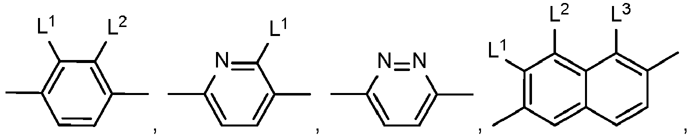 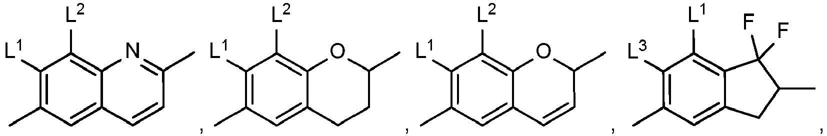 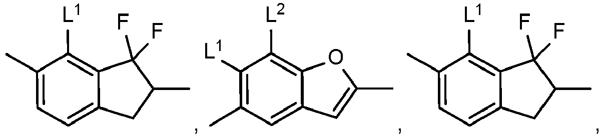 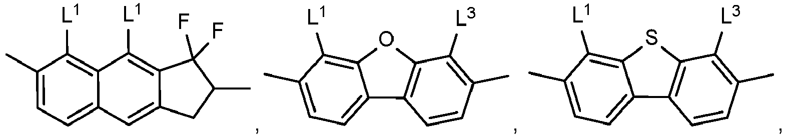 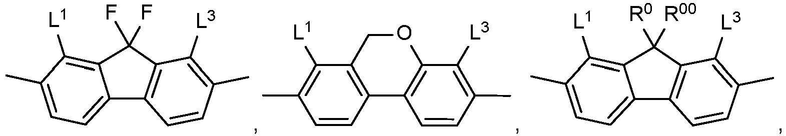 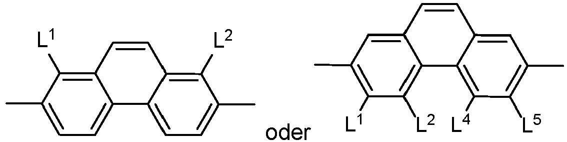 bedeutet, wo die Gruppen in beide Richtungen orientiert sein können,
L¹ bis L⁵ unabhängig voneinander F, Cl, Br, I, CN, SF₅, CF₃ oder OCF₃, vorzugsweise CI oder F bedeuten, wo L³ alternativ auch H bedeuten kann,
Sp eine Spacergruppe oder eine Einfachbindung bedeutet,
G -OH, -SH, -SO₂OH, -OP(O)(OH)₂, -PO(OH)₂, -C(OH)(PO(OH)₂)₂, -COOH, -Si(OR^{x})₃, -SiCl₃, -CH=CH₂, -POCl₂, -CO(NHOH), -CO(NR⁰OH), -Si(NMe₂)₃; -O-C(O)-OR^{V}, -O-C(O)-Si(OR^{V})₃, -PO(OR^{V})₂ oder -SO₂OR^{V} oder geradkettiges oder verzweigtes Alkyl mit 1 bis 12 C-Atomen bedeutet, worin ein, zwei oder drei nicht geminale H-Atome durch OH substituiert sind;
R⁰, R⁰⁰, R^{x} gleich oder verschieden geradkettiges oder verzweigtes Alkyl mit 1 bis 6 C-Atomen bedeuten,
R^{V} geradkettiges oder verzweigtes Alkyl mit 1 bis 12 C-Atomen bedeutet, und
r, s, t und u gleich oder verschieden 0, 1 oder 2 sind.

2. Elektronisches Element (10) nach Anspruch 1, **dadurch gekennzeichnet, dass** jede Zelle (100) ferner eine Diode, einen Schwellwertschalter oder einen Transistor als Auswahlvorrichtung (108) umfasst.

3. Elektronisches Element (10) nach Anspruch 2, wobei die Auswahlvorrichtung (108) als eine weitere selbstorganisierte Monoschicht aus organischen Molekülen oder als eine zwischen der molekularen Schicht und der ersten Elektrode oder der zweiten Elektrode angeordnete anorganische Diode ausgebildet ist.

4. Elektronisches Element (10) nach irgendeinem der Ansprüche 1 bis 3, **dadurch gekennzeichnet, dass** die ersten Elektrode (102) und/oder zweite Elektrode (106) jeder Zelle (100) aus einem Metall, einer leitfähigen Legierung, einer leitfähigen Keramik, einem Halbleiter, einem leitfähigen oxidischen Material, leitfähigen oder halbleitenden organischen Molekülen oder einem geschichteten leitfähigen 2D-Material bestehen.

5. Elektronisches Element (10) nach Anspruch 1, wobei die organischen Moleküle zur Bildung der selbstorganisierten Monoschicht ausgewählt sind aus der Gruppe bestehend aus den Formeln IA-1a bis IA-1f
T-Z^{T}-B-Sp-G IA-1a
T-Z^{T}-(A¹-Z¹)-B-Sp-G IA-1b
T-Z^{T}-(A¹-Z¹)₂-B-Sp-G IA-1c
T-Z^{T}-B-(Z²-A²)-Sp-G IA-1d
T-Z^{T}-B-(Z²-A²)₂-Sp-G IA-1e
T-Z^{T}-(A¹-Z¹)-B-(Z²-A²)- Sp-G IA-1f
worin T, Z^{T}, A¹, A², B, Z¹, Z², Sp und G die in Anspruch 1 genannten Bedeutungen besitzen.

6. Elektronisches Element (10) nach Anspruch 1 oder 5, wobei 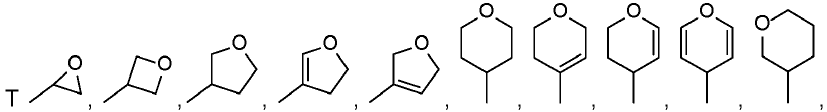 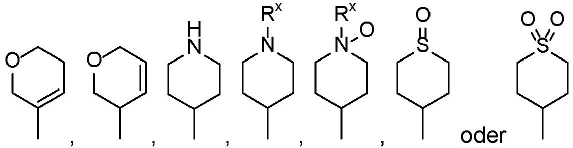 bedeutet,
worin R^{x} Alkyl mit 1 bis 6 C-Atomen bedeutet,
A¹ und A² gleich oder verschieden 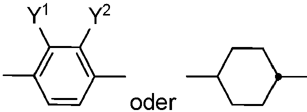 bedeuten,
B 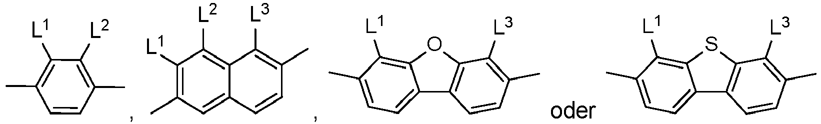 bedeutet,
L¹ und L² unabhängig voneinander CF₃, CI oder F bedeuten,
L³ H oder F bedeutet,
Y¹ und Y² unabhängig voneinander H, CI oder F bedeuten,
Z¹, Z², Z^{T} unabhängig voneinander eine Einfachbindung, -CF₂O-, -OCF₂-, -CH₂O-, -OCH₂- oder -CH₂CH₂- bedeuten,
Sp verzweigtes oder unverzweigtes 1,ω-Alkylen mit 1 bis 12 C-Atomen bedeutet,
und
G -OP(O)(OH)₂, -PO(OH)₂ oder -COH(PO(OH)₂)₂ bedeutet.

7. Elektronisches Element (10) nach Anspruch 1, wobei die organischen Moleküle zur Bildung der selbstorganisierten Monoschicht ausgewählt sind aus den Verbindungen der Formel IA-2
T-Z^{T}-(A¹-Z¹)ᵣ-B-Z³-A³-(Z⁴-A⁴)ᵤ-G IA-2
worin die auftretenden Gruppen und Parameter die in Anspruch 1 genannten Bedeutungen besitzen.

8. Elektronisches Element (10) nach Anspruch 7, wobei 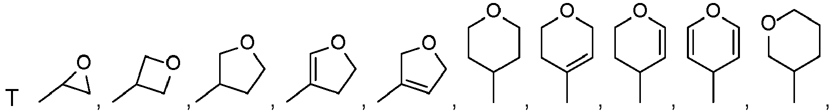 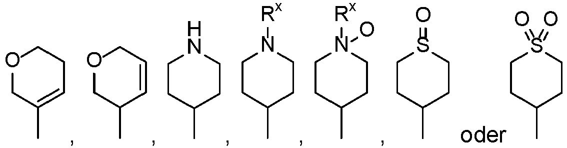
bedeutet,
worin R^{x} Alkyl mit 1 bis 6 C-Atomen bedeutet,
A¹ und A⁴ gleich oder verschieden
A³-Z³ 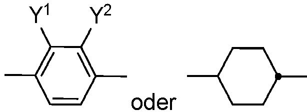 bedeuten, 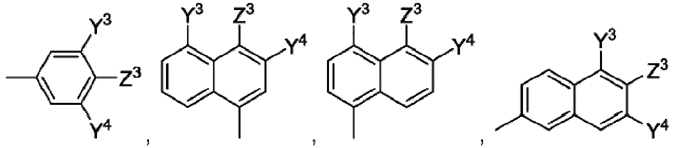 oder 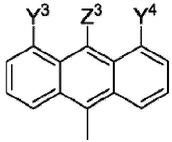 bedeutet,
B 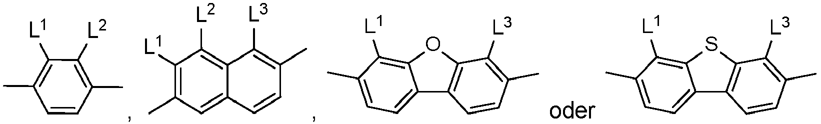 bedeutet,
Z^{T} eine Einfachbindung, -CH₂O-, -OCH₂- oder -CH₂CH₂- bedeutet,
L¹ und L² gleich oder verschieden F, CF₃ oder CI bedeuten,
Y¹ und Y² gleich oder verschieden eine der vorstehend für Y genannten Bedeutungen besitzen und vorzugsweise H, F oder CI bedeuten,
Y³ und Y⁴ gleich oder verschieden eine der vorstehend für Y¹ und Y² genannten Bedeutungen besitzen und vorzugsweise Methyl, Ethyl, Isopropyl, Cyclopropyl, Cyclobutyl, Cyclopentyl, Cyclopentenyl, Cyclohexyl, Cyclohexenyl, Methoxy, Trifluormethyl, Trifluormethoxy oder Trifluormethylthio bedeuten,
Z³ CH₂ oder O bedeutet,
Z¹, Z² unabhängig voneinander eine Einfachbindung, -C(O)O-, -OC(O)-, -CF₂O-, -OCF₂-, -CH₂O-, OCH₂- oder -CH₂CH₂- bedeuten,
G -PO(OH)₂ oder -COH(PO(OH)₂)₂ bedeutet, und
r und u unabhängig 0, 1 oder 2 sind.

9. Verfahren zur Herstellung eines elektronischen Elements (10) enthaltend eine Vielzahl von Zellen (100) nach irgendeinem der Ansprüche 1 bis 8, **dadurch gekennzeichnet, dass** das Verfahren umfasst:
A) Bereitstellen eines Basissubstrats (12),
B) Bildung einer ersten Elektrodenschicht (14), die Elektrodenleitungen (30, 31) umfasst, die durch ein dielektrisches Material (18) getrennt sind,
C) Bilden einer molekularen Schicht (20), die eine Monoschicht aus organischen Molekülen umfasst, die eine Ankergruppe aufweisen, die über eine konformationell flexible Einheit mit einer dipolaren Einheit verbunden ist, und
D) Abscheidung einer weiteren Elektrodenschicht (22), die Elektrodenleitungen (30, 31) umfasst, die durch ein dielektrisches Material (18) getrennt sind,
wobei die Schritte C) und D) wiederholt werden, bis die gewünschte Anzahl von Schichten von Zellen (100) gebildet ist und wobei die Elektrodenleitungen (30, 31) zweier benachbarter Elektrodenschichten (14, 22) so gegeneinander gedreht sind, dass die Elektrodenleitungen (30, 31) der beiden benachbarten Elektrodenschichten (14, 22) einander kreuzen,
wobei das Beschichten mit einer molekularen Monoschicht (20) die Schritte
- Vorbehandeln des zu beschichtenden Substrats zur Reinigung und Aktivierung,
- Eintauchen des Substrats in eine Lösung, die organische Moleküle enthält, um eine selbstorganisierte Monoschicht der Moleküle zu bilden,
- Spülen mit einem organischen Lösungsmittel und
- Tempern der gebildeten molekularen Monoschicht (20) umfasst, wobei es sich bei dem zu beschichtenden Substrat um die erste Elektrodenschicht (14) oder eine weitere Elektrodenschicht (22) handelt und
wobei die organischen Moleküle zum Bilden der selbstorganisierten Monoschicht ausgewählt sind aus einer oder mehreren Verbindungen der Formel I wie in Anspruch 1 definiert.

10. Verfahren nach Anspruch 9, **dadurch gekennzeichnet, dass** nach der Bildung der ersten Elektrodenschicht (14) gemäß Schritt B) oder einer weiteren Elektrodenschicht (22) gemäß Schritt D) und vor dem Bilden der molekularen Monoschicht (20) gemäß Schritt C) eine Auswahlvorrichtung (108) in Form einer Diodenschichtstruktur oder einer Schwellwertschalterstruktur abgeschieden wird.

11. Verfahren nach Anspruch 9 oder 10, **dadurch gekennzeichnet, dass** die Bildung der ersten Elektrodenschicht (14) und/oder der weiteren Elektrodenschichten (22) von Elektrodenleitungen (30, 31), die durch ein dielektrisches Material (18) getrennt sind, die Schritte
- Abscheiden eines Elektrodenmaterials (16),
- Entfernen des Elektrodenmaterials (16) von Nicht-Elektrodenbereichen (32),
- Abscheiden eines dielektrischen Materials (18),
- Planarisierung der erhaltenen Schichtstruktur bis auf das Niveau des Elektrodenmaterials (16)
umfasst
oder im Falle der Bildung der ersten Elektrodenschicht (14) die Schritte
- Abscheiden eines dielektrischen Materials (18),
- Entfernen des dielektrischen Materials (18) von Elektrodenbereichen (34),
- Abscheiden eines Elektrodenmaterials (16),
- Planarisierung der erhaltenen Schichtstruktur bis auf das Niveau des dielektrischen Materials (18)
umfasst.

12. Verfahren nach Anspruch 11, **dadurch gekennzeichnet, dass** das Entfernen von Elektrodenmaterial (16) in den Nicht-Elektrodenbereichen (32) oder das Entfernen von dielektrischem Material (18) in den Elektrodenbereichen (34) durch ein photolithographisches Verfahren durchgeführt wird, bei dem die zu entfernenden Bereiche definiert und geätzt werden.

13. Verfahren nach irgendeinem der Ansprüche 9 bis 12, **dadurch gekennzeichnet, dass** das dielektrische Material (18) und/oder das Material des Basissubstrats (12) aus SiO₂, ZrO₂, Diamant, Al₂O₃ oder GaN ausgewählt ist.

14. Verfahren nach Anspruch 11 oder 12, **dadurch gekennzeichnet, dass** die Abscheidung des dielektrischen Materials (18) und/oder des Elektrodenmaterials (16) durch physikalische Gasphasenabscheidung, chemische Gasphasenabscheidung, chemische Lösungsabscheidung, Atomlagenabscheidung, Mikrokontakt- oder Transferdruck oder Sol-Gel-Verfahren durchgeführt wird.

15. Verfahren nach Anspruch 9, **dadurch gekennzeichnet, dass** die Vorbehandlung mittels einer UV-Ozon-Behandlung durchgeführt wird.

16. Verfahren nach Anspruch 9, **dadurch gekennzeichnet, dass** die Lösung eine Mischung aus einer Phosphonsäure der Moleküle zur Bildung einer selbstorganisierten Monoschicht und einem Lösungsmittel ist.

17. Verfahren nach irgendeinem der Ansprüche 9 bis 16, **dadurch gekennzeichnet, dass** das Tempern bei einer Temperatur im Bereich von 50°C bis 250°C für eine Zeit von 1 Minute bis 60 Minuten durchgeführt wird.

18. Verwendung eines elektronischen Elements (10) nach irgendeinem der Ansprüche 1 bis 4 oder eines mittels eines Verfahrens nach irgendeinem der Ansprüche 9 bis 15 erhaltenen elektronischen Elements (10) als Speichervorrichtung, wobei Zellen (100) des elektronischen Elements (10) als Speicherzellen dienen, und/oder als neuronale Netzwerkvorrichtung, wobei Zellen (100) des elektronischen Elements (10) als Synapsen dienen.

## Revendications

1. Elément électronique (10) comprenant une pluralité de cellules (100) disposées en un réseau tridimensionnel de cellules (100), où les cellules (100) sont situées au niveau de croisements entre deux lignes d'électrodes croisées (30, 31), où
chaque cellule (100) comprend dans cet ordre une première électrode (102), une partie (104) d'une couche moléculaire (20) et une deuxième électrode (106), où la couche moléculaire (20) est une monocouche auto-assemblée de molécules organiques ayant un groupement d'ancrage relié à un motif dipolaire au moyen d'un motif flexible sur le plan conformationnel,
où les molécules organiques pour la formation de la monocouche auto-assemblée sont choisies parmi un ou plusieurs composés de formule I
T-Z^{T}-(A¹-Z¹)ᵣ-B-(Z²A²)ₛ-(Z³A³)ₜ-(Z⁴A⁴)ᵤ-Sp-G (I)
dans laquelle
T est un cycle aliphatique de trois à dix chaînons saturé ou partiellement insaturé, où au moins un groupement -CH₂- est remplacé par -O-, -S-, -S(O)-, -SO₂-, -NR^{x}- ou -N(O)R^{x}-, ou où au moins un groupement -CH= est remplacé par -N=,
Z^{T}, Z¹, Z² et Z⁴, à chaque occurrence, de manière identique ou différente, désignent une liaison simple, -CF₂O-, -OCF₂-, -CF₂S-, -SCF₂-, -CH₂O-, -OCH₂-, -C(O)O-, -OC(O)-, -C(O)S , -SC(O)-, -(CH₂)ₙ₁-, -(CF₂)ₙ₂-, -CF₂CH₂-, -CH₂CF₂-, -CH=CH-, -CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- ou -N=C-C=N-, où n1, n2, n3, n4, de manière identique ou différente, valent 1, 2, 3, 4, 5, 6, 7, 8, 9 ou 10,
Z³ désigne -O-, -S-, -CH₂-, -C(O)-, -CF₂-, -CHF-, -C(R^{x})₂-, -S(O)- ou -SO₂-,
A¹, A² et A⁴, à chaque occurrence, de manière identique ou différente, désignent un cycle aromatique, hétéroaromatique, alicyclique ou hétéroaliphatique ayant de 4 à 25 atomes de cycle, qui peut également contenir des cycles condensés et qui peut être mono- ou polysubstitué par Y,
A³ désigne un cycle aromatique ou hétéroaromatique ayant de 5 à 25 atomes de cycle, qui peut également contenir des cycles condensés et qui peut être mono- ou polysubstitué par Y^{C},
Y à chaque occurrence, de manière identique ou différente, désigne F, CI, CN, SCN, SF₅ ou alkyle, alcoxy, alkylcarbonyle, alcoxycarbonyle, alkylcarbonyloxy ou alcoxycarbonyloxy à chaîne linéaire ou ramifiée, dans chaque cas éventuellement fluoré, ayant de 1 à 12 atomes de C, préférablement F ou CI,
Y^{C} revêt l'une des significations de Y ou désigne cycloalkyle ou alkylcycloalkyle ayant chacun de 3 à 12 atomes de C, préférablement méthyle, éthyle, isopropyle, cyclopropyle, cyclobutyle, cyclopentyle, cyclohexyle, trifluorométhyle, méthoxy ou trifluorométhoxy,
B désigne 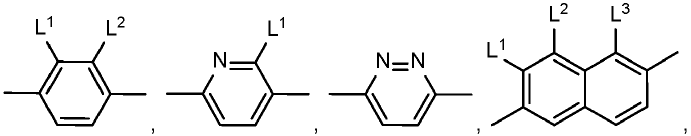 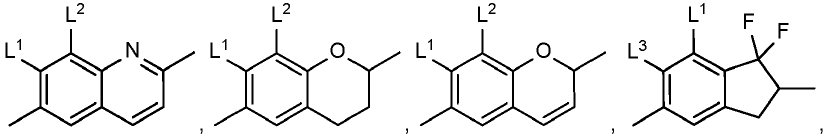 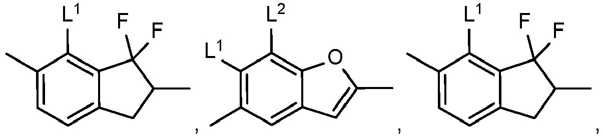 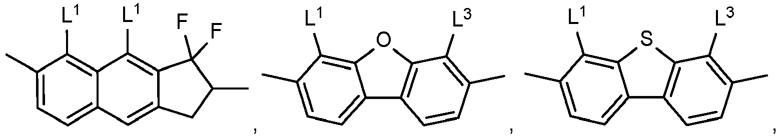 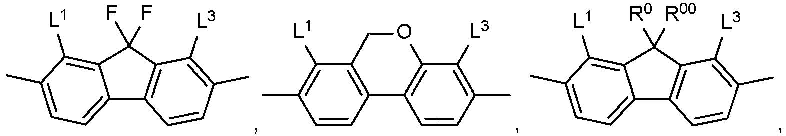 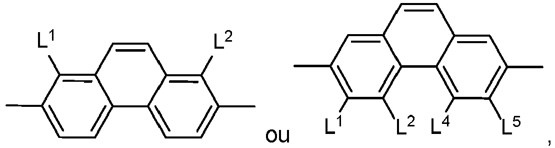 où les groupements peuvent être orientés dans les deux sens,
L¹ à L⁵, indépendamment les uns des autres, désignent F, Cl, Br, I, CN, SF₅, CF₃ ou OCF₃, préférablement CI ou F, où L³ peut, de manière alternative, également désigner H,
Sp désigne un groupement espaceur ou une liaison simple,
G désigne -OH, -SH, -SO₂OH, -OP(O)(OH)₂, -PO(OH)₂, -C(OH)(PO(OH)₂)₂, -COOH, -Si(OR^{x})₃, -SiCl₃, -CH=CH₂, -POCl₂, -CO(NHOH), -CO(NR⁰OH), -Si(NMe₂)₃ ; -O-C(O)-OR^{V}, -O-C(O)-Si(OR^{V})₃, -PO(OR^{V})₂ ou -SO₂OR^{V} ou alkyle à chaîne linéaire ou ramifiée ayant de 1 à 12 atomes de C où un, deux ou trois atomes de H non géminés sont substitués par OH ;
R⁰, R⁰⁰, R^{x} de manière identique ou différente, désignent alkyle à chaîne linéaire ou ramifiée ayant de 1 à 6 atomes de C,
R^{V} désigne alkyle à chaîne linéaire ou ramifiée ayant de 1 à 12 atomes de C, et
r, s, t et u, de manière identique ou différente, valent 0, 1 ou 2.

2. Elément électronique (10) selon la revendication 1, **caractérisé en ce que** chaque cellule (100) comprend en outre une diode, un interrupteur à seuil ou un transistor comme dispositif sélecteur (108).

3. Elément électronique (10) selon la revendication 2, dans lequel le dispositif sélecteur (108) est configuré comme une monocouche auto-assemblée supplémentaire de molécules organiques ou comme une diode inorganique disposée entre la couche moléculaire et la première électrode ou la deuxième électrode.

4. Elément électronique (10) selon l'une quelconque des revendications 1 à 3, **caractérisé en ce que** la première électrode (102) et/ou la deuxième électrode (106) de chaque cellule (100) sont constituées d'un métal, d'un alliage conducteur, d'une céramique conductrice, d'un semi-conducteur, d'un matériau conducteur de type oxyde, de molécules organiques conductrices ou semi-conductrices ou d'un matériau 2D conducteur en couches.

5. Elément électronique (10) selon la revendication 1, dans lequel les molécules organiques pour la formation de la monocouche auto-assemblée sont choisies dans le groupe constitué par les formules IA-1a à IA-1f
T-Z^{T}-B-Sp-G IA-1a
T-Z^{T}-(A¹-Z¹)-B-Sp-G IA-1b
T-Z^{T}-(A¹-Z¹)₂-B-Sp-G IA-1c
T-Z^{T}-B-(Z²-A²)-Sp-G IA-1d
T-Z^{T}-B-(Z²-A²)₂-Sp-G IA-1e
T-Z^{T}-(A¹-Z¹)-B-(Z²-A²)- Sp-G IA-1f
dans lesquelles T, Z^{T}, A¹, A², B, Z¹, Z², Sp et G revêtent les significations données selon la revendication 1.

6. Elément électronique (10) selon la revendication 1 ou 5, dans lequel
T désigne 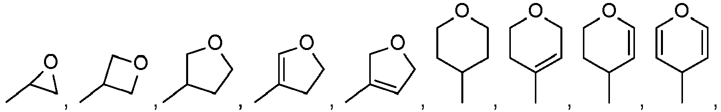 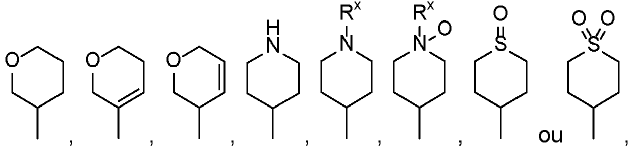 où R^{x} désigne alkyle ayant de 1 à 6 atomes de C,
A¹ et A², de manière identique ou différente, désignent 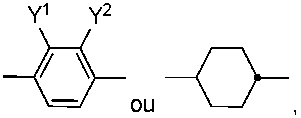
B désigne 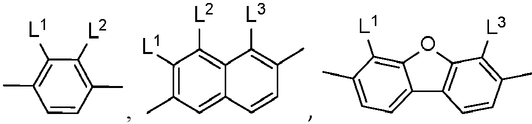 ou 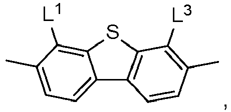
L¹ et L², indépendamment l'un de l'autre, désignent CF₃, CI ou F,
L³ désigne H ou F,
Y¹ et Y², indépendamment l'un de l'autre, désignent H, CI ou F,
Z¹, Z², Z^{T} indépendamment les uns des autres, désignent une liaison simple, -CF₂O-, -OCF₂-, -CH₂O-, -OCH₂- ou -CH₂CH₂-,
Sp désigne 1,ω-alkylène ramifié ou non ramifié ayant de 1 à 12 atomes de C, et
G désigne -OP(O)(OH)₂, -PO(OH)₂, ou -COH(PO(OH)₂)₂.

7. Elément électronique (10) selon la revendication 1, dans lequel les molécules organiques pour la formation de la monocouche auto-assemblée sont choisies parmi les composés de formule IA-2
T-Z^{T}-(A¹-Z¹)ᵣ-B-Z³-A³-(Z⁴-A⁴)ᵤ-G IA-2
dans laquelle les groupements présents et les paramètres revêtent les significations données selon la revendication 1.

8. Elément électronique (10) selon la revendication 7, dans lequel
T désigne 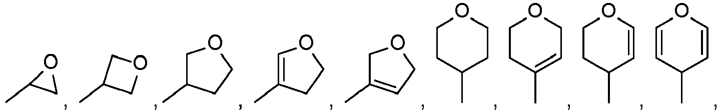 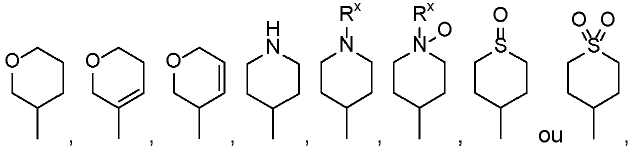 où R^{x} désigne alkyle ayant de 1 à 6 atomes de C,
A¹ et A⁴, de manière identique ou différente, désignent 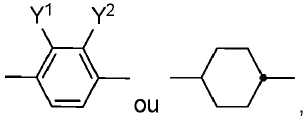
A³-Z³ désigne 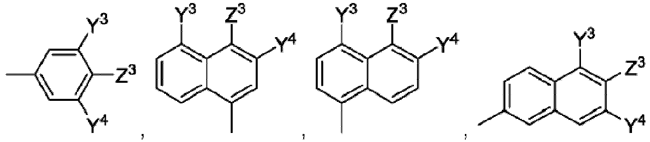 ou 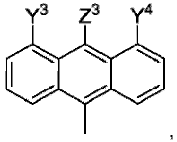
B désigne 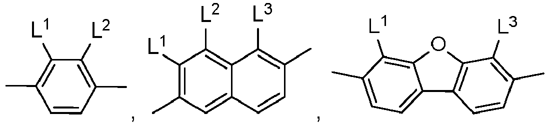 ou 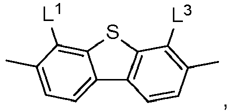
Z^{T} désigne une liaison simple, -CH₂O-, -OCH₂- ou -CH₂CH₂-,
L¹ et L² de manière identique ou différente, désignent F, CF₃ ou CI,
Y¹ et Y² de manière identique ou différente, revêtent l'une des significations données ci-dessus pour Y et préférablement désignent H, F ou CI,
Y³ et Y⁴, de manière identique ou différente, revêtent l'une des significations données ci-dessus pour Y¹ et Y² et préférablement désignent méthyle, éthyle, isopropyle, cyclopropyle, cyclobutyle, cyclopentyle, cyclopentényle, cyclohexyle, cyclohexényle, méthoxy, trifluorométhyle, trifluorométhoxy, ou trifluorométhylthio,
Z³ désigne CH₂ ou O,
Z¹, Z², indépendamment l'un de l'autre, désignent une liaison simple, -C(O)O-, -OC(O)-, -CF₂O-, -OCF₂-, -CH₂O-, OCH₂- ou -CH₂CH₂-,
G désigne -PO(OH)₂, ou -COH(PO(OH)₂)₂, et
r et u valent indépendamment 0, 1 ou 2.

9. Méthode de production d'un élément électronique (10) comprenant une pluralité de cellules (100) selon l'une quelconque des revendications 1 à 8, **caractérisée en ce que** la méthode comprend :
A) la mise à disposition d'un substrat de base (12),
B) la formation d'une première couche d'électrode (14) comprenant des lignes d'électrodes (30, 31) séparées par un matériau diélectrique (18),
C) la formation d'une couche moléculaire (20) comprenant une monocouche de molécules organiques ayant un groupement d'ancrage relié à un motif dipolaire au moyen d'un motif flexible sur le plan conformationnel, et
D) le dépôt d'une couche d'électrode supplémentaire (22) comprenant des lignes d'électrodes (30, 31) séparées par un matériau diélectrique (18),
dans laquelle les étapes C) et D) sont répétées jusqu'à ce que le nombre souhaité de couches de cellules (100) soit formé et où les lignes d'électrodes (30, 31) de deux couches d'électrodes adjacentes (14, 22) sont tournées l'une par rapport à l'autre de manière à ce que les lignes d'électrodes (30, 31) des deux couches d'électrodes adjacentes (14, 22) se croisent,
où le revêtement par une monocouche moléculaire (20) comprend les étapes
- de prétraitement du substrat à revêtir pour un nettoyage et une activation,
- d'immersion du substrat dans une solution contenant des molécules organiques afin de former une monocouche auto-assemblée desdites molécules,
- de rinçage par un solvant organique et
- de recuit de la monocouche moléculaire formée (20), où
le substrat à revêtir est la première couche d'électrode (14) ou une couche d'électrode supplémentaire (22) et
où les molécules organiques pour la formation de la monocouche auto-assemblée sont choisies parmi un ou plusieurs composés de formule I telle que définie selon la revendication 1.

10. Méthode selon la revendication 9, **caractérisée en ce qu'**un dispositif sélecteur (108) sous la forme d'une structure de couches de diodes ou d'une structure de commutateur à seuil est déposé après la formation de la première couche d'électrode (14) selon l'étape B) ou d'une couche d'électrode supplémentaire (22) selon l'étape D) et avant la formation de la monocouche moléculaire (20) selon l'étape C).

11. Méthode selon la revendication 9 ou 10, **caractérisée en ce que** la formation de la première couche d'électrode (14) et/ou des couches d'électrode supplémentaires (22) des lignes d'électrodes (30, 31) séparées par un matériau diélectrique (18) comprend les étapes
- de dépôt d'un matériau d'électrode (16),
- d'élimination du matériau d'électrode (16) des zones autres que d'électrodes (32),
- de dépôt d'un matériau diélectrique (18),
- de planarisation de la structure de couches obtenue jusqu'au niveau du matériau d'électrode (16),
ou, dans le cas de la formation de la première couche d'électrode (14), comprend les étapes
- de dépôt d'un matériau diélectrique (18),
- d'élimination du matériau diélectrique (18) des zones d'électrodes (34),
- de dépôt d'un matériau d'électrode (16),
- de planarisation de la structure de couches obtenue jusqu'au niveau du matériau diélectrique (18).

12. Méthode selon la revendication 11, **caractérisée en ce que** l'élimination du matériau d'électrode (16) des zones autres que d'électrodes (32) ou l'élimination du matériau diélectrique (18) des zones d'électrodes (34) est effectuée par une méthode photolithographique de définition des zones à éliminer et de gravure.

13. Méthode selon l'une quelconque des revendications 9 à 12, **caractérisée en ce que** le matériau diélectrique (18) et/ou le matériau du substrat de base (12) est choisi parmi SiO₂, ZrO₂, le diamant, Al₂O₃ ou GaN.

14. Méthode selon la revendication 11 ou 12, **caractérisée en ce que** le dépôt du matériau diélectrique (18) et/ou du matériau d'électrode (16) est effectué au moyen d'un dépôt physique en phase vapeur, d'un dépôt chimique en phase vapeur, d'un dépôt en solution chimique, d'un dépôt par couche atomique, d'une impression par microcontact ou par transfert ou d'une méthode sol-gel.

15. Méthode selon la revendication 9, **caractérisée en ce qu'**un pré-traitement est effectué au moyen d'un traitement UV-ozone.

16. Méthode selon la revendication 9, **caractérisée en ce que** la solution est un mélange d'un acide phosphonique des molécules permettant de former une monocouche auto-assemblée et d'un solvant.

17. Méthode selon l'une quelconque des revendications 9 à 16, **caractérisée en ce que** le recuit est effectué à une température dans la plage allant de 50°C à 250°C pendant une durée allant de 1 minute à 60 minutes.

18. Utilisation d'un élément électronique (10) selon l'une quelconque des revendications 1 à 4 ou d'un élément électronique (10) obtenu au moyen d'une méthode selon l'une quelconque des revendications 9 à 15, comme dispositif de mémoire, où les cellules (100) de l'élément électronique (10) servent de cellules de mémoire, et/ou comme dispositif de réseau neuronal, où les cellules (100) de l'élément électronique (10) servent de synapses.
